# EUROPEAN PATENT APPLICATION

(11) **EP 1 961 782 A1**
(43) Date of publication of application: **27.08.2008**
(21) Application number: 06833614.8
(22) Date of filing: 29.11.2006
(51) Int. Cl.: C08G 85/00, C08G 61/00, C08L 101/02, C09D 11/00, C09K 11/06, G02F 1/335, H01L 51/50

(54) **POLYMER MATERIAL AND POLYMER LIGHT-EMITTING DEVICE USING SAME**

(30) Priority: 30.11.2005 JP 2005346402
(71) Applicant: Sumitomo Chemical Company, Limited, Tokyo 104-8260 (JP)
(72) Inventor: ISHIKAWA, Miho, Tokyo 164-0002 (JP); OGUMA, Jun, Ibaraki 305-0005 (JP)
(74) Representative: Cresswell, Thomas Anthony
(86) International application number: PCT/JP2006/323810
(87) International publication number: WO 2007/063896

(57) **Abstract**

Disclosed is a polymer material containing a fluorescent or phosphorescent compound. When used in a light-emitting device, the polymer material enables to obtain a light-emitting device with excellent practicability which can be driven at low voltage and is excellent in luminous efficiency, color tones of emitted light and the like. Specifically disclosed is a polymer material **characterized by** containing a polymer (A) having a residue of a compound represented by the formula (1) below or the structure of (A), and a molecule (B) exhibiting fluorescence or phosphorescence in the visible region or the structure of (B). 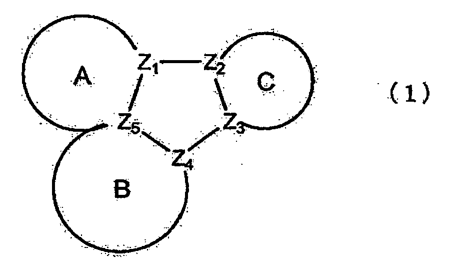 (In the formula, ring A, ring B and ring C independently represent an optionally substituted aromatic ring or non-aromatic ring; and Z₁, Z₂, Z₃, Z₄ and Z₅ independently represent C-(Q)_{z} or a nitrogen atom, wherein Q represents a substituent or a hydrogen atom and z represents 0 or 1. The ring A and ring B may have in common an atom other than Z₅ in the rings, and one or two of the ring A, ring B and ring C are non-aromatic rings.)

## Description

### TECHNICAL FIELD

The present invention relates to a polymer material and a polymer light emitting device using the material.

### BACKGROUND ART

Various high-molecular-weight light-emitting materials have been examined, unlike low-molecular-weight materials, because high-molecular-weight materials are soluble in solvents and light emitting layers can be formed in light emitting devices by a coating method.
For example, as a light emitting material for the light emitting layers, research has been conducted on a polymer material containing a conjugated polymer and a compound exhibiting fluorescence or phosphorescence (see Non-Patent Document 1 and Patent Document 1).
Non-Patent Document 1: Material Chemistry and Physics 93, pp. 95-99 (2005)
Patent Document 1: JP-A-2003-73480

### DISCLOSURE OF THE INVENTION

### PROBLEMS TO BE SOLVED BY THE INVENTION

However, polymer light emitting devices formed by using the polymer material do not offer enough performance in practical use because the devices have low light emitting efficiency, high operational voltage, insufficient colors of emitted light, and so on.
An object of the present invention is to provide a polymer material comprising a compound exhibiting fluorescence or phosphorescence, with which material light emitting devices with high practicality can be provided such as operability through the application of low voltage, high light emitting efficiency, and sufficient colors of emitted light.

### MEANS FOR SOLVING THE PROBLEMS

The present invention is described below.
[1] A polymer material comprising a polymer (A) including a moiety of a compound represented by the following formula (1) or a structure of the (A), and a molecule (B) exhibiting fluorescence or phosphorescence in a visible range or a structure of the (B), 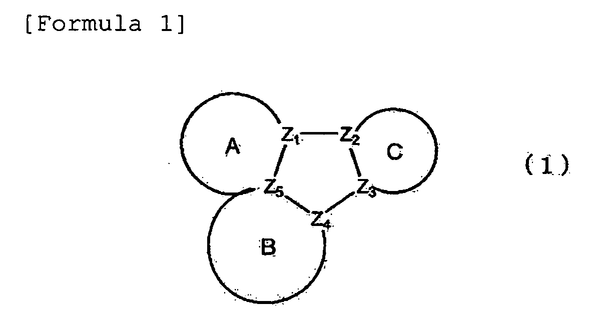 wherein each of rings A, B, and C independently represents an aromatic ring or a non-aromatic ring which rings may optionally have a substituent; each of Z₁, Z₂, Z₃, Z₄, and Z₅ independently represents C-(Q)z or a nitrogen atom; Q represents a substituent or a hydrogen atom; z represents 0 or 1; the rings A and B may share an atom of the rings other than Z₅; and one or two rings among the rings A, B, and C are non-aromatic rings.
[2] The polymer material according to [1], wherein the material is a composition comprising the polymer (A) and the molecule (B).
[3] The polymer material according to [1] or [2], wherein the polymer (A) comprises a repeating unit represented by any one of the following formulae (1-1) to (1-3), 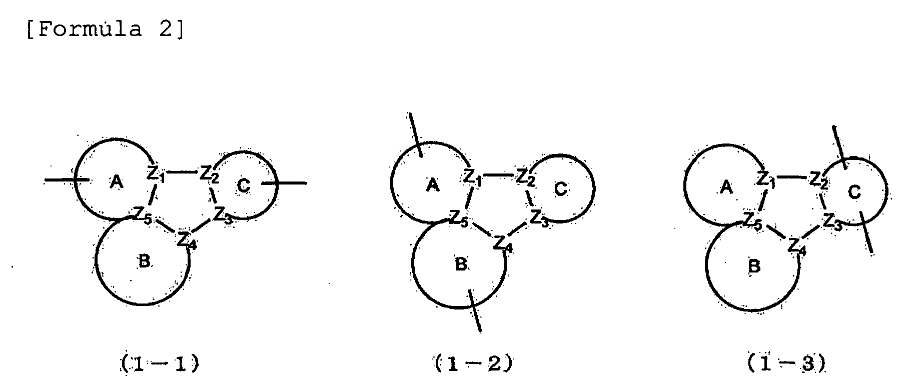 wherein each of the rings A, B, and C independently represents an aromatic ring or a non-aromatic ring which may optionally have a substituent; each of Z₁, Z₂, Z₃, Z₄, and Z₅ independently represents C-(Q)z or a nitrogen atom; Q represents a substituent or a hydrogen atom; z represents 0 or 1; the rings A and B may share an atom of the rings other than Z₅; substituents of the rings may be linked to form another ring; and one or more rings with no valence bond among the rings A, B, and C are non-aromatic rings.
[4] The polymer material according to [3], wherein all atoms forming skeletons of the rings A, B, and C in the formulae (1-1), (1-2), and (1-3) are carbon atoms.
[5] The polymer material according to [3] or [4], wherein the repeating unit represented by the formula (1-1) is a repeating unit represented by the following formula (2-1), 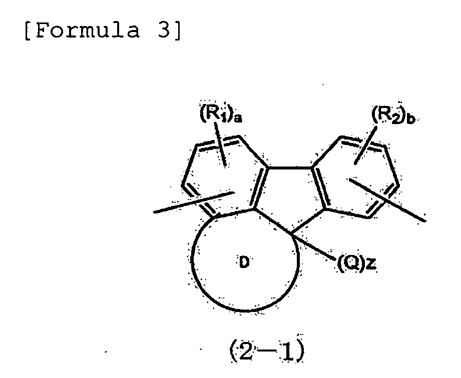 wherein each of R₁ and R₂ independently represents a substituent; the ring D represents a non-aromatic ring which may optionally have a substituent; a represents an integer of 0 to 2; b represents an integer of 0 to 3; when there are a plurality of R₁'s and R₂'s, respectively, R₁'s and R₂'s may be the same or different, respectively; R₁ and R₂ may be linked to each other to form a ring; R₁ and/or R₂ and the ring D may be linked to form a ring; and Q and z represent the same as above.
[6] The polymer material according to [3] or [4], wherein the repeating unit represented by the formula (2-1) is a repeating unit represented by the following formula (3-1), 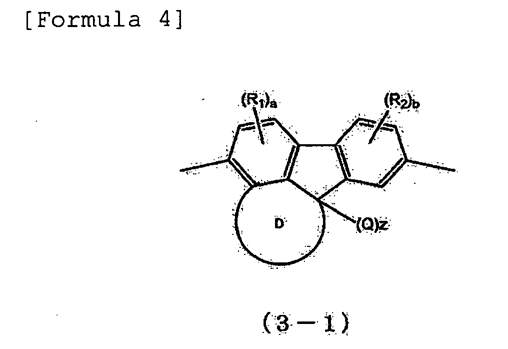 wherein R₁, R₂, the ring D, Q, z, a, and b represent the same as above.
[7] The polymer material according to [6], wherein the repeating unit represented by the formula (3-1) is selected from structures represented by the following formulae (4-1), (4-2), (4-3), and (4-4), 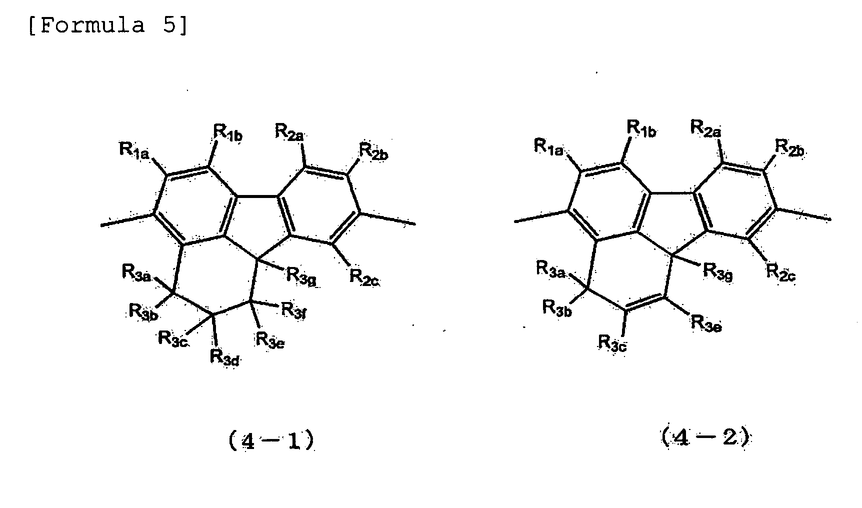 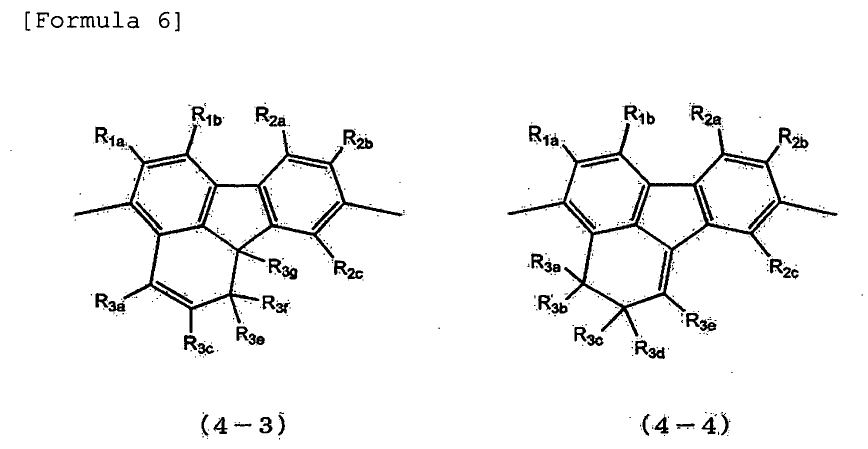 wherein each of R₁ₐ, R_{1b}, R₂ₐ to R_{2c}, and R₃ₐ to R_{3g} independently represents a hydrogen atom or a substituent; R_{2c} and R_{3g} in the formulae (4-1) to (4-3) may be linked to each other to form a ring; and R_{2c} and R₃ₑ in the formula (4-4) may be linked to each other to form a ring.
[8] The polymer material according to any one of [1] to [7], further comprising a repeating unit represented by the following formulae (5), (6), (7), or (8), 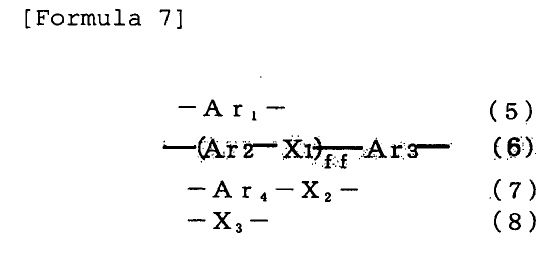 wherein each of Ar₁, Ar₂, Ar₃, and Ar₄ independently represents an arylene group, a divalent heterocyclic group, or a divalent group including a metal complex structure; each of X₁, X₂, and X₃ independently represents -CR₉=CR₁₀-, -C≡C-, -N (R₁₁)-, or - (SiR₁₂R₁₃)ₘ-; each of R₉ and R₁₀ independently represents a hydrogen atom, an alkyl group, an aryl group, a monovalent heterocyclic group, a carboxyl group, a substituted carboxyl group, or a cyano group; each of R₁₁, R₁₂, and R₁₃ independently represents a hydrogen atom, an alkyl group, an aryl group, a monovalent heterocyclic group, an arylalkyl group, or a substituted amino group; ff represents 1 or 2; m represents an integer of 1 to 12; when there are a plurality of R₉, R₁₀, R₁₁, R₁₂ and R₁₃, R₉ to R₁₃ may be the same or different.
[9] The polymer material according to any one of [1] and [3] to [8], wherein the polymer includes the structure (A) and the structure (B) intramolecularly.
[10] The polymer material according to [9], wherein a backbone chain of the polymer with the structure (A) includes the structure (B).
[11] The polymer material according to [9], wherein a side chain of the polymer with the structure (A) includes the structure (B).
[12] The polymer material according to [9], wherein the polymer (A) includes the molecule (B) at an end of the polymer (A) which the molecule (B) exhibits fluorescence or phosphorescence in a visible range.
[13] The polymer material according to any one of [9] to [12], wherein the molecule with the structure (B) is a metal complex.
[14] The polymer material according to any one of [1] to [13], further comprising at least one material selected from hole transport materials and electron transport materials.
[15] The polymer material according to any one of [1] to [14], wherein the molecule (B) or the structure (B) is selected from naphthalene derivatives, anthracene or derivatives thereof, perylene or derivatives thereof, dyes such as polymethine dyes, xanthene dyes, coumarin dyes, cyanine dyes, metal complexes of 8-hydroxyquinoline or derivatives thereof, organic metal complexes of aromatic amines, tetraphenylcyclopentadiene or derivatives thereof, tetraphenylbutadiene or derivatives thereof.
[16] The polymer material according to any one of [1] to [14], wherein the molecule (B) or the structure (B) is an organic metal complex; the metal complex has a central metal which is any one of W, Re, Os, Ir, Pt, Au, Ru, Rh, Pd, Ag, Ni, Cu, and Zn; at least one atom coordinated with the metal is a carbon atom; and all ligands are aromatic rings including substituents.
[17] The polymer material according to [16], wherein the molecule (B) or the structure (B) is a metal complex including at least one ligand with any one of the following moieties, 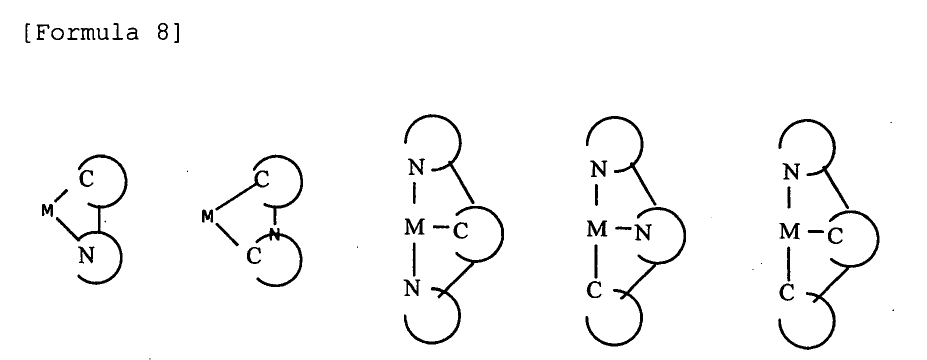 wherein M represents a central metal; and each of the rings represents a 5-membered or 6-membered ring that may optionally have a substituent, or a condensed ring including the 5-membered or 6-membered ring.
[18] A liquid composition comprising the polymer material according to any one of [1] to [17].
[19] The liquid composition according to [18], having a viscosity of 1 to 20 mPa·s at 25°C.
[20] A light emitting thin film comprising the polymer material according to any one of [1] to [17].
[21] A conductive thin film comprising the polymer material according to any one of [1] to [17].
[22] An organic semiconductor thin film comprising the polymer material according to any one of [1] to [17].
[23] A light emitting device comprising a layer comprising the polymer material according to any one of [1] to [17] between electrodes of an anode and a cathode.
[24] The light emitting device according to [22], further comprising a charge transport layer and a charge block layer between the electrodes of an anode and a cathode.
[25] A planar light source using the light emitting device according to [23] or [24].
[26] A segment display apparatus using the light emitting device according to [23] or [24].
[27] A dot matrix display apparatus using the light emitting device according to [23] or [24].
[28] A liquid crystal display apparatus using the light emitting device according to [23] or [24] as a back light.
[29] A lighting using the light emitting device according to [23] or [24].
The polymer material is a composition including the polymer (A) and the molecule (B), or a polymer including the structure (A) and the structure (B) intramolecularly.

Use of a polymer material according to the present invention as a material for a light emitting device provides a light emitting device with excellent device properties.

### BEST MODE FOR CARRYING OUT THE INVENTION

Hereinafter, a polymer material according to the present invention is described.
A polymer material according to the present invention is a composition comprising a polymer (A) including a moiety of a compound represented by the following formula (1) and a molecule (B) exhibiting fluorescence or phosphorescence in the visible range; or a polymer including the structure (A) and the structure (B) intramolecularly. A polymer light emitting device using the polymer material for forming a light emitting layer has excellent device properties such as light emitting efficiency and colors of emitted light.

There is described the polymer (A) and the structure (A) of a polymer material according to the present invention.
The polymer (A) and the structure (A) are characterized by comprising a moiety of a compound represented by the following formula (1). 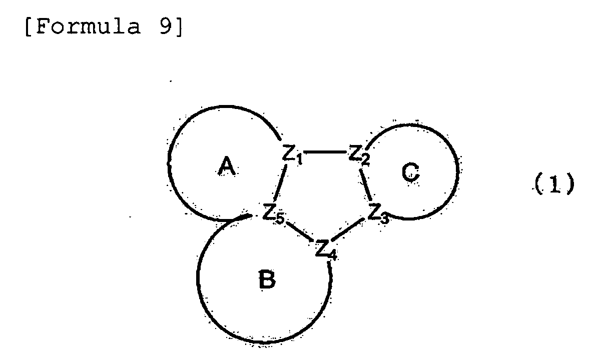 In the formula (1), each of the rings A, B, and C independently represents an aromatic ring or a non-aromatic ring which rings may optionally have a substituent.

The aromatic ring is a ring including 4n+2 π electrons in the ring structure. Specific examples of the aromatic ring may include: aromatic hydrocarbon rings such as a benzene ring, and a cyclodecane pentaene ring; and aromatic heterocyclic rings such as a furan ring, a thiophene ring, a pyrrole ring, a pyridine ring, a pyrimidine ring, and a pyridazine ring.
Specific examples of the non-aromatic ring may include: alicyclic rings such as a cyclopentane ring, a cyclopentene ring, a cyclopentadiene ring, a cyclohexane ring, a cyclohexene ring, a cyclohexadiene ring, a cycloheptane ring, a cycloheptene ring, a cycloheptadiene ring, a cycloheptatriene ring, a cyclooctane ring, a cyclooctene ring, a cyclooctadiene ring, a cyclooctatriene ring, a cyclooctatetraene ring, a cyclononane ring, a cyclononene ring, a cyclononanediene ring, a cyclononanetriene ring, a cyclodecane ring, a cyclodecene ring, a cyclodecanediene ring, a cyclodecanetriene ring, a cyclodecanetetraene ring, a cyclododecane ring, a cyclododecene ring, a cyclododecanediene ring, a cyclododecanetriene ring, a cyclododecanetetraene ring, a cyclododecanepentaene ring, a cycloundecane ring, a cycloundecen ring, a cycloundecanediene ring, a cycloundecanetriene ring, a cycloundecanetetraene ring, a cycloundecanepentaene ring, and a cycloundecanehexaene ring; and non-aromatic heterocyclic rings such as a pyran ring, and a thiopyran ring.

When the aromatic ring or the non-aromatic ring has a substituent/substituents, examples of the substituent may include: an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, substituted an amino group, substituted a silyl group, a fluorine atom, an acyl group, an acyloxy group, an amide group, an acid imide group, a monovalent heterocyclic group, a carboxyl group, substituted a carboxyl group, a cyano group, and a nitro group. Preferred examples of the substituent may include: an alkyl group, an alkoxy group, an aryl group, an aryloxy group, an arylalkyl group, an arylalkoxy group, and an arylalkylthio group.

. The alkyl group may be linear, branched, or cyclic. The alkyl group has typically about 1 to 20 carbon atoms, preferably 3 to 20 carbon atoms.
Specific examples of the alkyl group may include: a methyl group, an ethyl group, a propyl group, an isopropyl group, a butyl group, an isobutyl group, a t-butyl group, a pentyl group, an isoamyl group, a hexyl group, a cyclohexyl group, a heptyl group, an octyl group, a 2-ethylhexyl group, a nonyl group, a decyl group, a 3,7-dimethyloctyl group, a lauryl group, a trifluoromethyl group, a pentafluoroethyl group, a perfluorobutyl group, a perfluorohexyl group, and a perfluorooctyl group. Preferred examples of the alkyl group may include: a pentyl group, an isoamyl group, a hexyl group, an octyl group, a 2-ethylhexyl group, a decyl group, and a 3,7-dimethyloctyl group.

The alkoxy group may be linear, branched, or cyclic. The alkoxy group has typically about 1 to 20 carbon atoms, preferably 3 to 20 carbon atoms.
Specific examples of the alkoxy group may include: a methoxy group, an ethoxy group, a propyloxy group, an isopropyloxy group, a butoxy group, an isobutoxy group, a t-butoxy group, a pentyloxy group, a hexyloxy group, a cyclohexyloxy group, a heptyloxy group, an octyloxy group, a 2-ethylhexyloxy group, a nonyloxy group, a decyloxy group, a 3,7-dimethyloctyloxy group, a lauryloxy group, a trifluoromethoxy group, a pentafluoroethoxy group, a perfluorobutoxy group, a perfluorohexyl group, a perfluorooctyl group, a methoxymethyloxy group, and a 2-methoxyethyloxy group. Preferred examples of the alkoxy group may include: a pentyloxy group, a hexyloxy group, an octyloxy group, a 2-ethylhexyloxy group, a decyloxy group, and a 3,7-dimethyloctyloxy group.

The alkylthio group may be linear, branched, or cyclic. The alkylthio group has typically about 1 to 20 carbon atoms, preferably 3 to 20 carbon atoms. Specific examples of the alkylthio group may include: a methylthio group, an ethylthio group, a propylthio group, an isopropylthio group, a butylthio group, an isobutylthio group, t-butylthio group, pentylthio group, hexylthio group, a cyclohexylthio group, a heptylthio group, an octylthio group, a 2-ethylhexylthio group, a nonylthio group, a decylthio group, a 3,7-dimethyloctylthio group, a laurylthio group, and a trifluoromethylthio group. Preferred examples of the alkylthio group may include: a pentylthio group, a hexylthio group, an octylthio group, a 2-ethylhexylthio group, a decylthio group, and a 3,7-dimethyloctylthio group.

The aryl group is an atom group where a hydrogen atom is removed from an aromatic hydrocarbon, and includes aryl groups having a condensed ring/rings, and aryl groups where two or more independent benzene rings or condensed rings are bonded directly or via groups such as a vinylene. The aryl group has typically about 6 to 60 carbon atoms, preferably 7 to 48 carbon atoms. Specific examples of the aryl group may include: a phenyl group, a C₁ to C₁₂ alkoxyphenyl group (C₁ to C₁₂ represents that the group has 1 to 12 carbon atoms. Likewise, C₁ to C₁₂ represents the same hereinafter.), a C₁ to C₁₂ alkylphenyl group, a 1-naphthyl group, a 2-naphthyl group, a 1-anthracenyl group, a 2-anthracenyl group, a 9-anthracenyl group, and a pentafluorophenyl group. Preferred examples of the aryl group may include: a C₁ to C₁₂ alkoxyphenyl group, and a C₁ to C₁₂ alkylphenyl group. Specific examples of the C₁ to C₁₂ alkoxy may include: methoxy, ethoxy, propyloxy, isopropyloxy, butoxy, isobutoxy, t-butoxy, pentyloxy, hexyloxy, cyclohexyloxy, heptyloxy, octyloxy, 2-ethylhexyloxy, nonyloxy, decyloxy, 3,7-dimethyloctyloxy, and lauryloxy. Specific examples of the C₁ to C₁₂ alkylphenyl group may include: a methylphenyl group, an ethylphenyl group, a dimethylphenyl group, a propylphenyl group, a mesityl group, a methylethylphenyl group, an isopropylphenyl group, a butylphenyl group, an isobutylphenyl group, a t-butylphenyl group, a pentylphenyl group, an isoamylphenyl group, a hexylphenyl group, a heptylphenyl group, an octylphenyl group, a nonylphenyl group, a decylphenyl group, and a dodecylphenyl group.

The aryloxy group has typically about 6 to 60 carbon atoms, preferably 7 to 48 carbon atoms.
Specific examples of the aryloxy group may include: a phenoxy group, a C₁ to C₁₂ alkoxyphenoxy group, a C₁ to C₁₂ alkylphenoxy group, a 1-naphthyloxy group, a 2-naphthyloxy group, and a pentafluorophenyloxy group. Preferred examples of the aryloxy group may include: a C₁ to C₁₂ alkoxyphenoxy group, and a C₁ to C₁₂ alkylphenoxy group.
Specific examples of the C₁ to C₁₂ alkoxy may include: methoxy, ethoxy, propyloxy, isopropyloxy, butoxy, isobutoxy, t-butoxy, pentyloxy, hexyloxy, cyclohexyloxy, heptyloxy, octyloxy, 2-ethylhexyloxy, nonyloxy, decyloxy, 3,7-dimethyloctyloxy, and lauryloxy.
Specific examples of the C₁ to C₁₂ alkylphenoxy group may include: a methylphenoxy group, an ethylphenoxy group, a dimethylphenoxy group, a propylphenoxy group, a 1,3,5-trimethylphenoxy group, a methylethylphenoxy group, an isopropylphenoxy group, a butylphenoxy group, an isobutylphenoxy group, a t-butylphenoxy group, a pentylphenoxy group, an isoamylphenoxy group, a hexylphenoxy group, a heptylphenoxy group, an octylphenoxy group, a nonylphenoxy group, a decylphenoxy group, and a dodecylphenoxy group.

The arylthio group has typically about 3 to 60 carbon atoms. Specific examples of the arylthio group may include: a phenylthio group, a C₁ to C₁₂ alkoxyphenylthio group, a C₁ to C₁₂ alkylphenylthio group, a 1-naphthylthio group, a 2-naphthylthio group, and a pentafluorophenylthio group. Preferred examples of the arylthio group may include: a C₁ to C₁₂ alkoxyphenylthio group, and a C₁ to C₁₂ alkylphenylthio group.

The arylalkyl group has typically about 7 to 60 carbon atoms, preferably 7 to 48 carbon atoms. Specific examples of the arylalkyl group may include: a phenyl-C₁ to a C₁₂ alkyl group, a C₁ to C₁₂ alkoxyphenyl-C₁ to C₁₂ alkyl group, a C₁ to C₁₂ alkylphenyl-C₁ to C₁₂ alkyl group, a 1-naphthyl-C₁ to C₁₂ alkyl group, and a 2-naphthyl-C₁ to C₁₂ alkyl group. Preferred examples of the arylalkyl group may include: a C₁ to C₁₂ alkoxyphenyl-C₁ to C₁₂ alkyl group, and a C₁ to C₁₂ alkylphenyl-C₁ to C₁₂ alkyl group.

The arylalkoxy group has typically about 7 to 60 carbon atoms, preferably 7 to 48 carbon atoms. Specific examples of the arylalkoxy group may include: a phenyl-C₁ to a C₁₂ alkoxy group such as a phenylmethoxy group, a phenylethoxy group, a phenylbutoxy group, a phenylpentyloxy group, a phenylhexyloxy group, a phenylheptyloxy group, and a phenyloctyloxy group; a C₁ to C₁₂ alkoxyphenyl-C₁ to C₁₂ alkoxy group; a C₁ to C₁₂ alkylphenyl-C₁ to C₁₂ alkoxy group; a 1-naphthyl-C₁ to C₁₂ alkoxy group; and a 2-naphthyl-C₁ to C₁₂ alkoxy group. Preferred examples of the arylalkoxy group may include: a C₁ to C₁₂ alkoxyphenyl-C₁ to C₁₂ alkoxy group; and a C₁ to C₁₂ alkylphenyl-C₁ to C₁₂ alkoxy group.

The arylalkylthio group has typically about 7 to 60 carbon atoms, preferably 7 to 48 carbon atoms. Specific examples of the arylalkylthio group may include: a phenyl-C₁ to C₁₂ alkylthio group, a C₁ to C₁₂ alkoxyphenyl-C₁ to C₁₂ alkylthio group, a C₁ to C₁₂ alkylphenyl-C₁ to C₁₂ alkylthio group, a 1-naphthyl-C₁ to C₁₂ alkylthio group, and a 2-naphthyl-C₁ to C₁₂ alkylthio group. Preferred examples of the arylalkylthio group may include: a C₁ to C₁₂ alkoxyphenyl-C₁ to C₁₂ alkylthio group, and a C₁ to C₁₂ alkylphenyl-C₁ to C₁₂ alkylthio group.

The arylalkenyl group has typically about 8 to 60 carbon atoms. Specific examples of the arylalkenyl group may include: a phenyl-C₂ to C₁₂ alkenyl group, a C₁ to C₁₂ alkoxyphenyl-C₂ to C₁₂ alkenyl group, a C₁ to C₁₂ alkylphenyl-C₂ to C₁₂ alkenyl group, a 1-naphthyl-C₂ to C₁₂ alkenyl group, and a 2-naphthyl-C₂ to C₁₂ alkenyl group. Preferred examples of the arylalkenyl group may include: a C₁ to C₁₂ alkoxyphenyl-C₂ to C₁₂ alkenyl group, and a C₂ to C₁₂ alkylphenyl-C₁ to C₁₂ alkenyl group.

The arylalkynyl group has typically about 8 to 60 carbon atoms. Specific examples of the arylalkynyl group may include: a phenyl-C₂ to C₁₂ alkynyl group, a C₁ to C₁₂ alkoxyphenyl-C₂ to C₁₂ alkynyl group, a C₁ to C₁₂ alkylphenyl-C₂ to C₁₂ alkynyl group, a 1-naphthyl-C₂ to C₁₂ alkynyl group, and a 2-naphthyl-C₂ to C₁₂ alkynyl group. Preferred examples of the arylalkynyl group may include: a C₁ to C₁₂ alkoxyphenyl-C₂ to C₁₂ alkynyl group, and a C₁ to C₁₂ alkylphenyl-C₂ to C₁₂ alkynyl group.

Examples of the substituted amino group may include amino groups substituted with one or two groups selected from alkyl groups, aryl groups, arylalkyl groups, and monovalent heterocyclic groups. The alkyl groups, aryl groups, arylalkyl groups, and monovalent heterocyclic groups may have a substituent/substituents. The substituted amino group has typically about 1 to 60 carbon atoms, preferably 2 to 48 carbon atoms without counting the carbon atoms of the substituent/substituents.
Specific examples of the substituted amino group may include: a methylamino group, a dimethylamino group, an ethylamino group, a diethylamino group, a propylamino group, a dipropylamino group, an isopropylamino group, a diisopropylamino group, a butylamino group, an isobutylamino group, a t-butylamino group, a pentylamino group, a hexylamino group, a cyclohexylamino group, a heptylamino group, an octylamino group, a 2-ethylhexylamino group, a nonylamino group, a decylamino group, a 3,7-dimethyloctylamino group, a laurylamino group, a cyclopentylamino group, a dicyclopentylamino group, a cyclohexylamino group, a dicyclohexylamino group, a pyrrolidyl group, a piperidyl group, a ditrifluoromethylamino group, a phenylamino group, a diphenylamino group, a C₁ to C₁₂ alkoxyphenylamino group, a di (C₁ to C₁₂ alkoxyphenyl)amino group, a di(C₁ to C₁₂ alkylphenyl)amino group, a 1-naphthylamino group, a 2-naphthylamino group, a pentafluorophenylamino group, a pyridylamino group, a pyridazinylamino group, a pyrimidinylamino group, a pyrazylamino group, a triazylamino group, a phenyl-C₁ to C₁₂ alkylamino group, a C₁ to C₁₂ alkoxyphenyl-C₁ to C₁₂ alkylamino group, a C₁ to C₁₂ alkylphenyl-C₁ to C₁₂ alkylamino group, a di (C₁ to C₁₂ alkoxyphenyl-C₁ to C₁₂ alkyl)amino group, a di(C₁ to C₁₂ alkylphenyl-C₁ to C₁₂ alkyl)amino group, a 1-naphthyl-C₁ to C₁₂ alkylamino group, and a 2-naphthyl-C₁ to C₁₂ alkylamino group.

Examples of the substituted silyl group may include silyl groups substituted with one, two or three groups selected from alkyl groups, aryl groups, arylalkyl groups, and monovalent heterocyclic groups. The substituted silyl group has typically about 1 to 60 carbon atoms, preferably 3 to 48 carbon atoms. The alkyl groups, aryl groups, arylalkyl groups, and monovalent heterocyclic groups may have a substituent/substituents.
Specific examples of the substituted silyl group may include: a trimethylsilyl group, a triethylsilyl group, a tripropylsilyl group, a triisopropylsilyl group, a dimethylisopropylsilyl group, a diethylisopropylsilyl group, a t-butylsilyldimethylsilyl group, a pentyldimethylsilyl group, a hexyldimethylsilyl group, a heptyldimethylsilyl group, an octyldimethylsilyl group, a 2-ethylhexyl-dimethylsilyl group, a nonyldimethylsilyl group, a decyldimethylsilyl group, a 3,7-dimethyloctyl-dimethylsilyl group, a lauryldimethylsilyl group, a phenyl-C₁ to C₁₂ alkylsilyl group, a C₁ to C₁₂ alkoxyphenyl-C₁ to C₁₂ alkylsilyl group, a C₁ to C₁₂ alkylphenyl-C₁ to C₁₂ alkylsilyl group, a 1-naphthyl-C₁ to C₁₂ alkylsilyl group, a 2-naphthyl-C₁ to C₁₂ alkylsilyl group, a phenyl-C₁ to C₁₂ alkyldimethylsilyl group, a triphenylsilyl group, a tri-p-xylylsilyl group, a tribenzylsilyl group, a diphenylmethylsilyl group, a t-butyldiphenylsilyl group, and a dimethylphenylsilyl group.

The acyl group has typically about 2 to 20 carbon atoms, preferably 2 to 18 carbon atoms.
Specific examples of the acyl group may include: an acetyl group, a propionyl group, a butyryl group, an isobutyryl group, a pivaloyl group, a benzoyl group, a trifluoroacetyl group, and a pentafluorobenzoyl group.

The acyloxy group has typically about 2 to 20 carbon atoms, preferably 2 to 18 carbon atoms.
Specific examples of the acyloxy group may include: an acetoxy group, a propionyloxy group, a butyryloxy group, an isobutyryloxy group, a pivaloyloxy group, a benzoyloxy group, a trifluoroacetyloxy group, and a pentafluorobenzoyloxy group.

The amide group has typically about 2 to 20 carbon atoms, preferably 2 to 18 carbon atoms.
Specific examples of the amide group may include: a formamide group, an acetamide group, a propioamide group, a butyroamide group, a benzamide group, a trifluoroacetamide group, a pentafluorobenzamide group, a diformamide group, a diacetamide group, a dipropioamide group, dibutyroamide group, dibenzamide group, a ditrifluoroacetamide group, and a dipentafluorobenzamide group.

The acid imide group is a moiety obtained from an acid imide by removing a hydrogen atom bonding to a nitrogen atom thereof. The acid imide group has typically about 4 to 20 carbon atoms. Specific examples of the acid imide group may include the following groups.

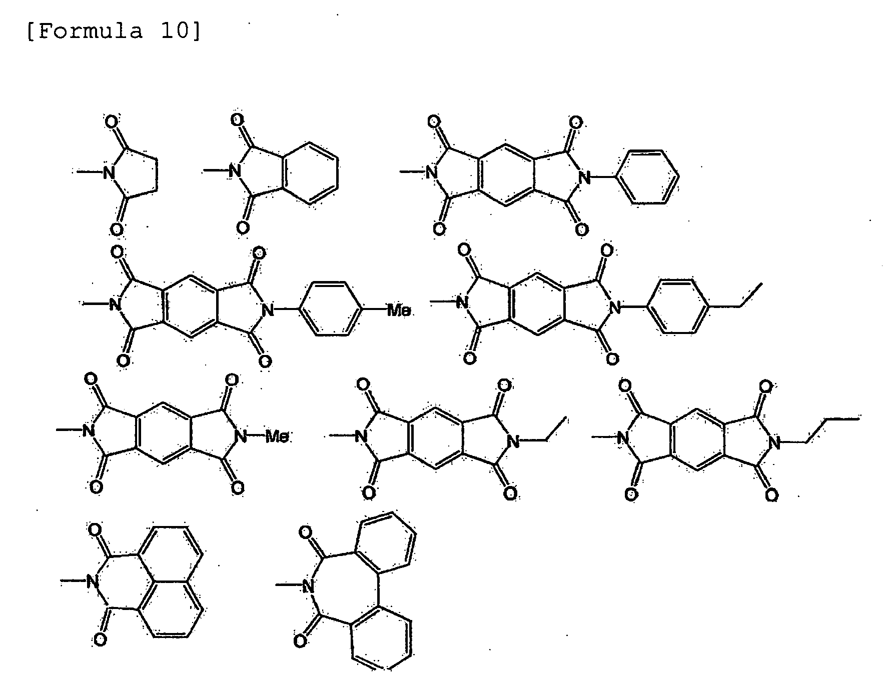

The monovalent heterocyclic group is an atom group where a hydrogen atom is removed from a heterocyclic compound. The monovalent heterocyclic group has typically about 4 to 60 carbon atoms, preferably 4 to 20 carbon atoms. The number of the carbon atoms of the heterocyclic group does not include the number of carbon atoms of a substituent/substituents. The heterocyclic compound is an organic compound with a cyclic structure where the cyclic skeleton is formed with elements not only carbon atoms but also a hetero atom/atoms such as oxygen, sulfur, nitrogen, phosphorus, or boron. Specific examples of the monovalent heterocyclic group may include the following structures. 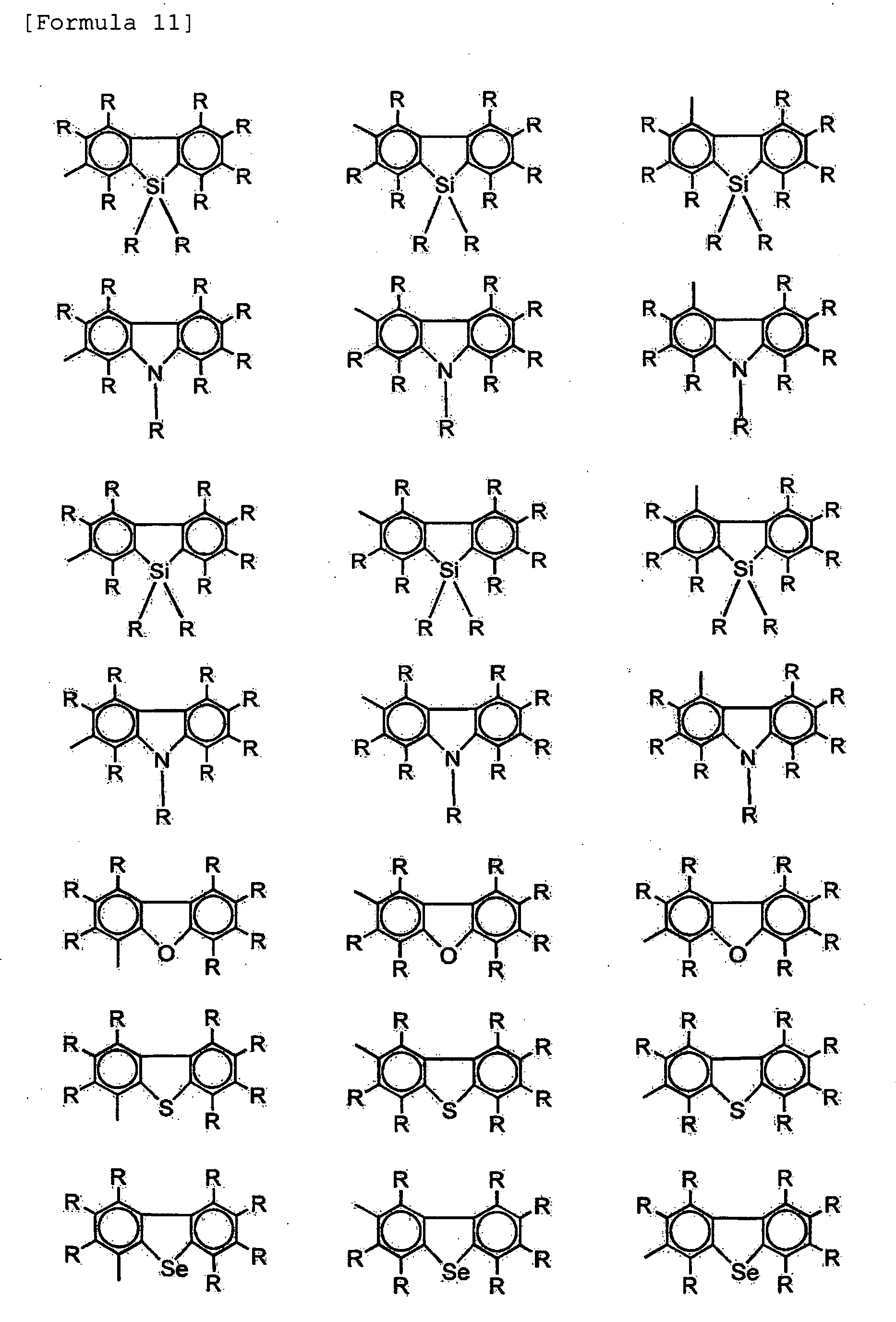 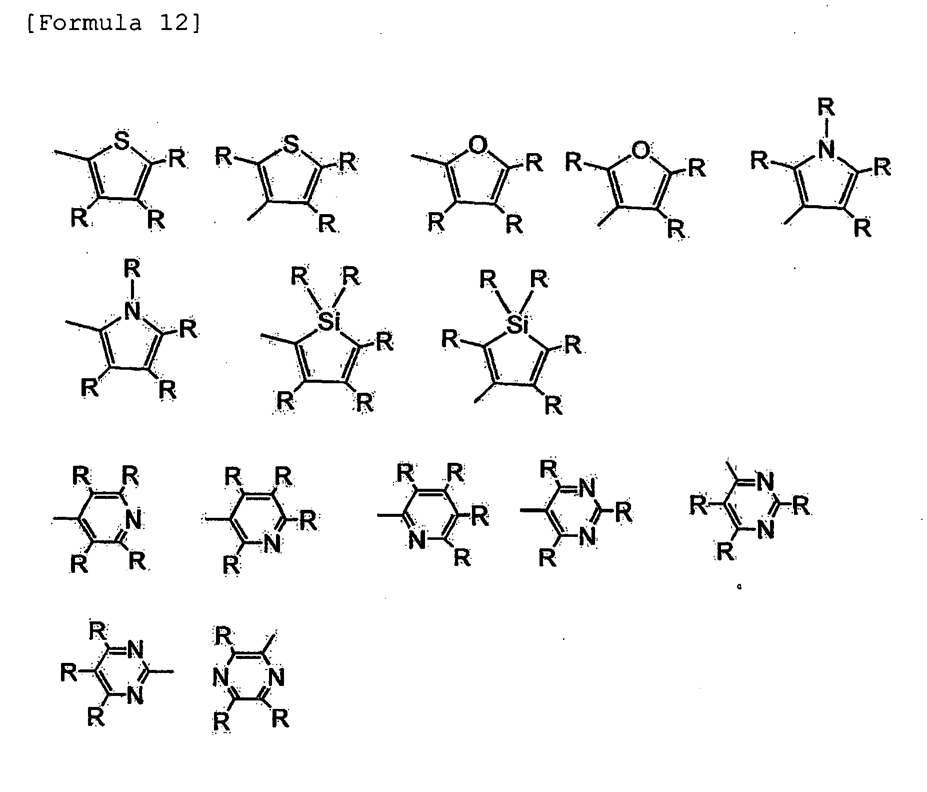 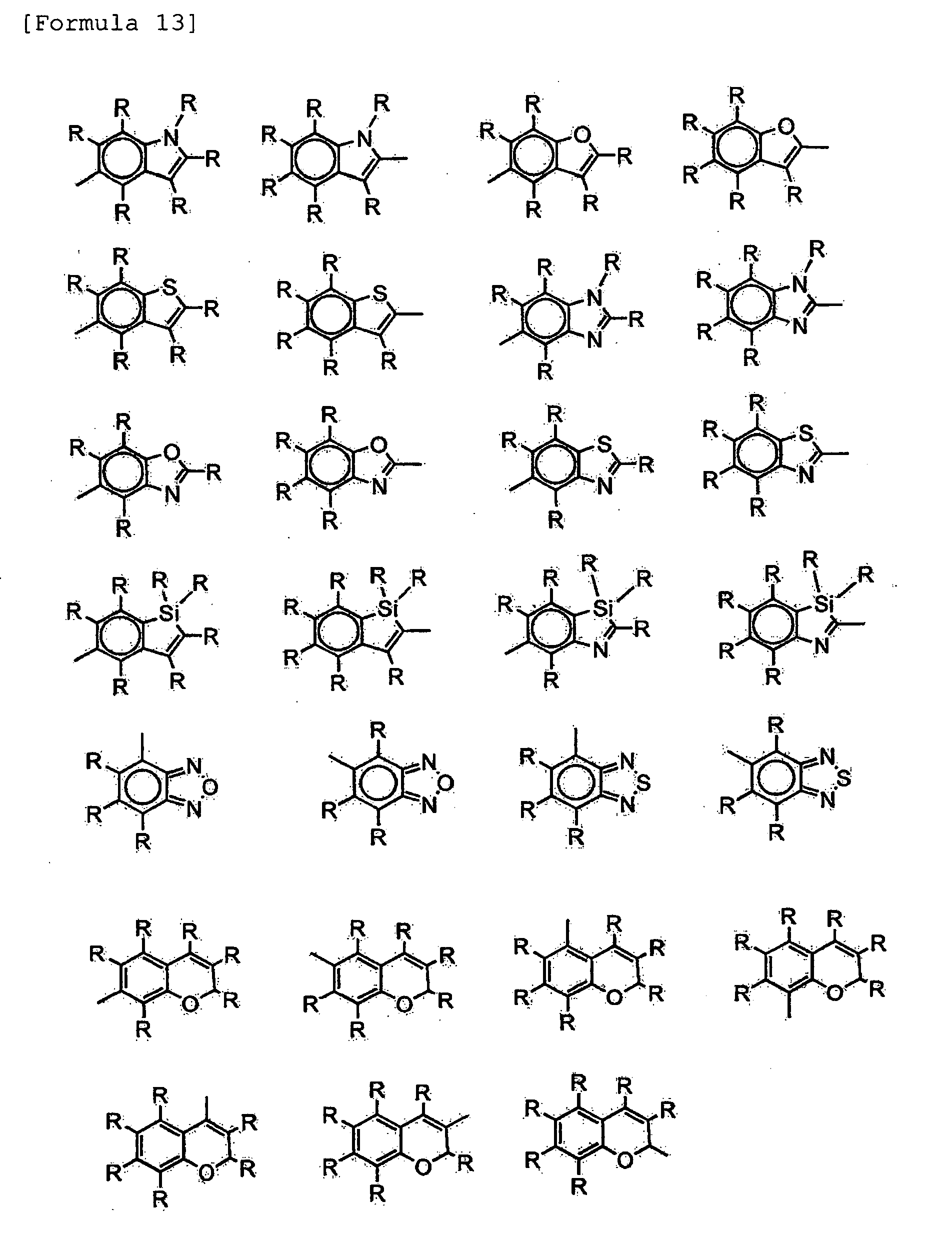 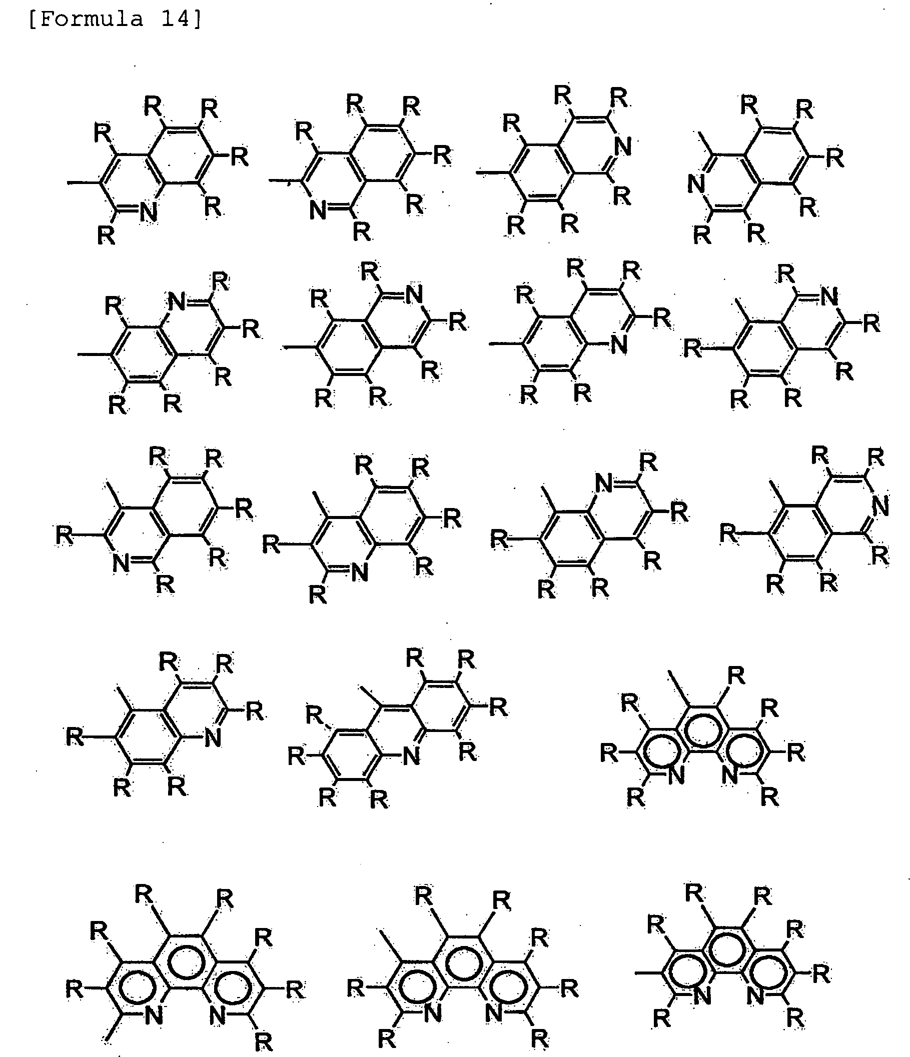 In the formulae, each of R independently represents a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, substituted an amino group, a silyl group, substituted a silyl group, a halogen atom, an acyl group, an acyloxy group, an imine residue, an amide group, an acid imide group, a monovalent heterocyclic group, a carboxyl group, substituted a carboxyl group, or a cyano group.
In particular, R preferably represents a thienyl group, a C₁ to C₁₂ alkylthienyl group, a pyrrolyl group, a furyl group, a pyridyl group, a C₁ to C₁₂ alkylpyridyl group, a piperidyl group, a quinolyl group, an isoquinolyl group, or the like. More preferably, R represents a thienyl group, a C₁ to C₁₂ alkylthienyl group, a pyridyl group, or a C₁ to C₁₂ alkylpyridyl group.

The substituted carboxyl group is a carboxyl group substituted with an alkyl group, an aryl group, an arylalkyl group, or a monovalent heterocyclic group. The substituted carboxyl group has typically about 2 to 60 carbon atoms, preferably 2 to 48 carbon atoms. Specific examples of the substituted carboxyl group may include: a methoxycarbonyl group, an ethoxycarbonyl group, a propoxycarbonyl group, an isopropoxycarbonyl group, a butoxycarbonyl group, an isobutoxycarbonyl group, a t-butoxycarbonyl group, a pentyloxycarbonyl group, a hexyloxycarbonyl group, a cyclohexyloxycarbonyl group, a heptyloxycarbonyl group, an octyloxycarbonyl group, a 2-ethylhexyloxycarbonyl group, a nonyloxycarbonyl group, a decyloxycarbonyl group, a 3,7-dimethyloctyloxycarbonyl group, a dodecyloxycarbonyl group, a trifluoromethoxycarbonyl group, a pentafluoroethoxycarbonyl group, a perfluorobutoxycarbonyl group, a perfluorohexyloxycarbonyl group, a perfluorooctyloxycarbonyl group, a phenoxycarbonyl group, a naphthoxycarbonyl group, and a pyridyloxycarbonyl group. The alkyl group, aryl group, arylalkyl group, or monovalent heterocyclic group may have a substituent/substituents. The number of the carbon atoms of the substituted carboxyl group does not include the number of carbon atoms of the substituent/substituents.

In the formula 1, each of Z₁, Z₂, Z₃, Z₄, and Z₅ independently represents C-(Q)z or a nitrogen atom; Q represents a substituent or a hydrogen atom; and z represents 0 or 1.
Examples of the substituent for Q may include: an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, substituted an amino group, substituted a silyl group, a fluorine atom, an acyl group, an acyloxy group, an amide group, an acid imide group, a monovalent heterocyclic group, a carboxyl group, substituted a carboxyl group, a cyano group, and a nitro group. The definitions and specific examples of the foregoing are the same as mentioned above.

The rings A and B may share an atom/atoms of the rings other than Z₅. One or two rings among the rings A, B, and C are non-aromatic rings.
The rings A and B preferably share one atom of the rings other than Z₅. One ring among the rings A, B, and C is preferably a non-aromatic ring.

A polymer compound according to the present invention preferably comprises a repeating unit represented by the following formulae (1-1) to (1-3). 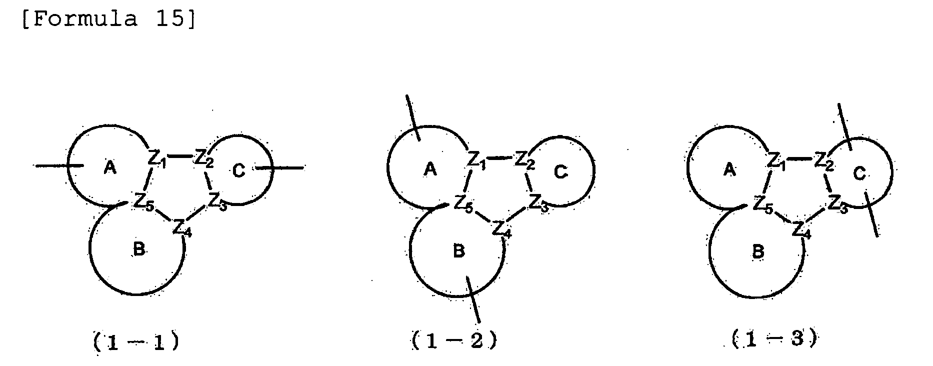 wherein each of the rings A, B, and C independently represents an aromatic ring or a non-aromatic ring which may optionally have a substituent; each of Z₁, Z₂, Z₃, Z₄, and Z₅ independently represents C-(Q)z or a nitrogen atom; Q represents a substituent or a hydrogen atom; z represents 0 or 1; the rings A and B may share an atom of the rings other than Z₅; substituents of the rings may be linked to form another ring; and one or more rings with no valence bond among the rings A, B, and C are non-aromatic rings.

Specific examples of a repeating unit represented by the formula (1-1) may include the following repeating units and these units having a substituent/substituents.

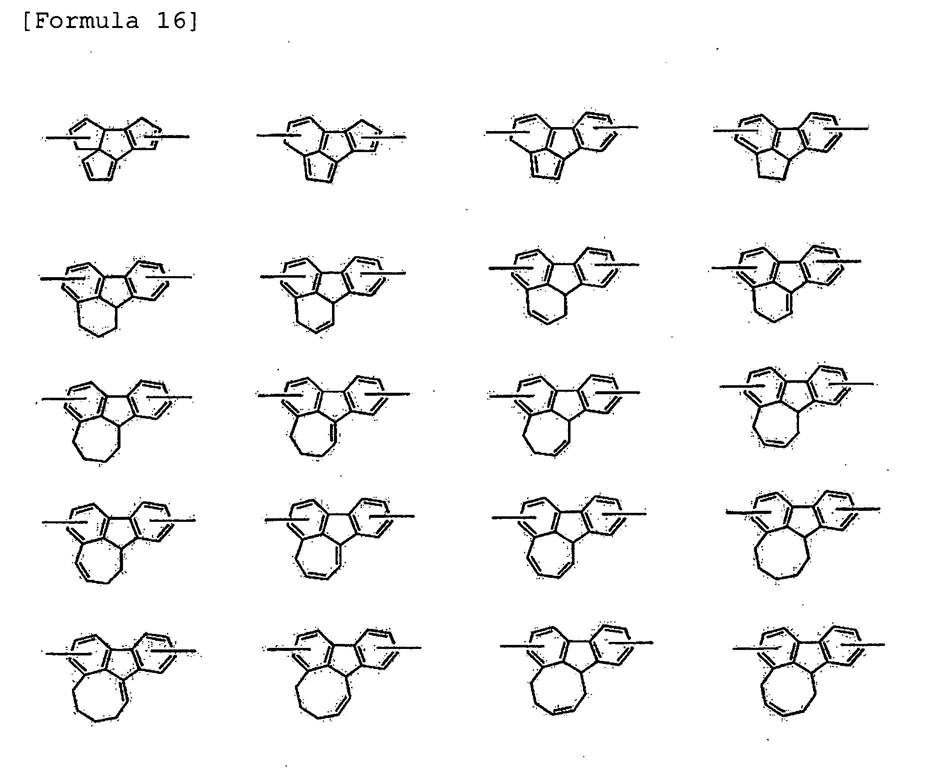

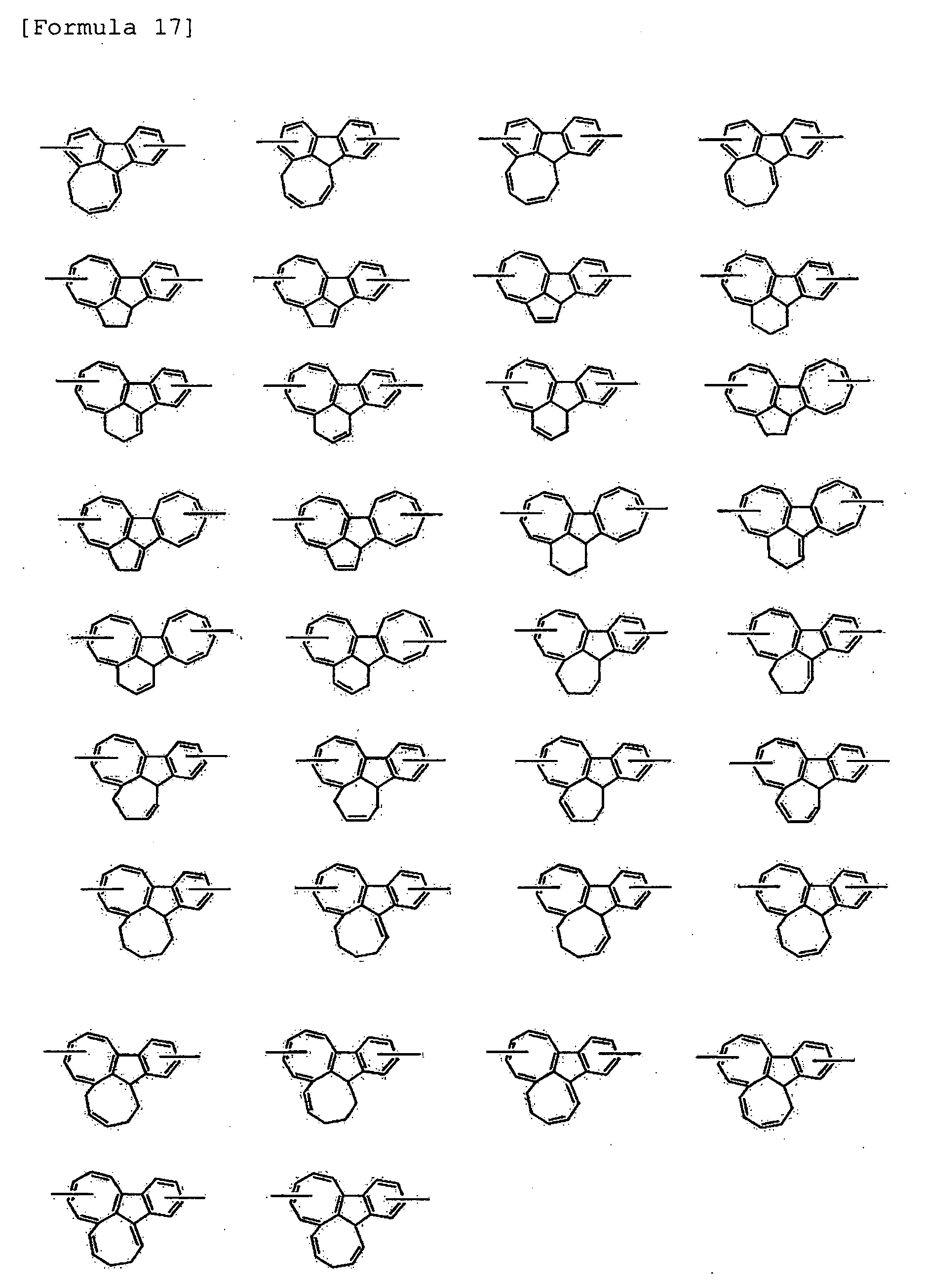

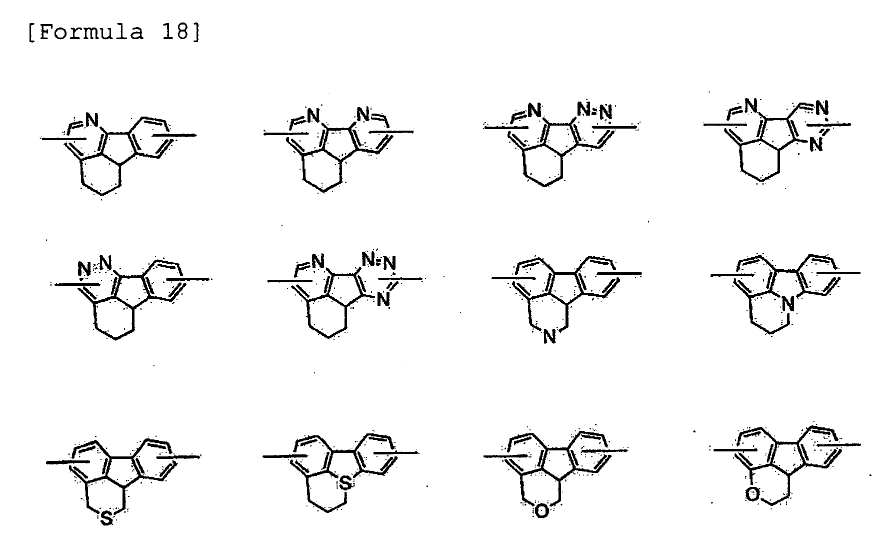

Specific examples of a repeating unit represented by the formula (1-2) may include the following repeating units and these units having a substituent/substituents.

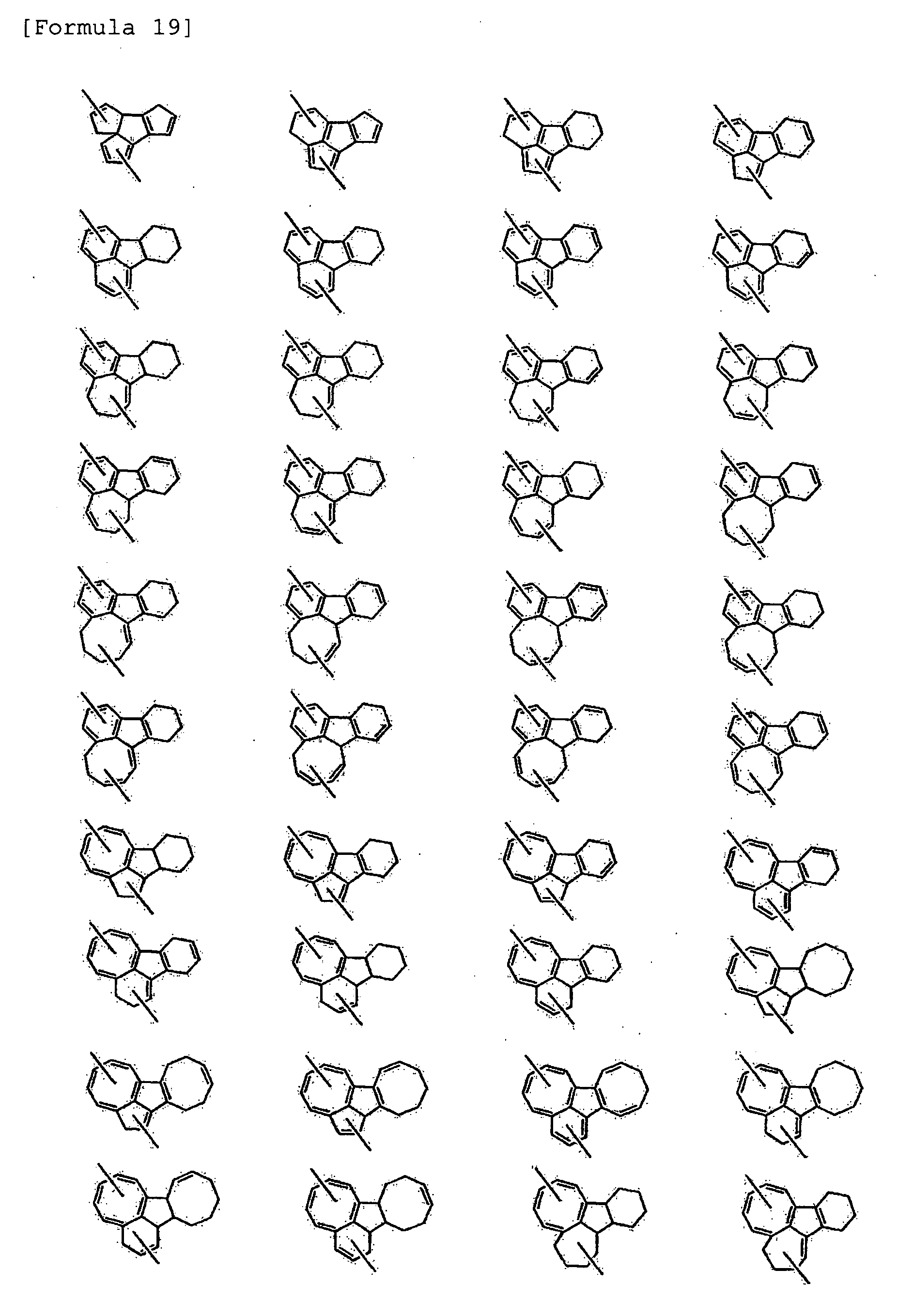

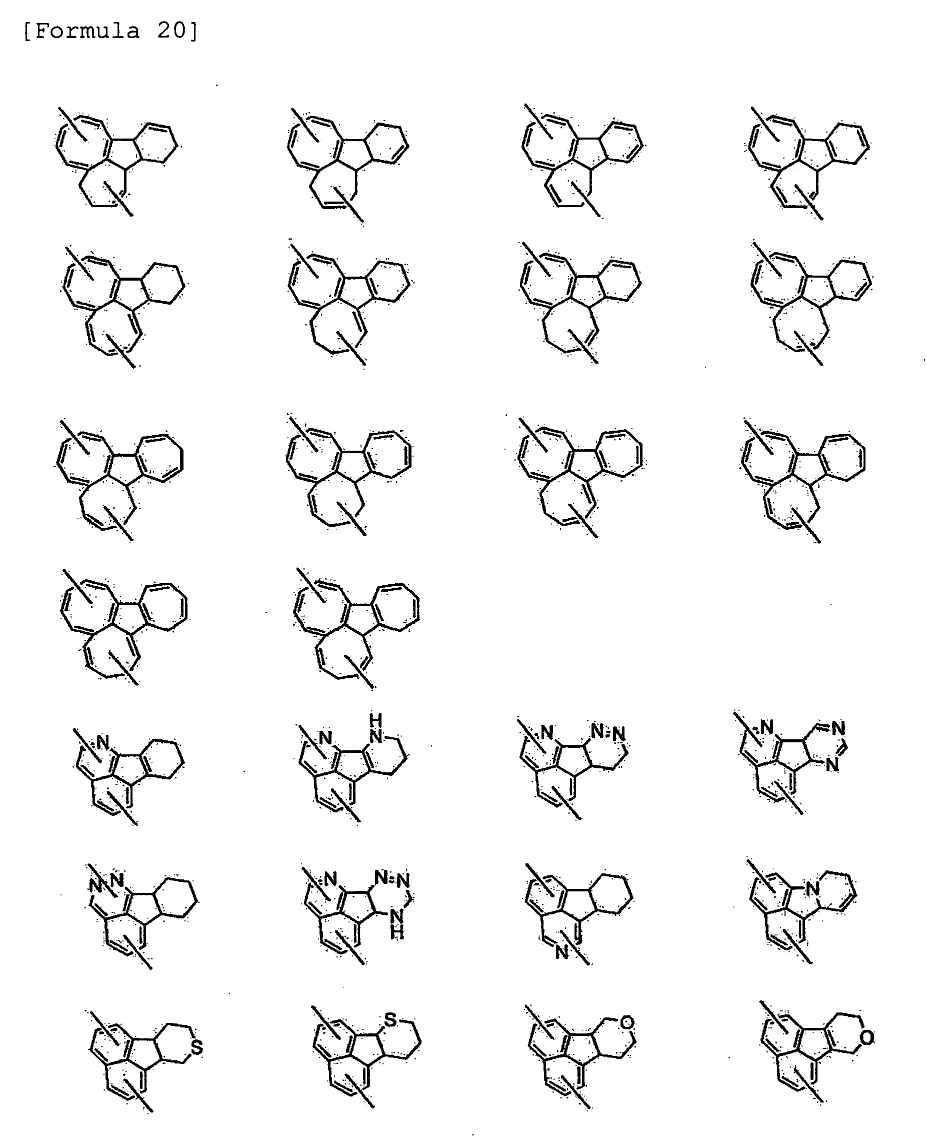

Specific examples of a repeating unit represented by the formula (1-3) may include the following repeating units and these units having a substituent/substituents.

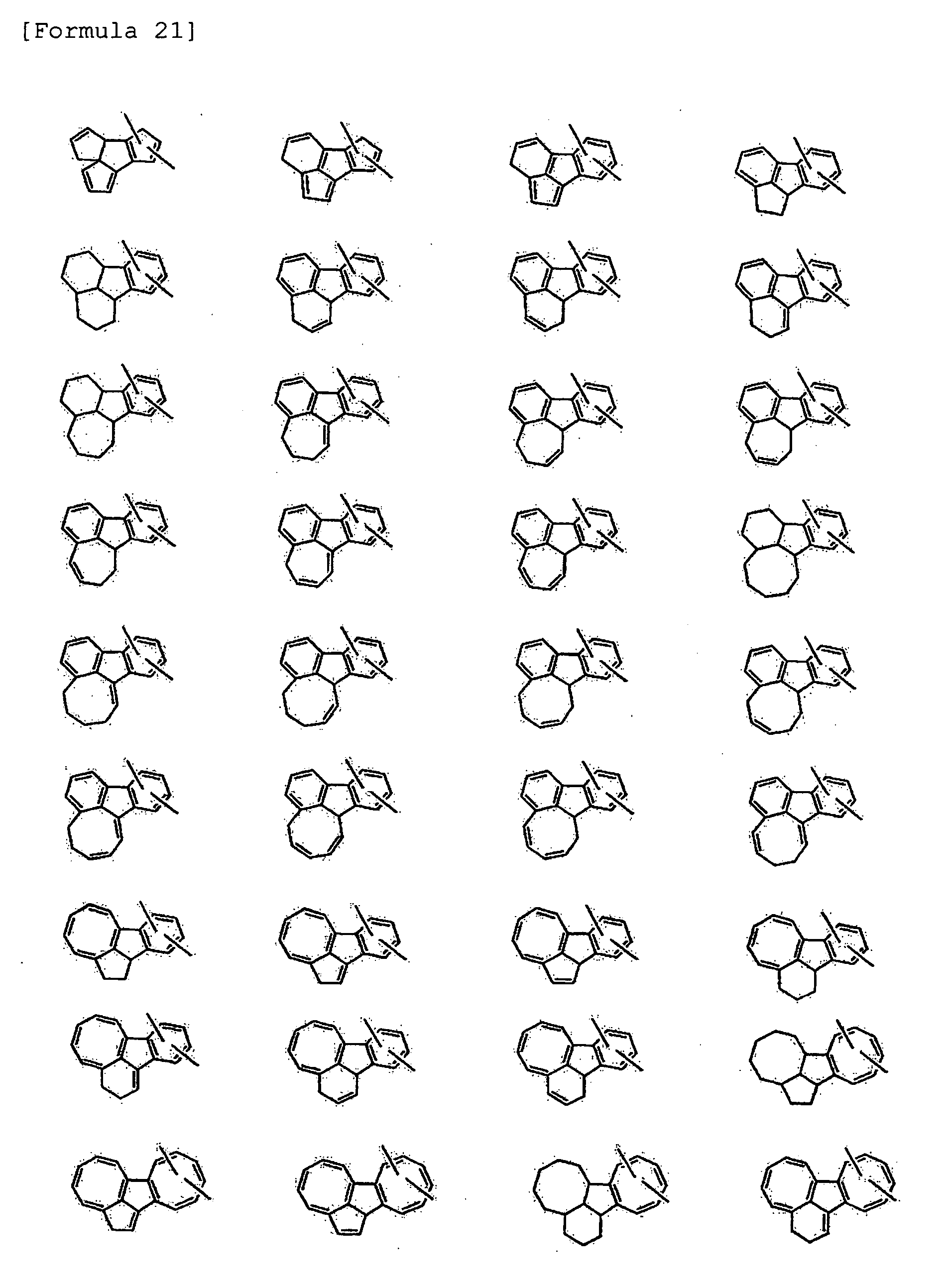

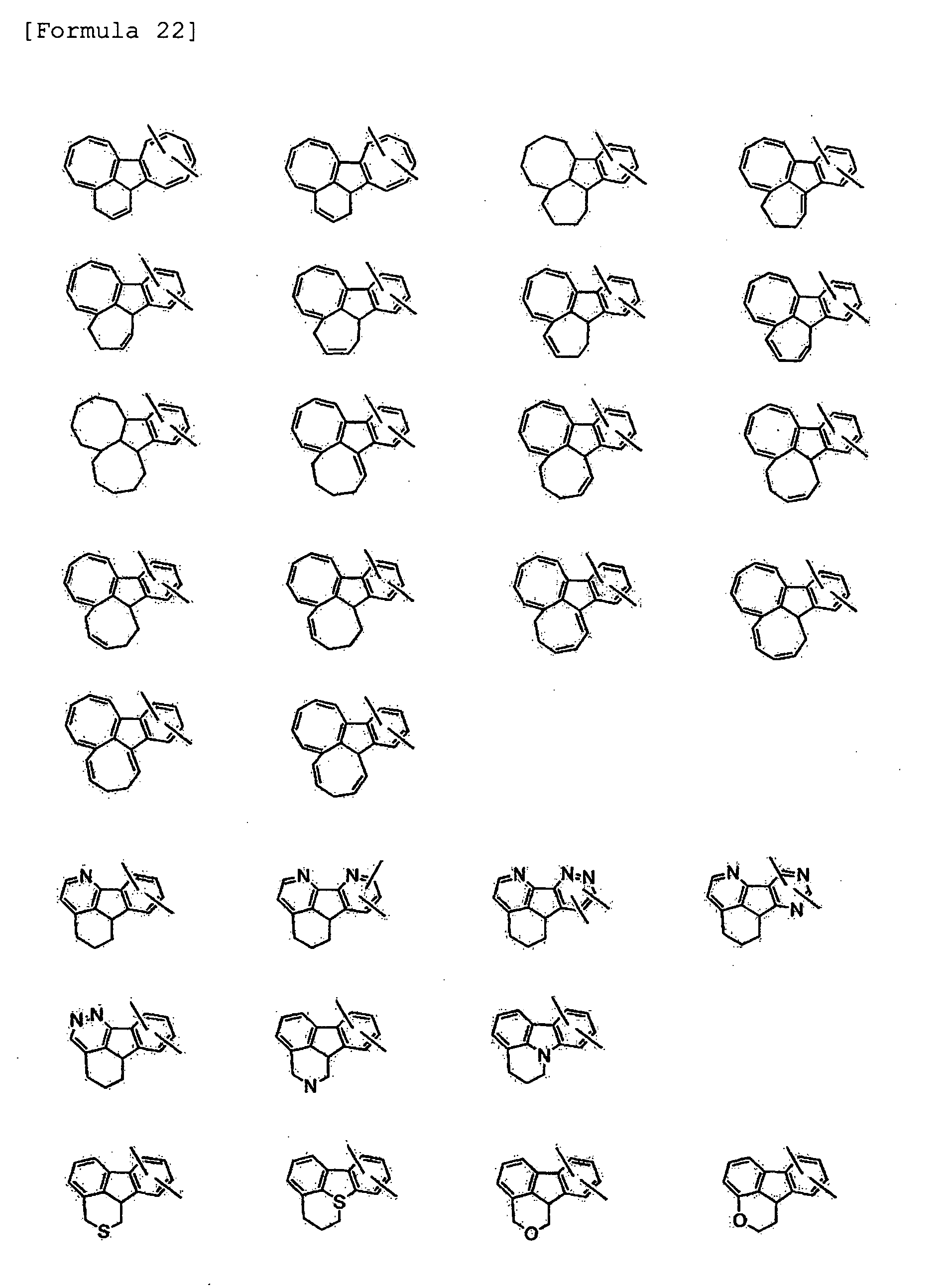

In the repeating units represented by the formulae (1-1) to (1-3), atoms forming skeletons of the rings A, B, and C are preferably only carbon atoms in view of adjusting a charge transporting property.

Any one of the rings A, B, and C preferably has a substituent/substituents in view of enhancing solubility of the polymer compound, adjusting the wavelength of emitted light, and adjusting the charge transporting property.

Repeating units represented by the formulae (1-1) and (1-2) are preferable in view of adjusting the charge transporting property. Repeating units represented by the formula (1-1) are more preferable in view of ease of synthesis.

The formula (1-1) is preferably the following formula (2-1). 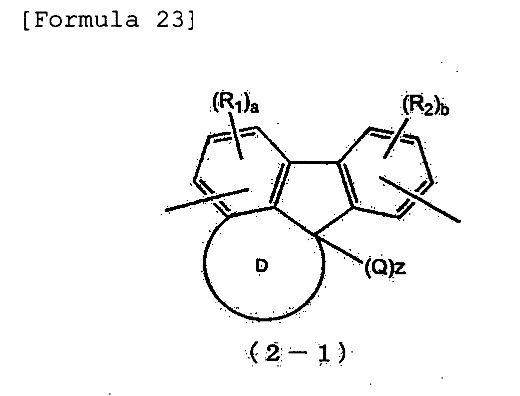 wherein each of R₁ and R₂ independently represents a substituent; the ring D represents a non-aromatic ring which may optionally have a substituent; a represents an integer of 0 to 2; b represents an integer of 0 to 3; when there are a plurality of R₁'s and R₂'s, respectively, R₁'s and R₂'s may be the same or different, respectively; R₁ and R₂ may be linked to form a ring; R₁ and/or R₂ and the ring D may be linked to form a ring; Q and z represent the same as above.

The repeating unit represented by the formula (2-1) is preferably a repeating unit represented by the following formula (3-1). 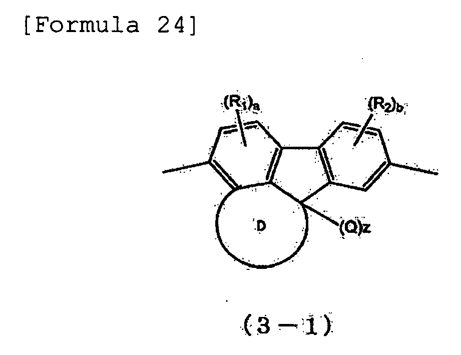 wherein R₁, R₂, the ring D, Q, z, a, and b represent the same as above.

Among the repeating units represented by the formula (3-1), preferred are repeating units represented by the following formulae (4-1), (4-2), (4-3), and (4-4) in view of adjusting the charge transporting property. 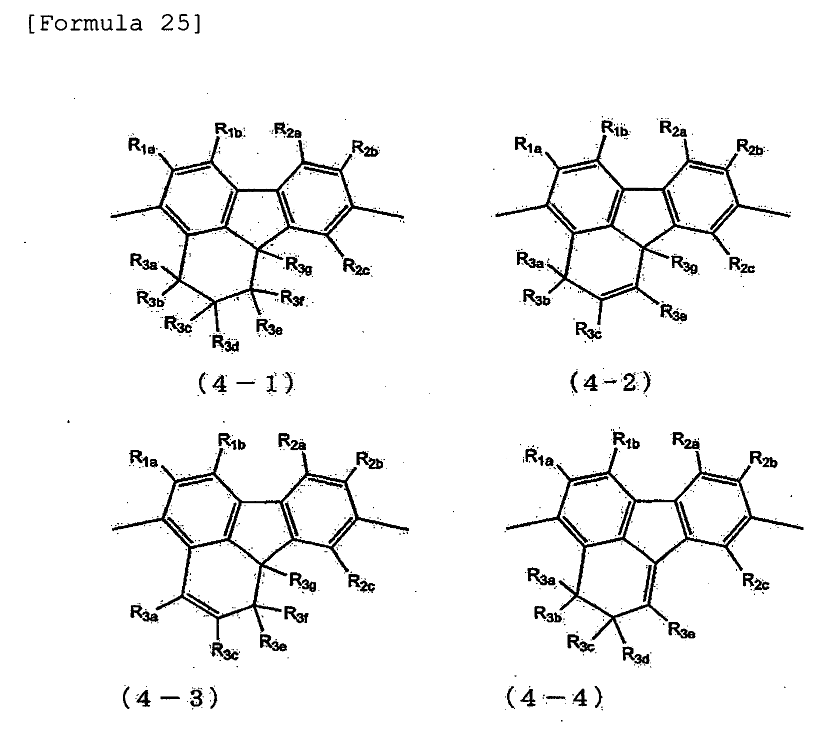 wherein each of R₁ₐ, R_{1b}, R₂ₐ to R_{2c}, and R₃ₐ to R_{3g} represents a substituent; R_{2c} and R_{3g} in the formulae (4-1) to (4-3) may be linked to form a ring; and R_{2c} and R₃ₑ in the formula (4-4) may be linked to form a ring.
Examples of the ring formed by linking each other may include aromatic rings, and non-aromatic rings. Specific examples of the rings are the same those mentioned above.
The units represented by the formulae (4-1) to (4-3) are included by the formula (3-1) with z=1. The units represented by the formula (4-4) are included by the formula (3-1) with z=0.

Specific examples of a repeating unit represented by the formula (4-1) may include the following repeating units.

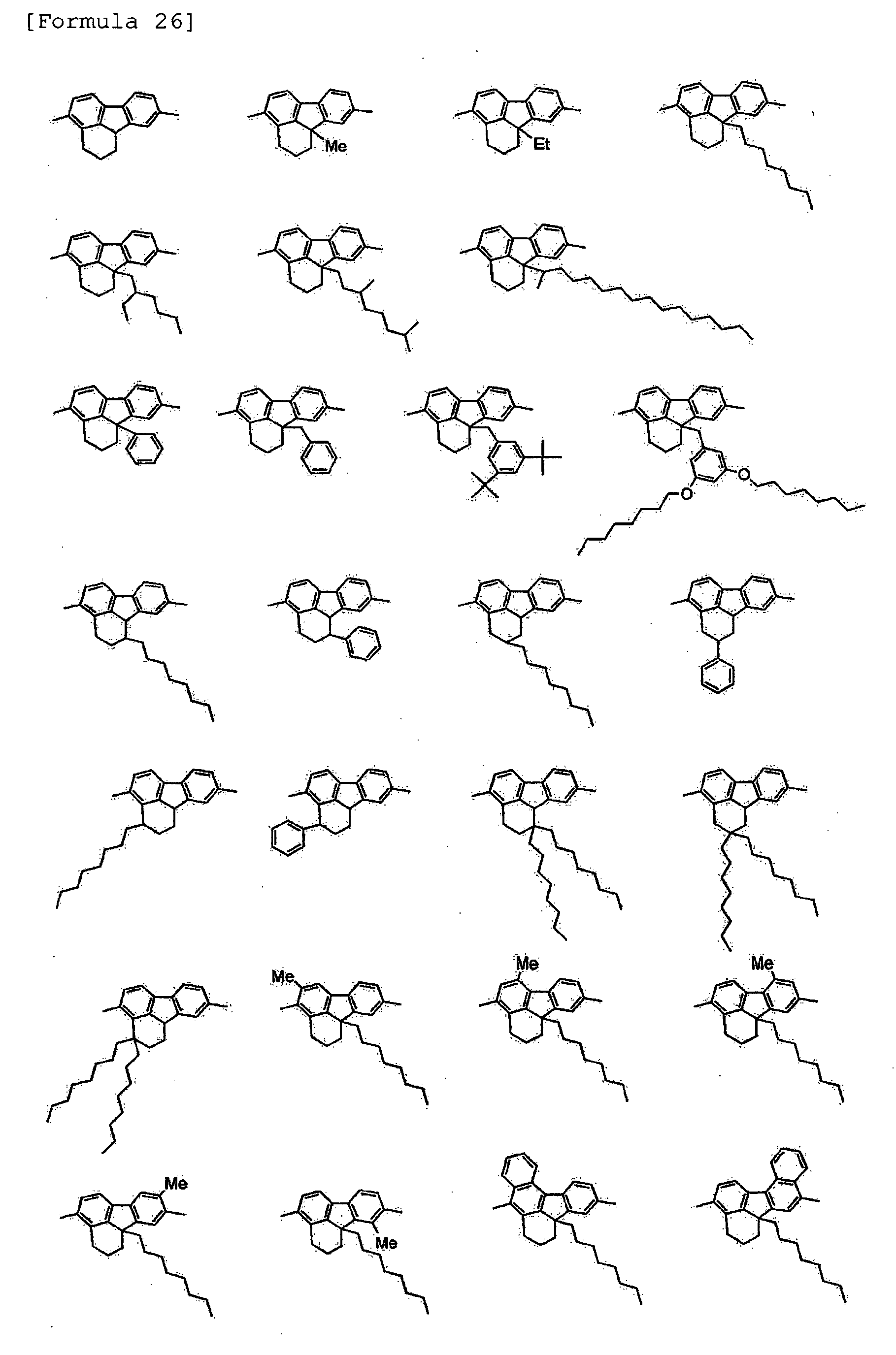

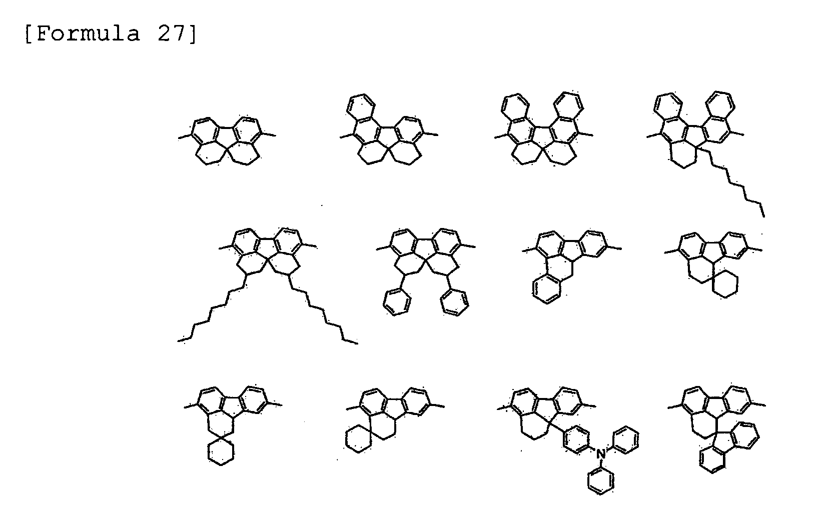

Specific examples of a repeating unit represented by the formula (4-2) may include the following repeating units.

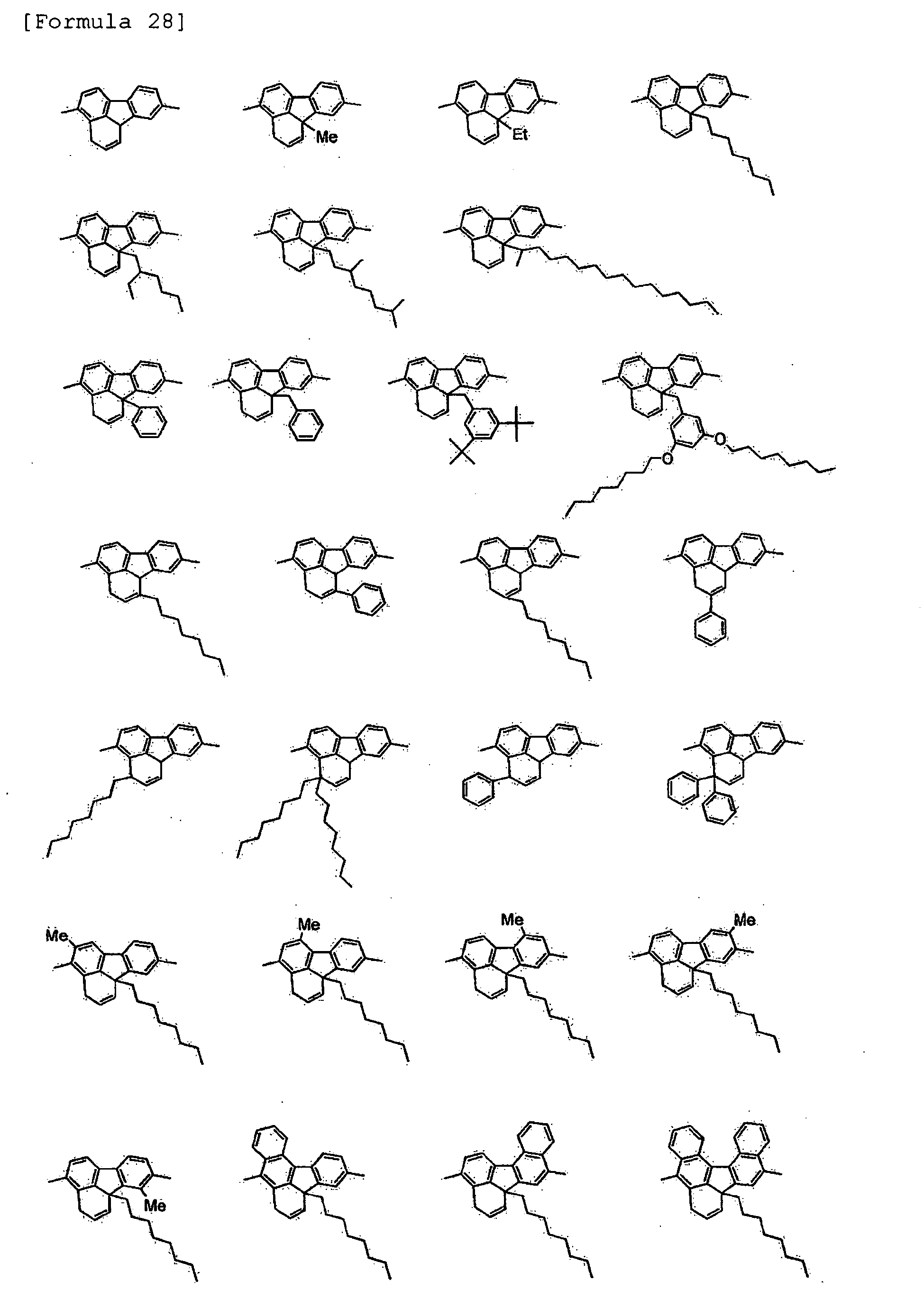

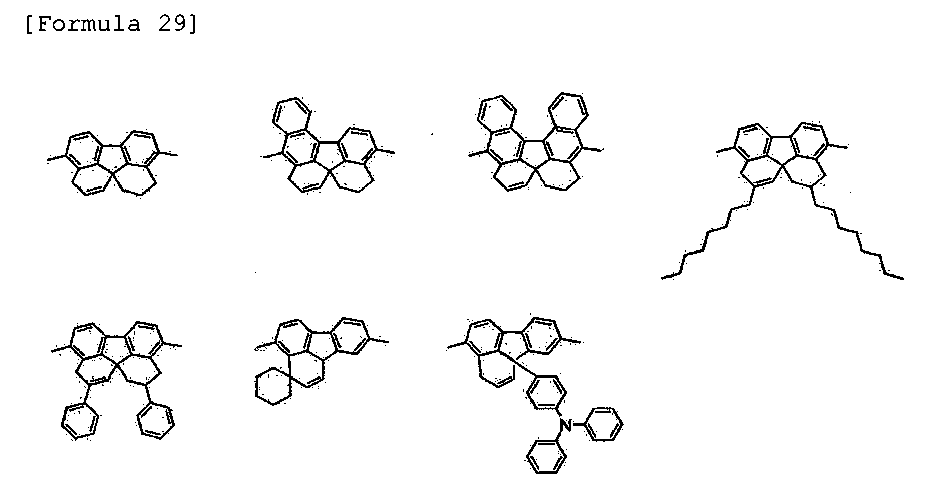

Specific examples of a repeating unit represented by the formula (4-3) may include the following repeating units.

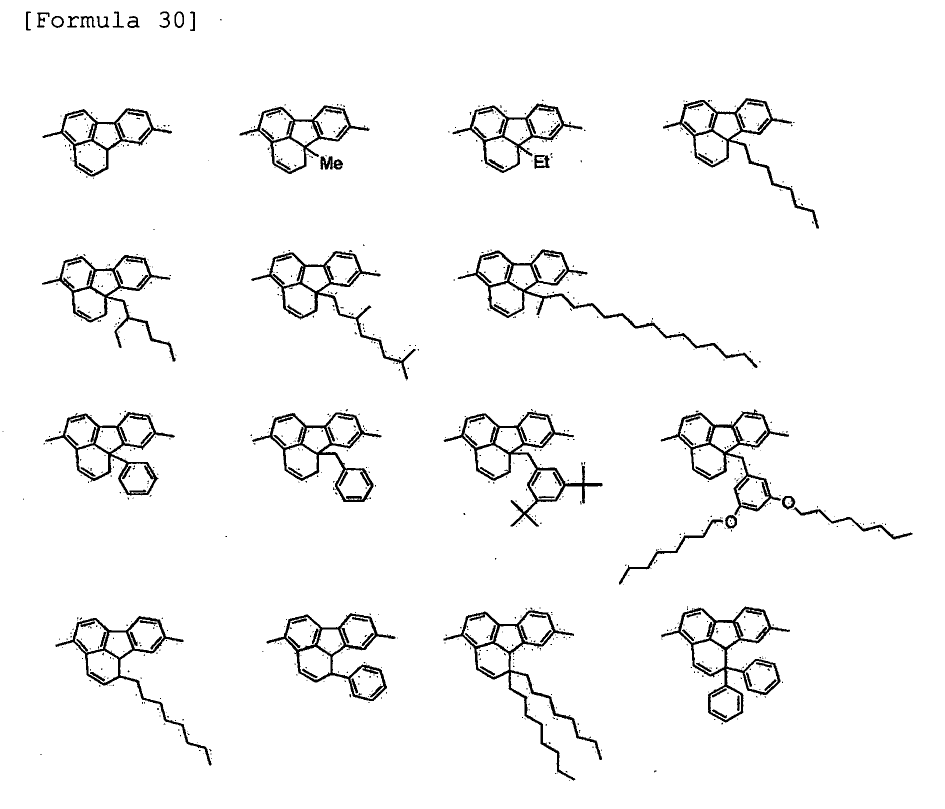

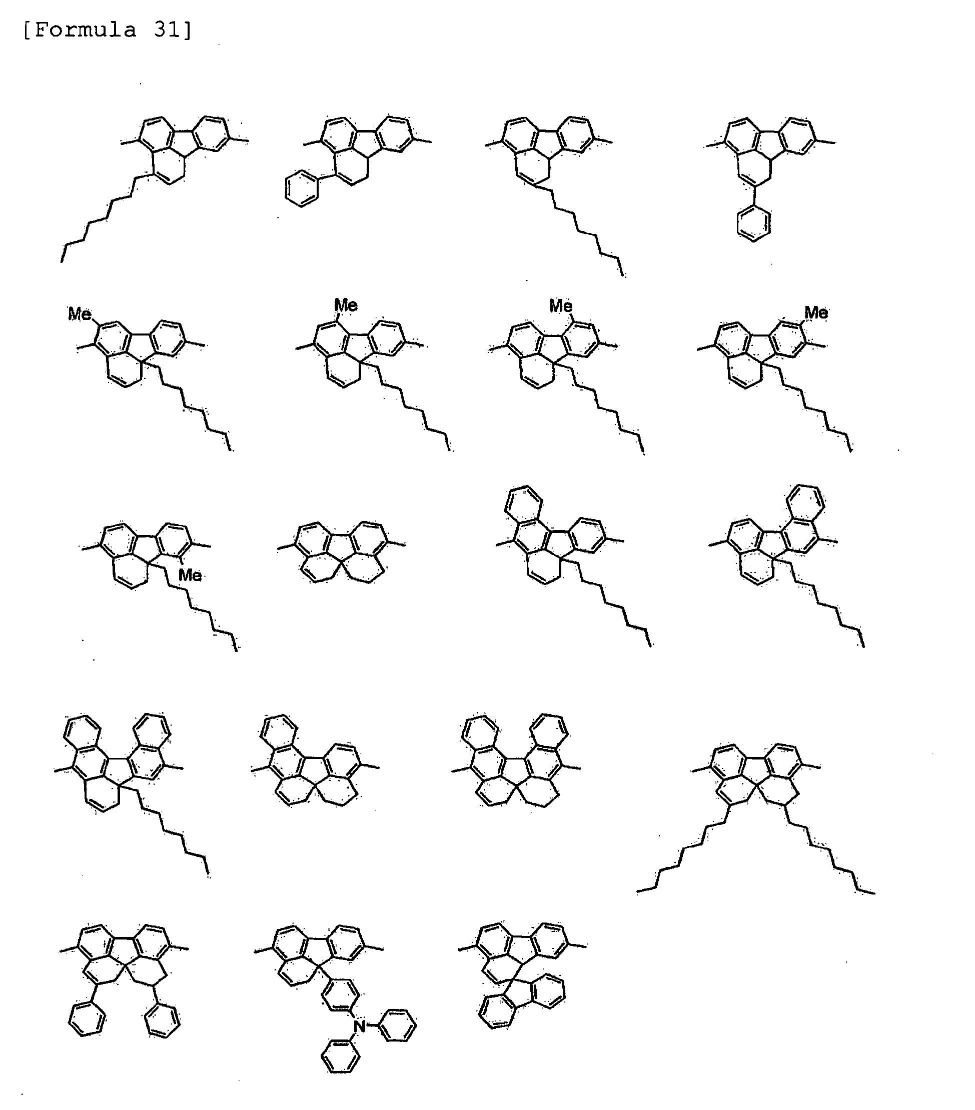

Specific examples of a repeating unit represented by the formula (4-4) may include the following repeating units.

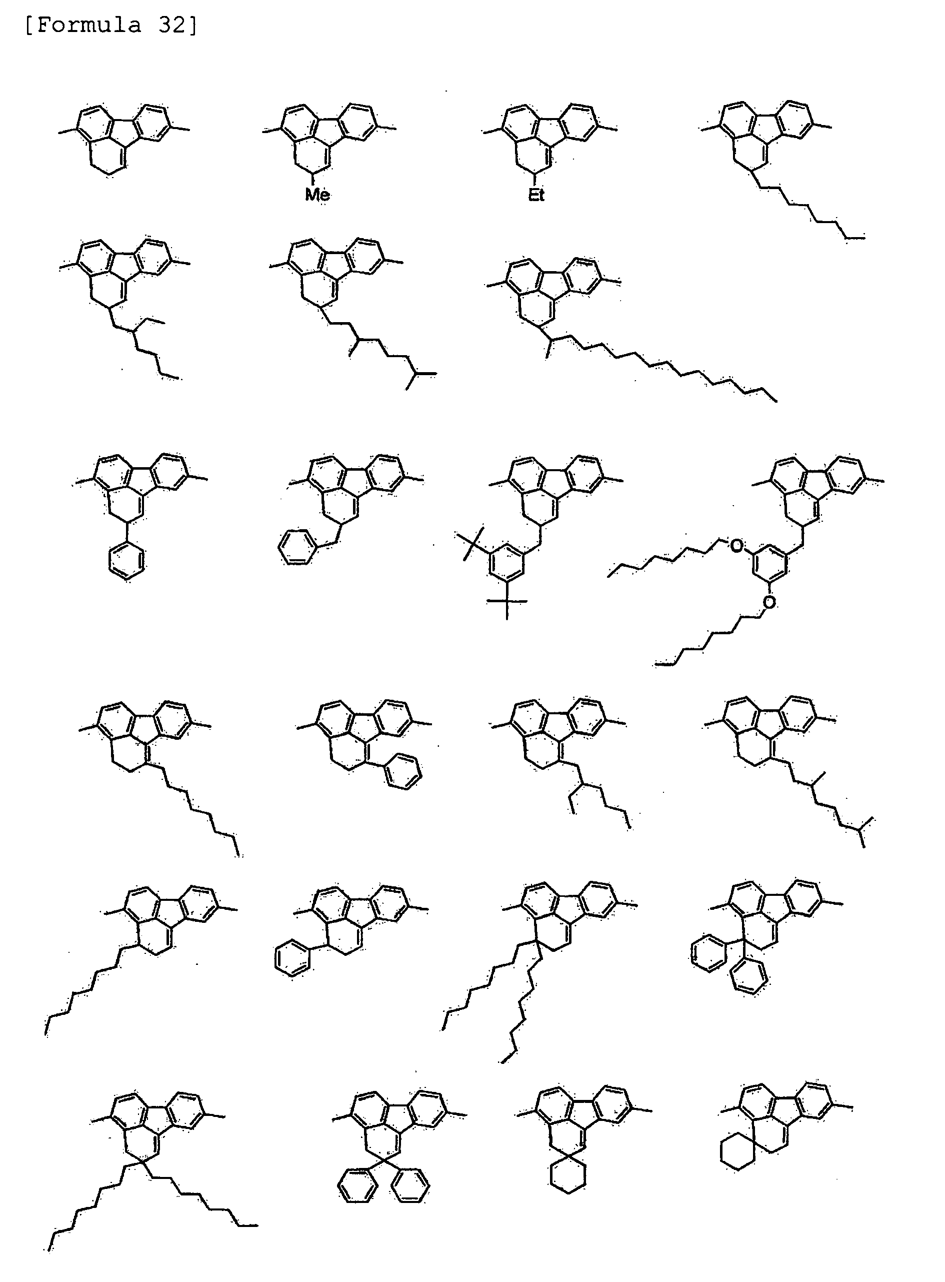

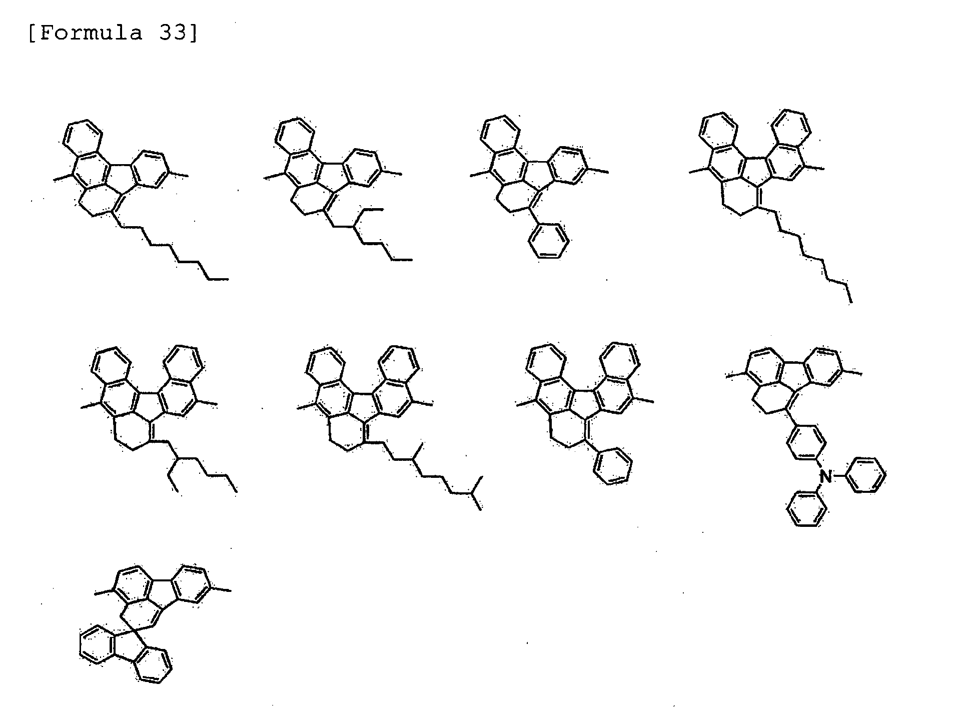

In the formulae, Me represents a methyl group and Et represents an ethyl group.

The total of repeating units with structures represented by the formulae (1-1), (1-2), (1-3), (2-1), (3-1), (4-1), (4-2), (4-3), and (4-4) are typically 1 mole% to 100 mole% (inclusive), preferably 5 mole% to 100 mole% (inclusive), of the total of all the repeating units of a polymer component according to the present invention.

A polymer component according to the present invention is preferably a copolymer, in addition to repeating units represented by the formulae (1-1), (1-2), (1-3), (2-1), (3-1), (4-1), (4-2), (4-3), and (4-4), including one or more other repeating units in view of enhancing light emitting efficiency, enhancing heat resistance, and so on.

Preferred examples of the repeating units other than repeating units represented by the formulae (1-1), (1-2), (1-3), (2-1), (3-1), (4-1), (4-2), (4-3), and (4-4) are represented by the following formulae (5), (6), (7), or (8). 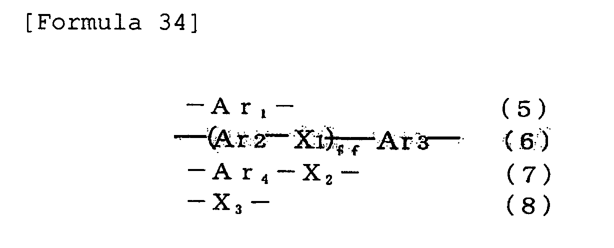 In the formulae, each of Ar₁, Ar₂, Ar₃, and Ar₄ independently represents an arylene group, or a divalent heterocyclic group; each of X₁, X₂, and X₃ independently represents -CR₉=CR₁₀-, -C≡C-, -N(R₁₁)-, or - (SiR₁₂R₁₃)ₘ-; each of R₉ and R₁₀ independently represents a hydrogen atom, an alkyl group, an aryl group, a monovalent heterocyclic group, a carboxyl group, a substituted carboxyl group, or a cyano group; each of R₁₁, R₁₂, and R₁₃ independently represents a hydrogen atom, an alkyl group, an aryl group, a monovalent heterocyclic group, an arylalkyl group, or a substituted amino group; ff represents 1 or 2; m represents an integer of 1 to 12; when there are a plurality of R₉'s, R₁₀'s, R₁₁'s, R₁₂' s and R₁₂' s, respectively, R₉' s to R₁₂' s may be the same or different, respectively.

The arylene group is an atom group where two hydrogen atoms are removed from an aromatic hydrocarbon, and includes arylene groups having a condensed ring, and arylene groups where two or more independent benzene rings or condensed rings are bonded directly or via groups such as vinylene. The arylene group may have a substituent/substituents.
Examples of the substituent/substituents may include: an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, substituted an amino group, a silyl group, substituted a silyl group, halogen atom, an acyl group, an acyloxy group, an imine residue, an amide group, an acid imide group, a monovalent heterocyclic group, a carboxyl group, substituted a carboxyl group, and a cyano group.
The arylene group has typically about 6 to 60 carbon atoms, preferably 6 to 20 carbon atoms, except for its substituents. The arylene group has typically about 6 to 100 carbon atoms with counting the number of carbon atoms of its substituents.
Examples of the arylene group may include: a phenylene group (examples thereof are the following formulae 1 to 3), a naphthalenediyl group (the following formulae 4 to 13), a anthracene-diyl group (the following formulae 14 to 19), a biphenyl-diyl group (the following formulae 20 to 25), a fluorene-diyl group (the following formulae 36 to 38), a terphenyl-diyl group (the following formulae 26 to 28), a condensed ring compound group (the following formulae 29 to 35), stilbene-diyl (the following formulae A to D), and distilbene-diyl (the following formulae E and F).
In particular, preferred arylene groups are a phenylene group, a biphenylene group, a fluorene-diyl group, and a stilbene-diyl group.

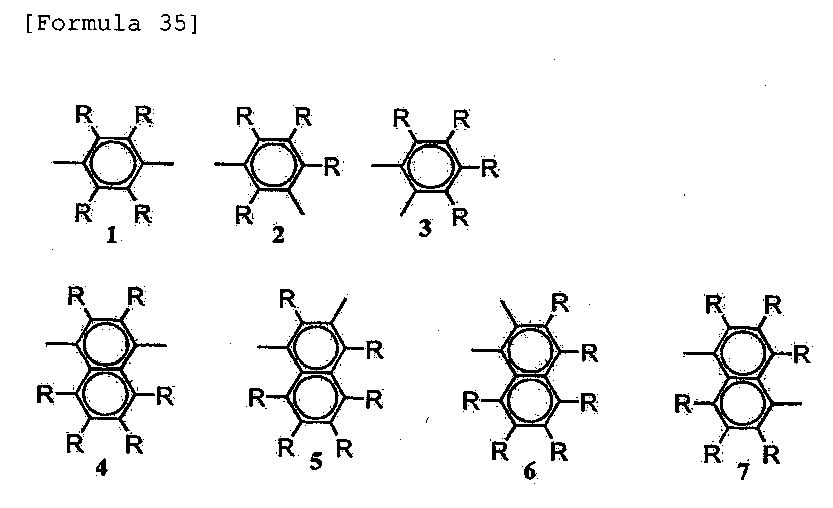

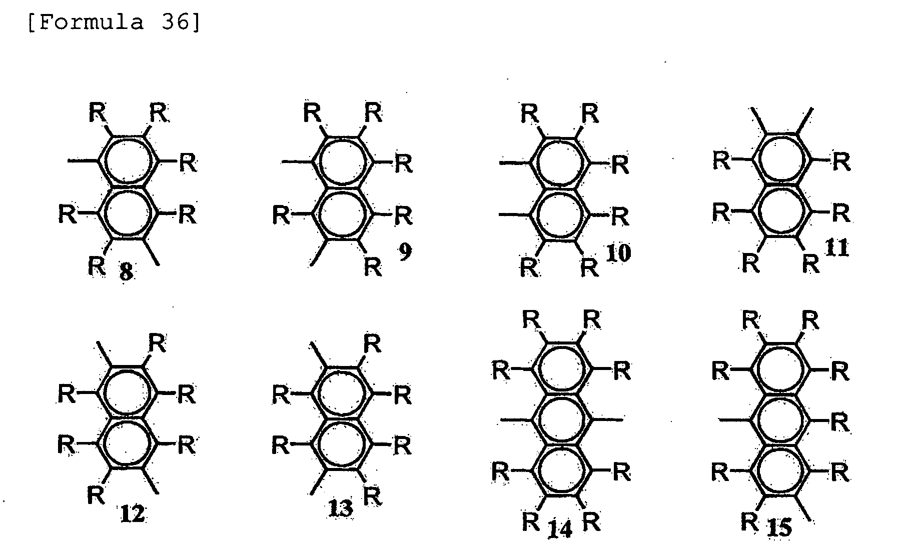

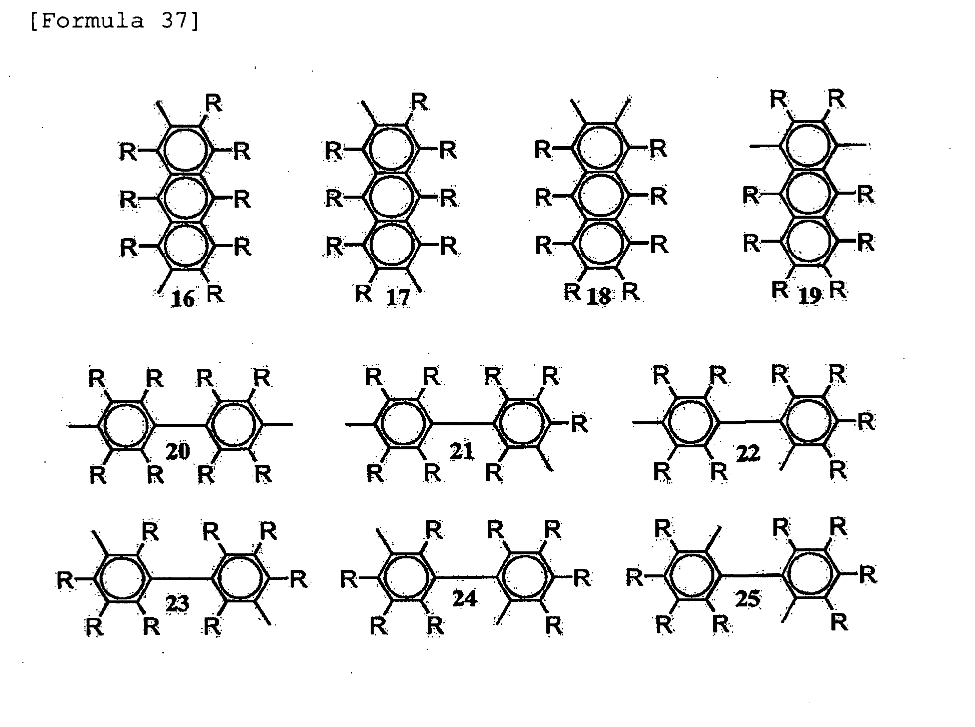

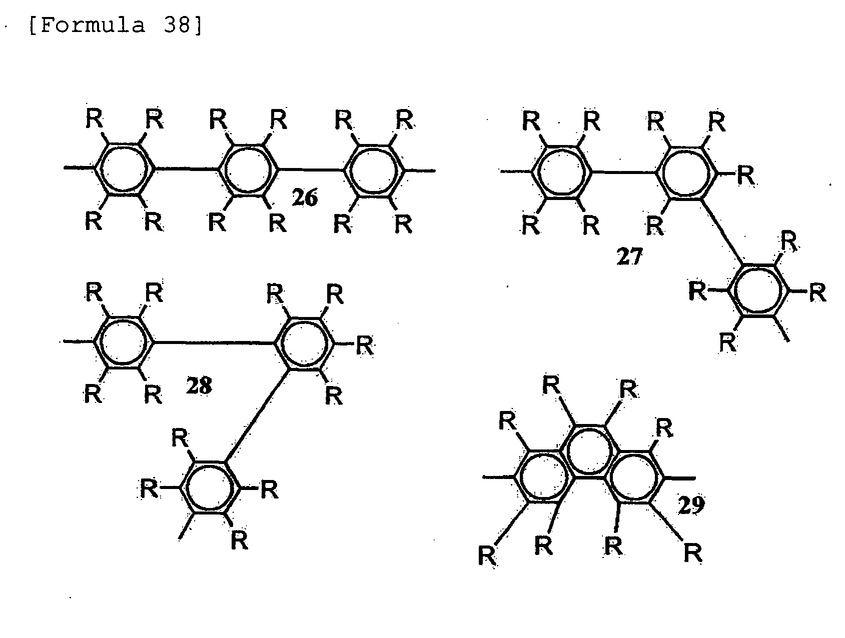

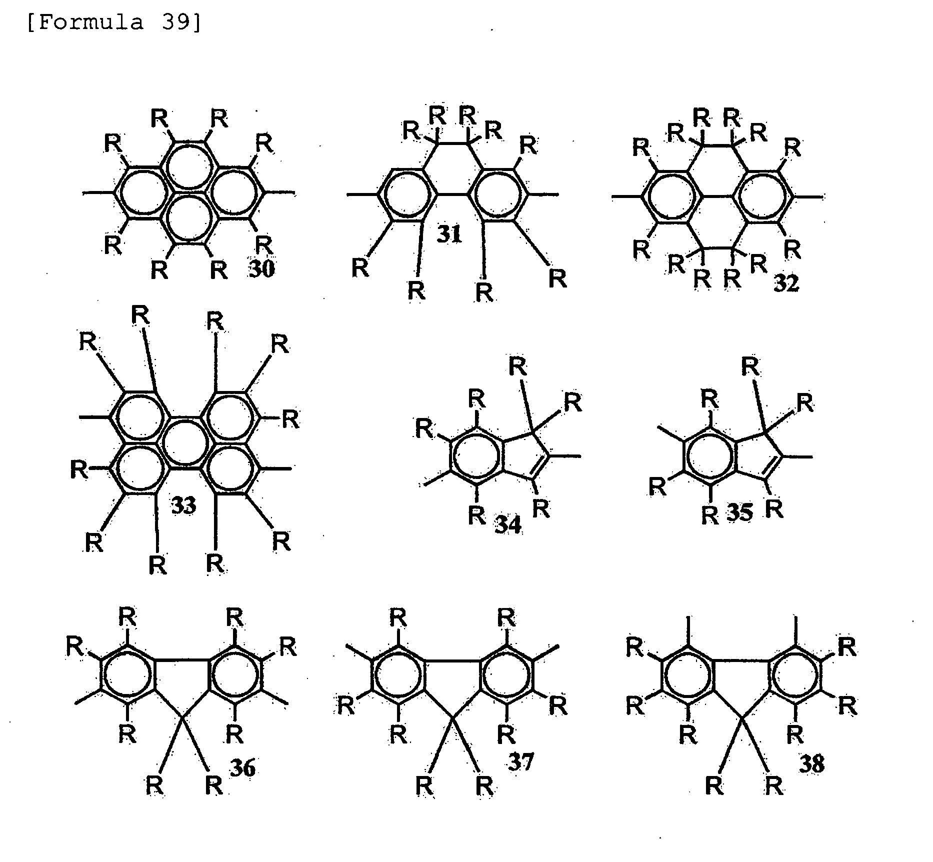

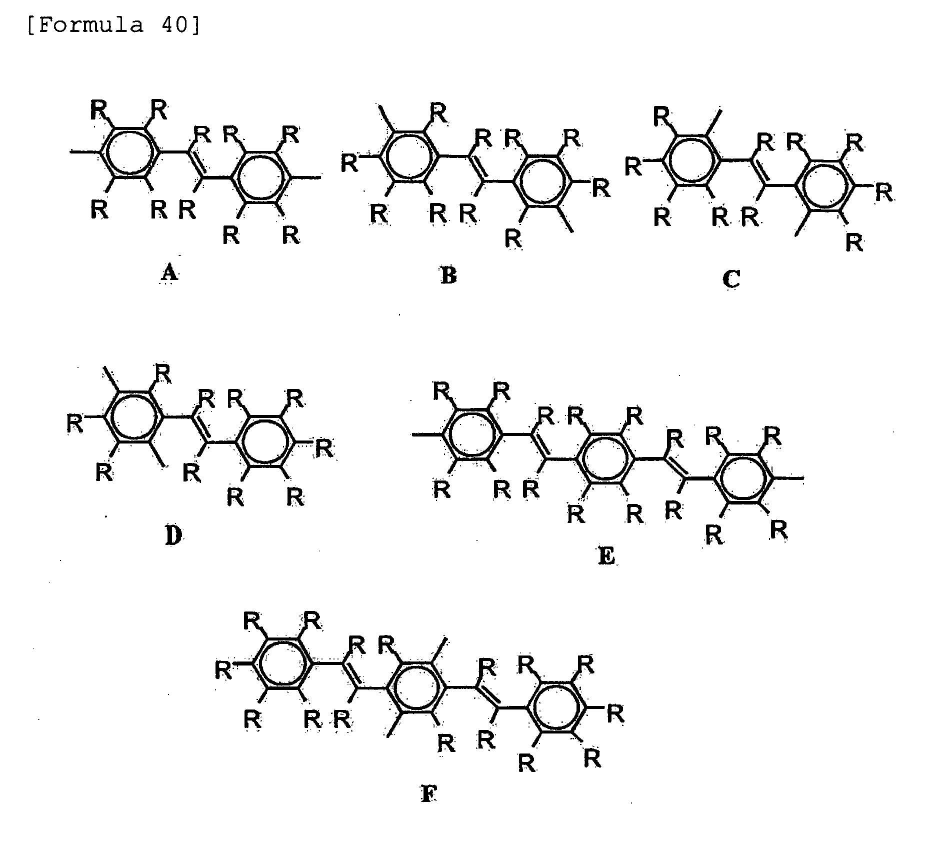

The divalent heterocyclic group in Ar₁, Ar₂, Ar₃, and Ar₄ is an atom group where two hydrogen atoms are removed from a heterocyclic compound. The divalent heterocyclic group may have a substituent/substituents.
The heterocyclic compound is an organic compound with a cyclic structure where the cyclic skeleton is formed with elements not only carbon atoms but also a hetero atom/atoms such as oxygen, sulfur, nitrogen, phosphorus, boron, or arsenic. The divalent heterocyclic group is preferably an aromatic heterocyclic group.
Examples of the substituent/substituents may include: an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, substituted an amino group, a silyl group, substituted a silyl group, halogen atom, an acyl group, an acyloxy group, an imine residue, an amide group, an acid imide group, a monovalent heterocyclic group, a carboxyl group, substituted a carboxyl group, and a cyano group.
The divalent heterocyclic group has typically about 3 to 60 carbon atoms except for its substituents. The divalent heterocyclic group has typically about 3 to 100 carbon atoms with counting the number of carbon atoms of its substituents.

Examples of the divalent heterocyclic group are shown below.
A divalent heterocyclic group having a nitrogen atom/nitrogen atoms as a hetero atom/hetero atoms: a pyridine-diyl group (the following formulae 39 to 44), a diazaphenylene group (the following formulae 45 to 48), a quinolinediyl group (the following formulae 49 to 63), a quinoxalinediyl group (the following formulae 64 to 68), an acridinediyl group (the following formulae 69 to 72), a bipyridyldiyl group (the following formulae 73 to 75), and a phenanthrolinediyl group (the following formulae 76 to 78).
A group with a fluorene structure having a hetero atom/hetero atoms such as silicon, nitrogen, and selenium (the following formulae 79 to 93).
A 5-membered heterocyclic group having a hetero atom such as silicon, nitrogen, sulfur, and selenium (the following formulae 94 to 98).
A 5-membered condensed heterocyclic group having a hetero atom/hetero atoms such as silicon, nitrogen, and selenium (the following formulae 99 to 108).
A group of a dimer or an oligomer where 5-membered ring heterocyclic groups having a hetero atom/hetero atoms such as silicon, nitrogen, sulfur, and selenium are bonded at the α-position of the hetero atom/hetero atoms (the following formulae 109 to 112).
A group where a 5-membered heterocyclic group having a hetero atom/hetero atoms such as silicon, nitrogen, sulfur, and selenium is bonded to a phenyl group at the α-position of the hetero atom/hetero atoms (the following formulae 113 to 119).
A 5-membered condensed heterocyclic group having a hetero atom/hetero atoms such as silicon, nitrogen, and sulfur substituted with a phenyl group, a furyl group, or a thienyl group (the following drawings 120 to 125).

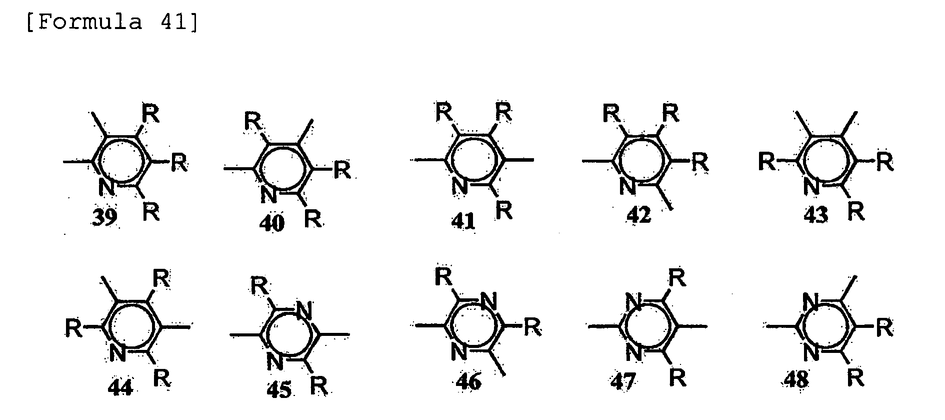

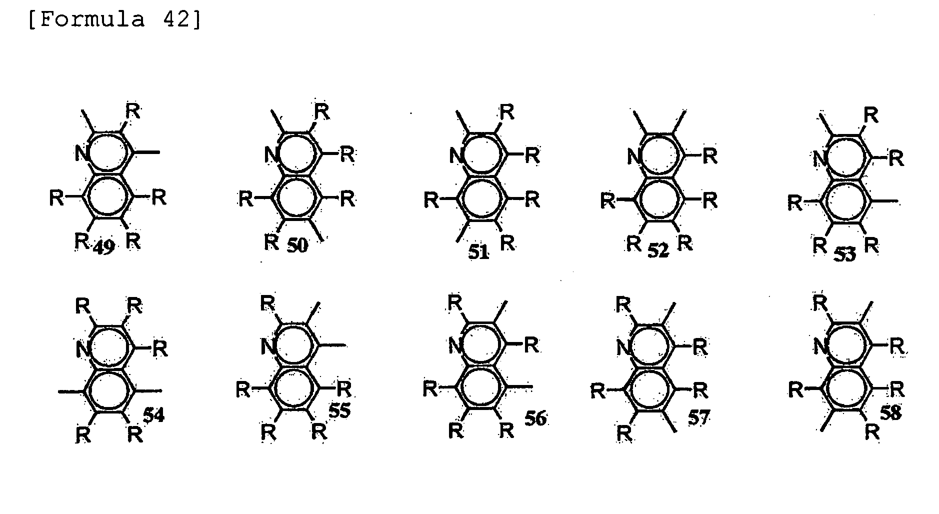

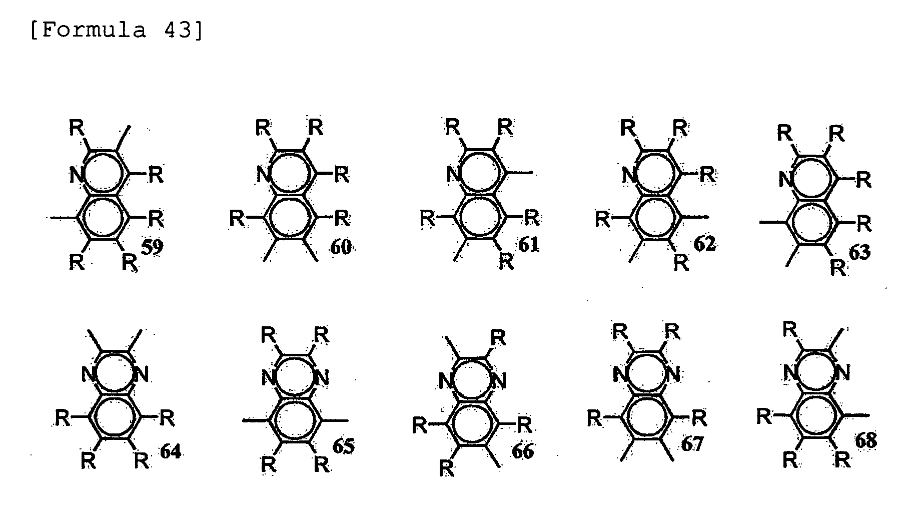

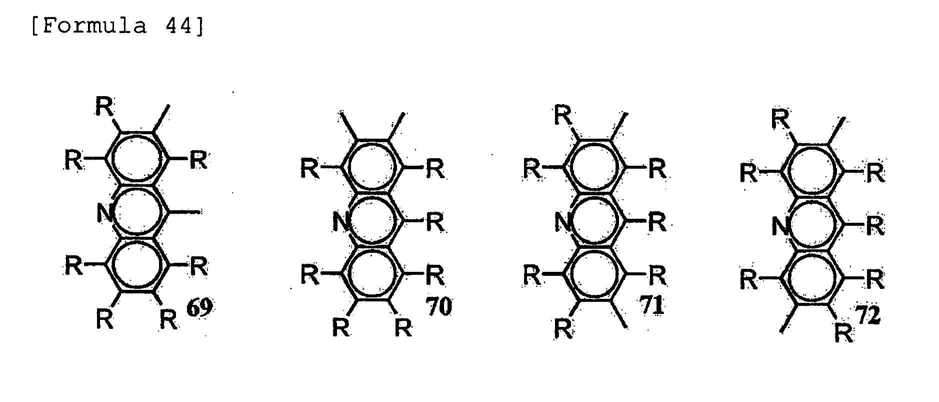

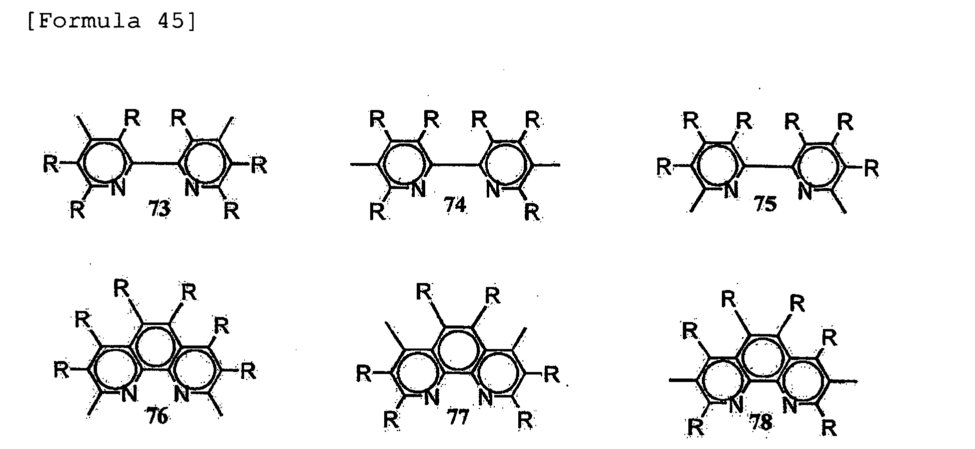

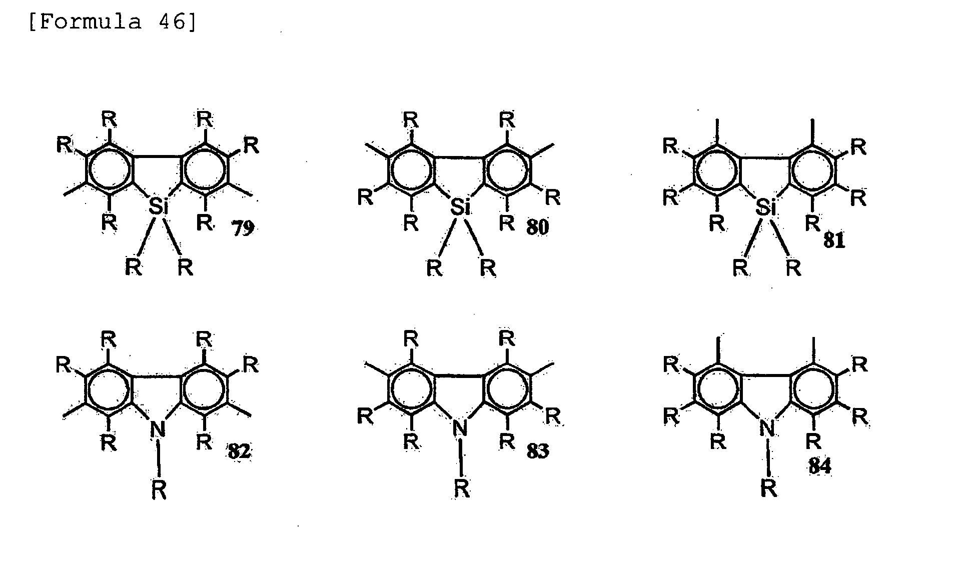

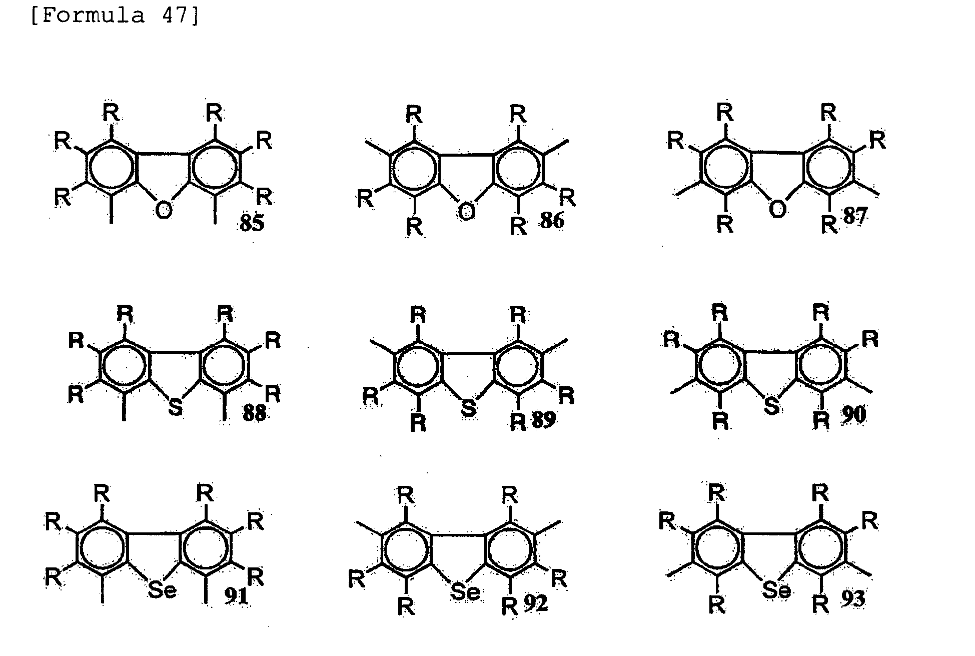

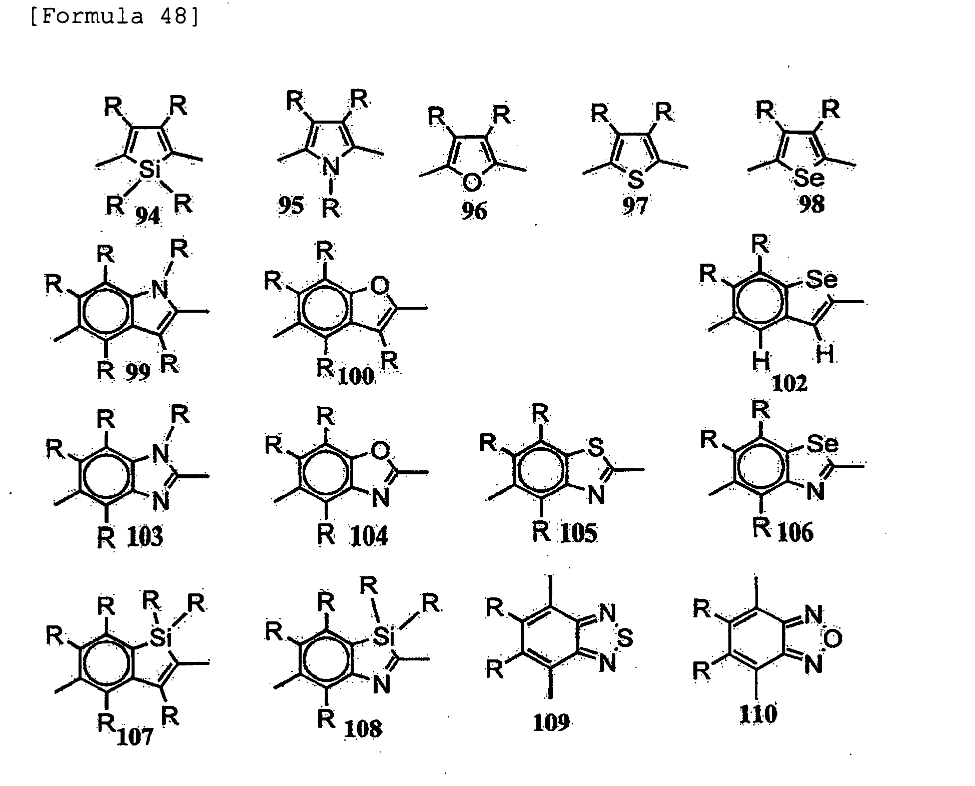

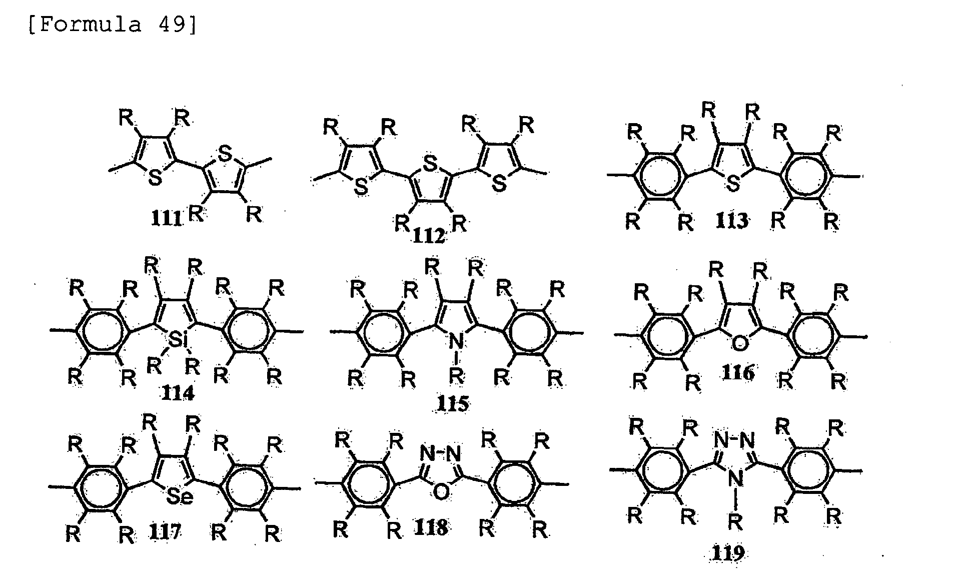

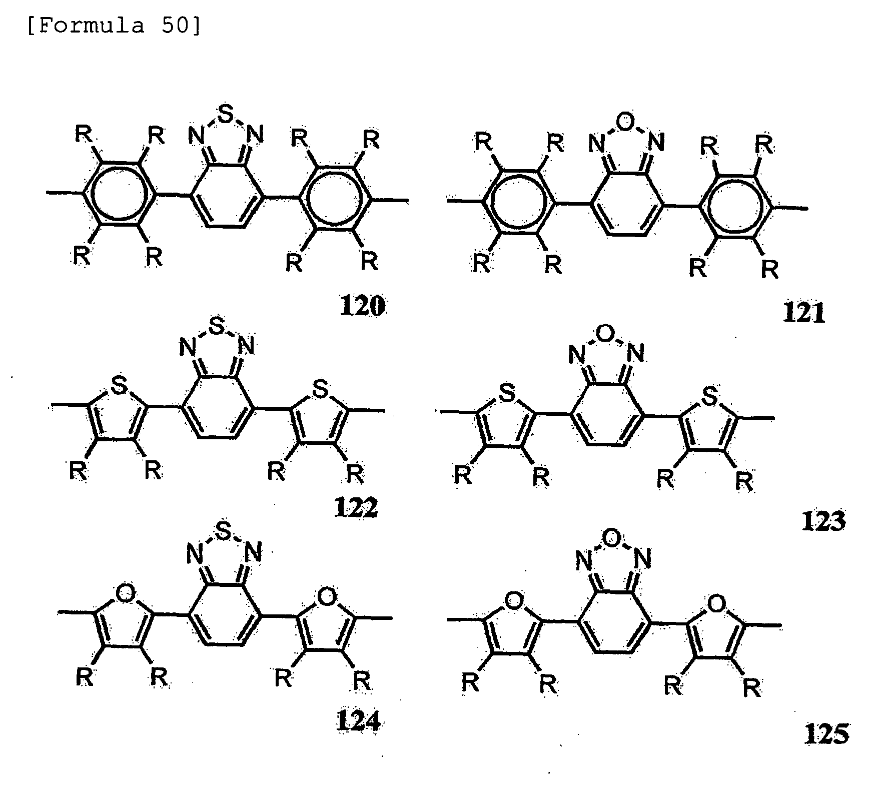

In the formulae 1 to 125, each of R independently represents a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, substituted an amino group, a silyl group, substituted a silyl group, a halogen atom, an acyl group, an acyloxy group, an imine residue, an amide group, an acid imide group, a monovalent heterocyclic group, a carboxyl group, substituted a carboxyl group, or a cyano group. The carbon atoms of the groups in the formulae 1 to 132 may be replaced with nitrogen atoms, oxygen atoms, or sulfur atoms. Likewise, the hydrogen atoms may be replaced with fluorine atoms.

Among the repeating units represented by the formulae (5), (6), (7), and (8), repeating units represented by the following formulae (9), (10), (11), (12), and (13) are preferable. 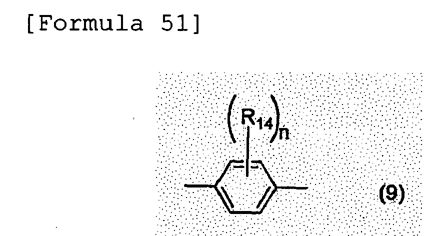 In the formula, R₁₄ represents an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, substituted an amino group, a silyl group, substituted a silyl group, a halogen atom, an acyl group, an acyloxy group, an imine residue, an amide group, an acid imide group, a monovalent heterocyclic group, a carboxyl group, substituted a carboxyl group, or a cyano group; n represents an integer of 0 to 4; when there are a plurality of R₁₄, R₁₄ may be the same or different. 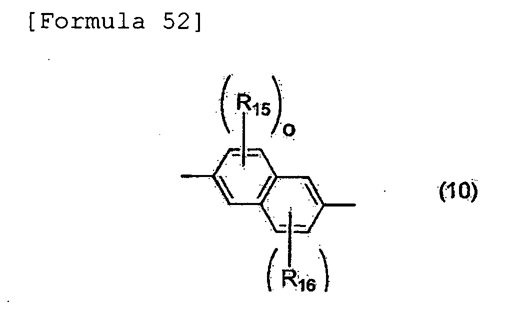 In the formula, each of R₁₅ and R₁₆ independently represents an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, substituted an amino group, a silyl group, substituted a silyl group, a halogen atom, an acyl group, an acyloxy group, an imine residue, an amide group, an acid imide group, a monovalent heterocyclic group, carboxyl group, substituted a carboxyl group, or a cyano group; o and p independently represent an integer of 0 to 3; when there are a plurality of R₁₅ and R₁₆, R₁₅ and R₁₆ may be the same or different. 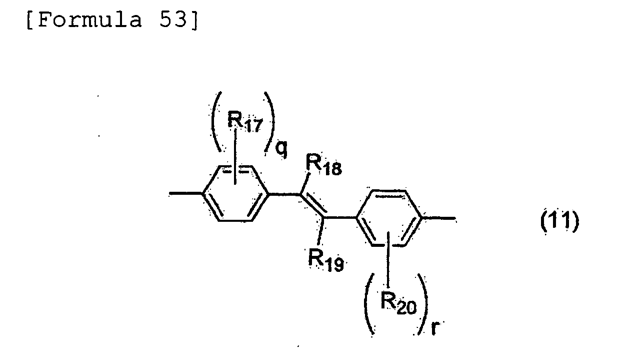 In the formula, each of R₁₇ and R₂₀ independently represents an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, substituted an amino group, a silyl group, substituted a silyl group, a halogen atom, an acyl group, an acyloxy group, an imine residue, an amide group, an acid imide group, a monovalent heterocyclic group, a carboxyl group, substituted a carboxyl group, or a cyano group; each of q and r independently represents an integer of 0 to 4; each of R₁₈ and R₁₉ independently represents a hydrogen atom, an alkyl group, an aryl group, a monovalent heterocyclic group, a carboxyl group, substituted a carboxyl group, or a cyano group; when there are a plurality of R₁₇ and R₂₀, R₁₇ and R₂₀ may be the same or different. 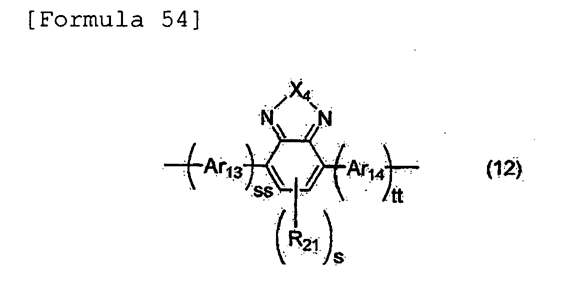 In the formula, R₂₁ represents an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, substituted an amino group, a silyl group, substituted a silyl group, a halogen atom, an acyl group, an acyloxy group, an imine residue, an amide group, an acid imide group, a monovalent heterocyclic group, a carboxyl group, substituted a carboxyl group, or a cyano group; s represents an integer of 0 to 2; each of Ar₁₃ and Ar₁₄ independently represents an arylene group, a divalent heterocyclic group, or a divalent group including a metal complex structure; each of ss and tt independently represents 0 or 1.
X₄ represents O, S, SO, SO₂, Se, or Te. When there are a plurality of R₂₁, R₂₁ may be the same or different. 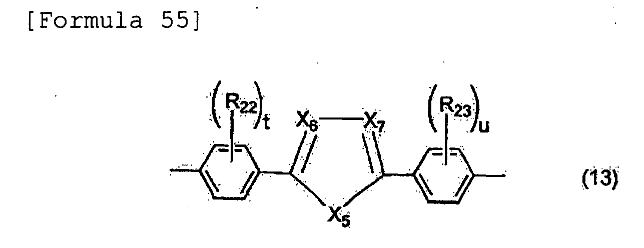 In the formula, each of R₂₂ and R₂₅ independently represents an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, substituted an amino group, a silyl group, substituted a silyl group, a halogen atom, an acyl group, an acyloxy group, an imine residue, an amide group, an acid imide group, a monovalent heterocyclic group, a carboxyl group, substituted a carboxyl group, or a cyano group; each of t and u independently represents an integer of 0 to 4; X₅ represents O, S, SO₂, Se, Te, N-R₂₄ or SiR₂₅R₂₆; each of X₆ and X₇ independently represents N or C-R₂₇; each of R₂₄, R₂₅, R₂₆, and R₂₇ independently represents a hydrogen atom, an alkyl group, an aryl group, an arylalkyl group, or a monovalent heterocyclic group; when there are a plurality of R₂₂, R₂₃, and R₂₇, R₂₂, R₂₃, and R₂₇ may be the same or different.
Examples of the 5-membered ring at the center of the repeating unit represented by the formula (11) may include: thiadiazole, oxadiazole, triazole, thiophene, furan, and silole.

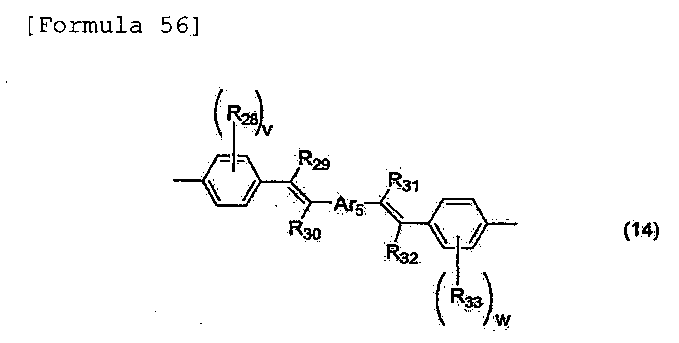

In the formula, each of R₂₈ and R₃₃ independently represents an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, substituted an amino group, a silyl group, substituted a silyl group, a halogen atom, an acyl group, an acyloxy group, an imine residue, an amide group, an acid imide group, a monovalent heterocyclic group, carboxyl group, substituted a carboxyl group, or a cyano group; each of v and w independently represents an integer of 0 to 4; each of R₂₉, R₃₀, R₃₁, and R₃₆ independently represents a hydrogen atom, an alkyl group, an aryl group, a monovalent heterocyclic group, a carboxyl group, substituted a carboxyl group, or a cyano group; Ar₅ represents an arylene group, a divalent heterocyclic group, or a divalent group including a metal complex structure; when there are a plurality of R₂₈ and R₃₃, R₂₈ and R₃₃ may be the same or different.
Among the repeating units represented by the formula (6), preferred are repeating units represented by the following formula (15) in view of enhancing light emitting efficiency, and enhancing heat resistance. 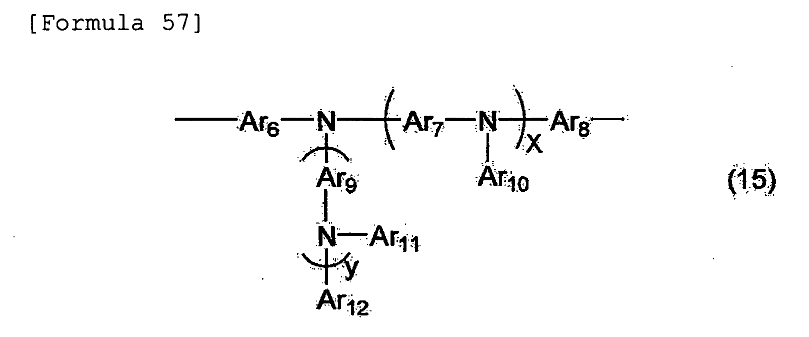 In the formula, each of Ar₆, Ar₇, Ar₈, and Ar₉ independently represents an arylene group, or a divalent heterocyclic group; each of Ar₁₀, Ar₁₁, and Ar₁₂ independently represents an aryl group, or a monovalent heterocyclic group; Ar₆, Ar₇, Ar₈, Ar₉, and Ar₁₀ may have a substituent/substituents; each of x and y independently represents 0 or 1; and 0≤x+y≤1.

Specific examples of the repeating units represented by the formula (15) may include repeating units represented by the following formulae 133 to 140.

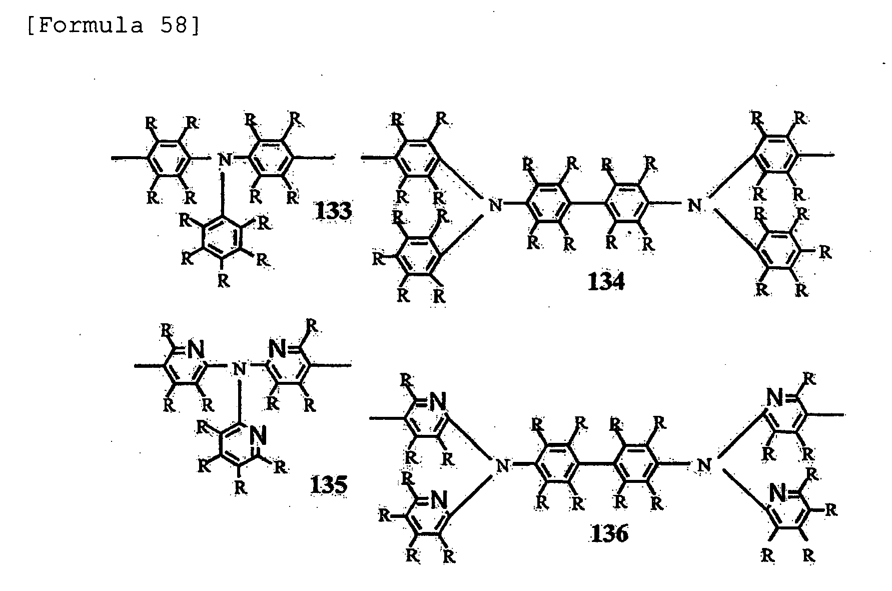

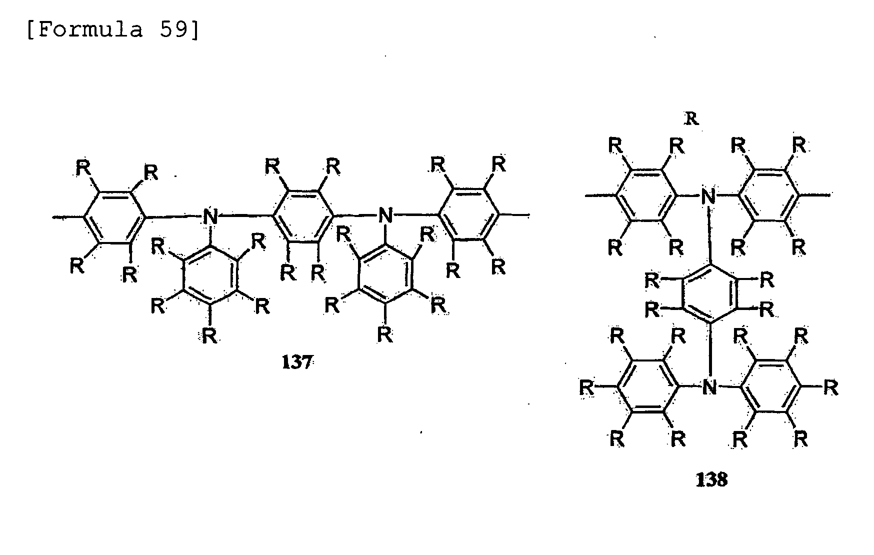

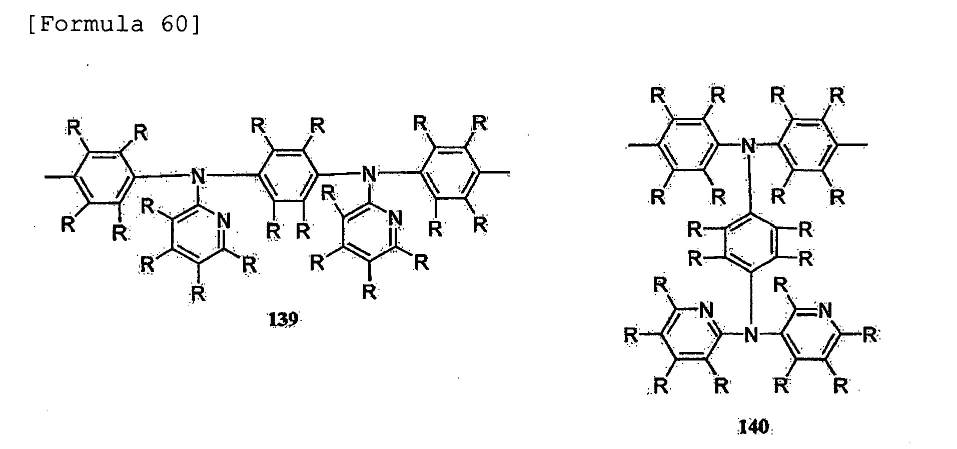

In the formulae, R are the same as R in the formulae 1 to 132.
In order to enhance the solubility of the polymer in solvents, the repeating units preferably have one or more atoms other than hydrogen atoms, and the repeating units including substituents preferably have less symmetry.

When R in the formulae are substituents including alkyl groups, R preferably include one or more cyclic or branched alkyl groups to enhance the solubility of the polymer compound in solvents.
When R in the formulae include aryl groups or heterocyclic groups, the aryl groups or the heterocyclic groups may have one or more substituents.

In the repeating units represented by the formula (15), it is preferred that each of Ar₆, Ar₇, Ar₈, and Ar₉ independently represents an arylene group and each of Ar₁₀, Ar₁₁, and Ar₁₂ independently represents an aryl group in view of adjusting the wavelength of emitted light, in view of device properties, and the like.

It is preferred that each of Ar₆, Ar₇, and Ar₈ independently represents a non-substituted phenylene group, a non-substituted biphenyl group, a non-substituted naphthylene group, or a non-substituted anthracene-diyl group.

In view of solubility, light emitting efficiency, and stability, it is preferred that each of Ar₁₀, Ar₁₁, and Ar₁₂ independently represents an aryl group with three or more substituents; more preferably, a phenyl group with three or more substituents, a naphthyl group with three or more substituents, or an anthranyl group with three or more substituents; still more preferably, a phenyl group with three or more substituents.

In particular, each of Ar₁₀, Ar₁₁, and Ar₁₂ is independently represented by the following formula (15-1) . 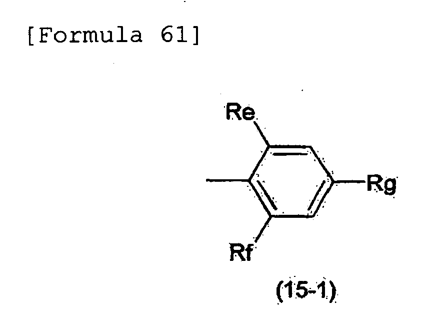 In the formula, each of Re, Rf, and Rg independently represents an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, substituted an amino group, a silyl group, substituted a silyl group, a silyloxy group, substituted a silyloxy group, a monovalent heterocyclic group, or a halogen atom.

In the repeating units represented by the formula (15), Ar₇ preferably represents the following formula (15-2) or (15-3). 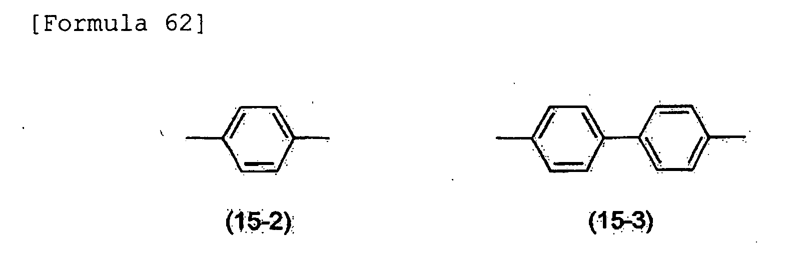 In the formulae, the benzene rings included in the structures represented by the formulae (15-2) and (15-3) may independently have one or more and four or less substituents; the substituents may be the same or different; a plurality of substituents may be linked to form a ring; the benzene rings may be bonded with another aromatic hydrocarbon ring or heterocyclic ring.

In the repeating units represented by the formula (15), particularly preferred specific examples may include repeating units represented by the following formulae 141 and 142. 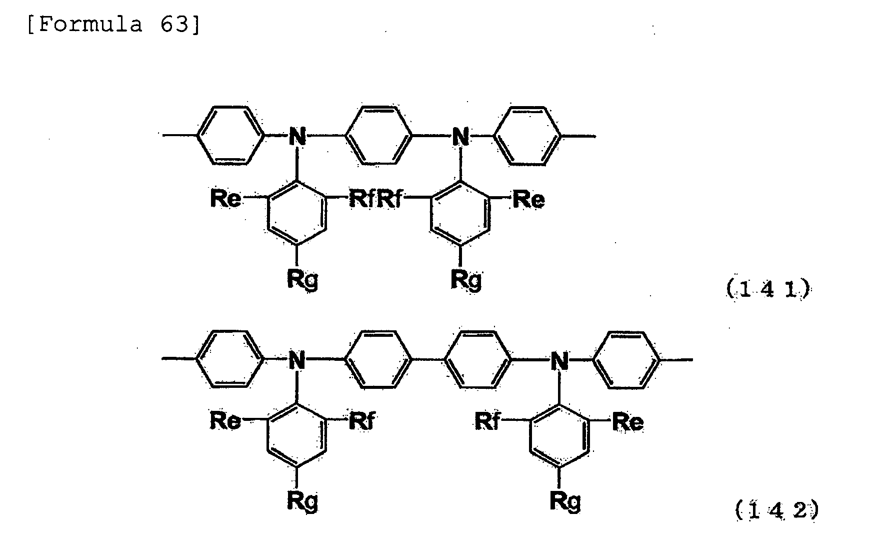 In the formulae, Re to Rg are the same as above.

In the formulae, Re to Rg are the same as Re to Rg in the formulae 1 to 132. In order to enhance the solubility of the polymer in solvents, the repeating units preferably have one or more atoms other than hydrogen atoms, and the repeating units including their substituents preferably have less symmetry.
When R in the formulae are substituents including alkyl chain, R preferably include one or more cyclic or branched alkyl chain to enhance the solubility of the polymer compound in solvents.
When R in the formulae include aryl groups or heterocyclic groups, the aryl groups or the heterocyclic groups may have one or more substituents.

A polymer compound of the present invention may include repeating units other than repeating units represented by the formulae (1-1), (1-2), (1-3), and (5) to (15) as long as light emitting properties or charge transporting properties are not impaired. The repeating units and other repeating units may be linked via non-conjugate units. The repeating units may include the non-conjugate units. Examples of the linking structure may include the following structures and combinations of two or more of the following structures. In the formulae, R are groups selected from the substituents mentioned above; Ar represents a hydrocarbon group with 6 to 60 carbon atoms.

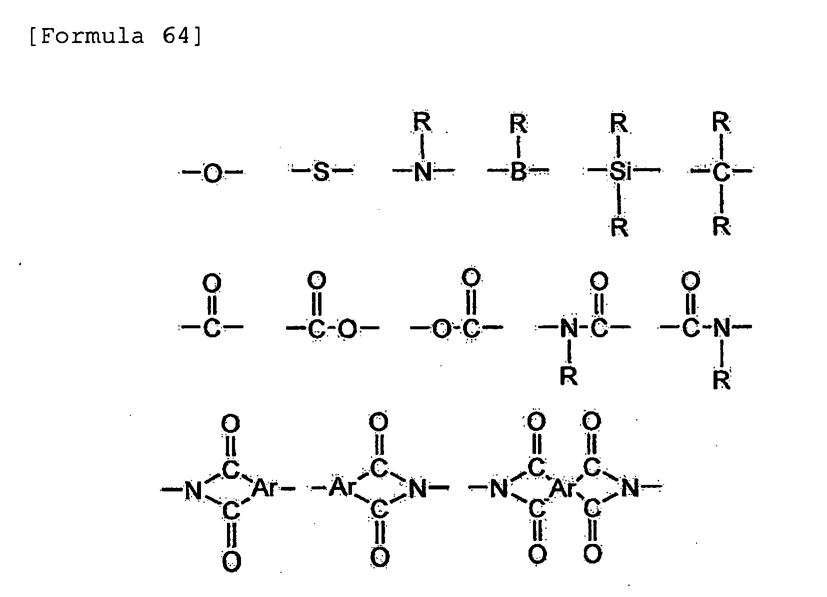

Among polymers (A) according to the present invention, preferred are polymers composed of only a repeating unit represented by the formula (1-1), and/or polymers composed of only a repeating unit represented by the formula (1-2), and/or polymers composed of only a repeating unit represented by the formula (1-3), and polymers substantially composed of repeating units represented by the formula (1-1), and/or (1-2), and/or (1-3), and one or more repeating units represented by the formula (5) to (15).

Hereinafter, there is described a method of producing a polymer (A) according to the present invention,
Among polymer compounds according to the present invention, for example, polymer compounds having repeating units represented by the formulae (1-1), (1-2), and (1-3) can be produced by polymerization by using compounds represented by the following formulae (16-1), (16-2), and (16-3) as part of the materials. 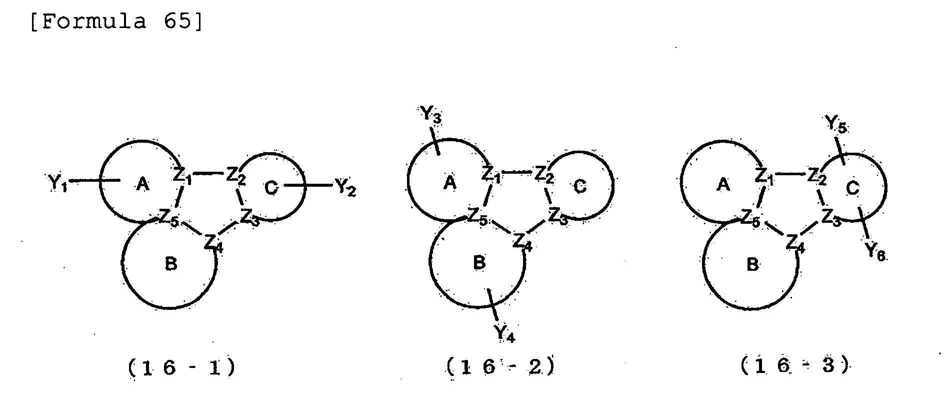 In the formulae, the rings A, B, and C, and Z₁ to Z₅ represent the same as above; each of Y₁, Y₂, Y₃, Y₄, Y₅, and Y₆ independently represents a substituent to be involved in polymerization.

Among compounds represented by the formula (16-1), preferred are compounds represented by the formula (17-1). 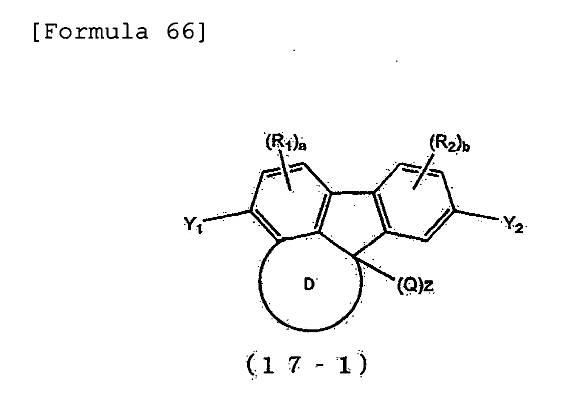 In the formula, R₁, R₂, a, b, the ring D, Q, z, Y₁, and Y₂ represent the same as above.

Among compounds represented by the formula (17-1), more preferred are structures represented by the formulae (18-1), (18-2), (18-3), and (18-4).

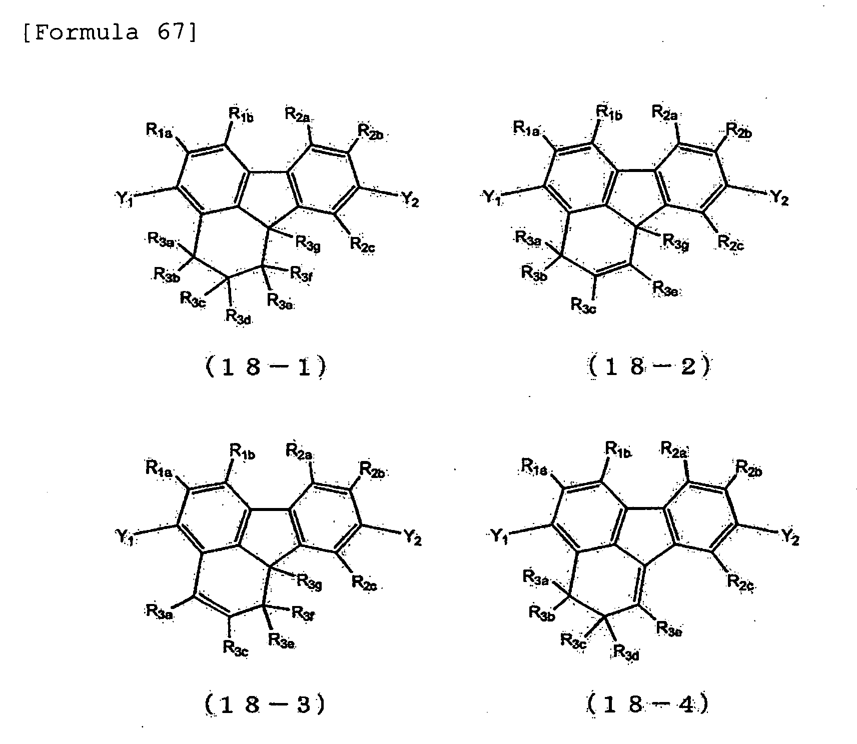

Among compounds represented by the formula (16-2), preferred are compounds represented by the formula (17-2). 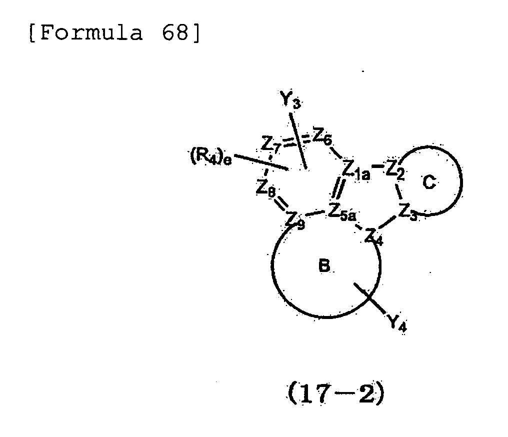 In the formulae, the B ring, the C ring, Z₂, Z₃, Z₄, Y₃, and Y₄ represent the same as above; each of Z₆, Z₇, and Z₈ independently represents C-(Q)z or a nitrogen atom; each of Z₁ₐ, Z₅ₐ, and Z₉ independently represents a carbon atom; Q and z represent the same as above; R₄ represents a substituent; e represents an integer of 0 to 2; when there are a plurality of R₄, R₄ may be the same or different; R₄ may be linked to each other to form a ring.

Among compounds represented by the formula (16-3), preferred are compounds represented by the formula (17-3). 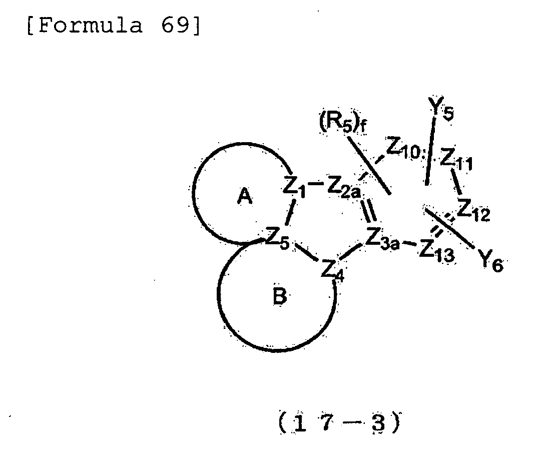 In the formulae, the A ring, the B ring, Z₁, Z₄, Z₅, Y₅, and Y₆ represent the same as above; each of Z₁₀, Z₁₁, Z₁₂, and Z₁₃ independently represents C-(Q)z or a nitrogen atom; each of Z₂ₐ and Z₃ₐ independently represents a carbon atom; Q and z represent the same as above; R₅ represents a substituent; f represents an integer of 0 to 2; when there are a plurality of R₅, R₅ may be the same or different; R₅ may be linked to each other to form a ring.

In a production method according to the present invention, examples of substituents to be involved in polymerization may include: a halogen atom, an alkylsulfonate group, an arylsulfonate group, an arylalkylsulfonate group, a boric acid ester group, a sulfonium methyl group, a phosphonium methyl group, a phosphonate methyl group, a methyl monohalide group, - B(OH)₂, a formyl group, a cyano group, and a vinyl group.

Examples of the halogen atom may include: a fluorine atom, a chlorine atom, a bromine atom, and an iodine atom. Preferred are a bromine atom, and an iodine atom in view of increasing degree of polymerization.

Examples of the alkylsulfonate group may include a methanesulfonate group, an ethanesulfonate group, and a trifluoromethanesulfonate group. Examples of the arylsulfonate group may include a benzenesulfonate group, and a p-toluenesulfonate group. Examples of the arylsulfonate group may include a benzylsulfonate group.

Examples of the boric acid ester group may include groups represented by the following formulae. 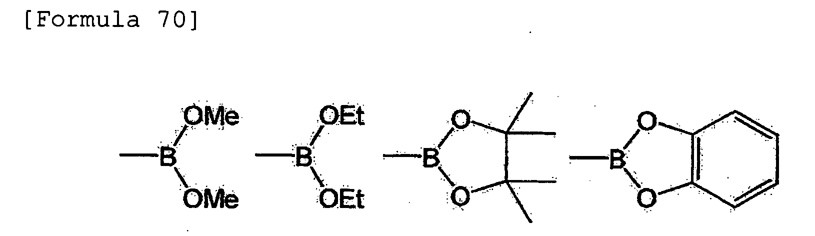 In the formulae, Me represents a methyl group; Et represents an ethyl group.

Examples of the sulfonium methyl group may include groups represented by the following formulae:

-CH₂S⁺Me₂X⁻, and -CH₂S⁺Ph₂X⁻,

wherein X represents a halogen atom; Ph represents a phenyl group.

Examples of the phosphonium methyl group may include groups represented by the following formula:

-CH₂P⁺Ph₃X⁻,

wherein X represents a halogen atom.

Examples of the phosphonate methyl group may include groups represented by the following formula:

-CH₂PO(OR')₂,

wherein X represents a halogen atom; R' represents an alkyl group, an aryl group, or an arylalkyl group.

Examples of the methyl monohalide group may include: a methyl fluoride group, a methyl chloride group, a methyl bromide group, and a methyl iodide group.

Preferred substituents to be involved in the polymerization may vary depending on the type of the polymerization reaction. For example, when the reaction is the Yamamoto coupling reaction or the like which uses a zerovalent nickel complex, preferred substituents may include a halogen atom, an alkylsulfonate group, an arylsulfonate group and an arylalkylsulfonate group. When the reaction is the Suzuki coupling reaction or the like which uses a nickel or palladium catalyst, preferred substituents may include an alkylsulfonate group, a halogen atom, a boric acid ester group, and -B(OH)₂.

In particular, a polymer compound having a repeating unit represented by the formula (4-1) can also be obtained by hydrogenating polymer compounds having repeating units represented by the formulae (4-2) to (4-4) with a catalyst where a noble metal such as palladium, platinum, rhodium, ruthenium, or mixture thereof is held on activated carbon.

Conversely, polymer compounds having repeating units represented by the formulae (4-2) to (4-4) can also be obtained by oxidizing a polymer compound having a repeating unit represented by the formula (4-1) with 2,3-dichloro-5,6-dicyano-1,4-benzoquinone (DDQ), or with tetrabutylammonium bromide under a basic condition.

A polymer according to the present invention has a repeating unit other than repeating units represented by the formulae (1-1), (1-2), and (1-3) can be produced by polymerization in the presence of a compound with two substituents involved in polymerization to form a repeating unit other than repeating units represented by formulae (1-1), (1-2), and (1-3).

Besides a compound represented by the formulae (16-1), (16-2), or (16-3), a compound represented by any one of the formulae (19) to (22) can be used as a material. 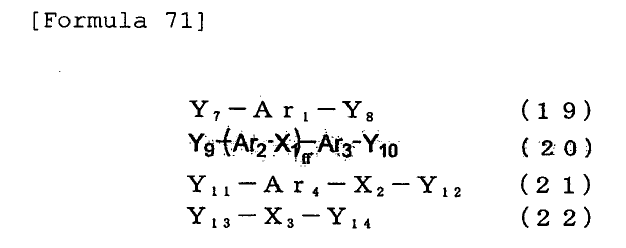 In the formulae, Ar₁, Ar₂, Ar₃, Ar₄, ff, X₁, X₂, and X₃ are the same as above. Y₇, Y₈, Y₉, Y₁₀, Y₁₁, Y₁₂, Y₁₃, and Y₁₄ independently represent polymerizable substituents.
A polymer compound can be produced having a unit represented by the formula (1-1), (1-2), or (1-3), and, in the order presented, one or more units represented by the formula (5), (6), (7), or (8).

Examples of the compound with two substituents involved in polymerization corresponding to the formula (15) to form a repeating unit other than repeating units represented by formulae (1-1), (1-2), and (1-3) may include compounds represented by the following formula (15-7). 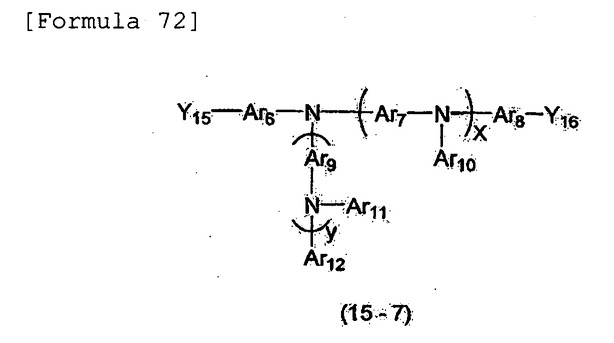 In the formulae, Ar₆, Ar₇, Ar₈, Ar₉, Ar₁₀, Ar₁₁, Ar₁₂, x, and y are the same as above. Y₁₅ and Y₁₆ independently represent substituents involved in polymerization.
More preferably, the examples may include compounds represented by the following formula (15-8) or (15-9). 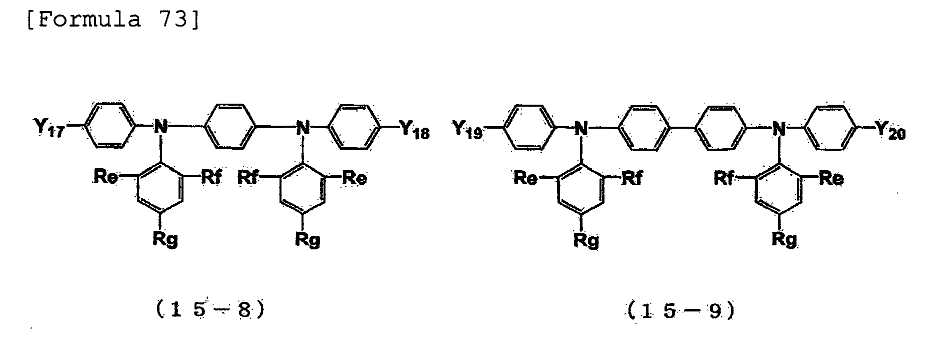 In the formulae, Re to Rg are the same as above. Y₁₇, Y₁₈, Y₁₉, and Y₂₀ independently represent substituents involved in polymerization.

Next, there is described a method of producing the polymer (A) according to the present invention.
Specifically, the polymer (A) according to the present invention can be produced by dissolving a compound, to be a monomer, having a plurality of substituents to be involved in condensation polymerization in an organic solvent according to necessity, and polymerizing the compound with alkali or an appropriate catalyst, at a temperature of the melting point or above and the boiling point or below of the organic solvent.
For example, known methods which can be used are described in: "Organic Reactions", Volume 14, page 270-490, John Wiley & Sons, Inc., 1965; "Organic Syntheses", Collective Volume VI, page 407-411, John Wiley & Sons, Inc., 1988; Chemical Review (Chem. Rev.), Volume 95, page 2457 (1995); Journal of Organometallic Chemistry (J. Organomet. Chem.), Volume 576, page 147 (1999); and Macromolecular Chemistry, Macromolecular Symposium (Makromol. Chem., Macromol. Symp.), Volume 12, page 229 (1987).

In the production method of the polymer (A) according to the present invention, polymerization is conducted by known polymerization reactions according to substituents involved in polymerization of compounds represented by the formulae (16-1) to (16-3), and (22) to (25).
The polymer compound according to the present invention is produced by polymerization, in the case of forming a double bond, for example, by methods described in JP-A-05-202355. That is, the methods include a polymerization by Wittig reaction of a compound having a formyl group and a compound having a phosphonium-methyl group, or a compound having a formyl group and a phosphonium-methyl group; polymerization by Heck reaction of a compound having a vinyl group and a compound having a halogen atom; polymerization by dehydrohalogenation method of a compound having two or more methyl monohalide groups; polymerization by sulfonium-salt decomposition method of a compound having two or more sulfonium-methyl groups; polymerization by Knoevenagel reaction of a compound having a formyl group and a compound having a cyano group; and polymerization by McMurry reaction of a compound having two or more formyl groups.
When the polymer compound according to the present invention having a triple bond in the backbone chain is produced by polymerization, for example, Heck reaction or Sonogashira reaction can be used.

When the polymer according to the present invention without a double bond or a triple bond is produced, for example, by polymerization of applicable monomers by the Suzuki coupling reaction; polymerization of applicable monomers by the Grignard reaction; polymerization of applicable monomers using a Ni (0) complex; polymerization of applicable monomers using an oxidant such as FeCl₃; electrochemical oxidative polymerization of applicable monomers; and decomposition of an intermediate polymer having an appropriate leaving group.

Among the methods, preferred are the polymerization by Wittig reaction, polymerization by Heck reaction, polymerization by Knoevenagel reaction, polymerization by Suzuki coupling reaction, polymerization by Grignard reaction, and polymerization which uses a zerovalent nickel complex because of ease of structural control.

Among production methods according to the present invention, when one compound selected from compounds represented by the formulae (16-1), (16-2), (16-3), (17-1), (17-2), (17-3), (18-1), (18-2), (18-3), and (18-4) is polymerized alone or with at least one compound selected from compounds represented by the formulae (19) to (22), condensation polymerization is preferably conducted in the presence of a zerovalent nickel complex where each of Y₁, Y₂, Y₃, Y₄, Y₅, Y₆, Y₇, Y₈, Y₉, Y₁₀, Y₁₁, Y₁₂, Y₁₃, Y₁₄, Y₁₅, Y₁₆, Y₁₇, Y₁₈, Y₁₉, and Y₂₀ independently represents a halogen atom, an alkylsulfonate group, an arylsulfonate group, or an arylalkylsulfonate group.
In this case, examples of raw material compounds may include: dihalogen compounds, bis(alkylsulfonate) compounds, bis(arylsulfonate) compounds, bis(arylalkylsulfonate) compounds, halogen-alkylsulfonate compounds, halogen-arylsulfonate compounds, halogen-arylalkylsulfonate compounds, alkylsulfonate-arylsulfonate compounds, alkylsulfonate-arylalkylsulfonate compounds and arylsulfonate-arylalkylsulfonate compounds.

Among production methods according to the present invention, when one compound selected from compounds represented by the formulae (16-1), (16-2), (16-3), (17-1), (17-2), (17-3), (18-1), (18-2), (18-3), and (18-4) is polymerized alone or with at least one compound selected from compounds represented by the formulae (19) to (22), condensation polymerization is preferably conducted where each of Y₁, Y₂, Y₃, Y₄, Y₅, Y₆, Y₇, Y₈, Y₉, Y₁₀, Y₁₁, Y₁₂, Y₁₃, Y₁₄, Y₁₅, Y₁₆, Y₁₇, Y₁₈, Y₁₉, and Y₂₀ independently represents a halogen atom, an alkylsulfonate group, an arylsulfonate group, an arylalkylsulfonate group, -B(OH)₂, or a boric acid ester group; the ratio of the total mole number of the halogen atom, alkylsulfonate group, arylsulfonate group, and arylalkylsulfonate group to the total mole number of -B(OH)₂ and the boric acid ester group is substantially 1 (generally K/J is in the range of 0.7 to 1.2); and a nickel or palladium catalyst is used.
In this case, specific examples of combination of raw material compounds may include: combinations of a dihalogen compound, a bis(alkylsulfonate) compound, a bis(arylsulfonate) compound, or a bis(arylalkylsulfonate) compound, and a diboric acid compound or a diboric acid ester compound.
The examples may also include: halogen-boric acid compounds, halogen-boric acid ester compounds, alkylsulfonate-boric acid compounds, alkylsulfonate-boric acid ester compounds, arylsulfonate-boric acid compounds, arylsulfonate-boric acid ester compounds, arylalkylsulfonate-boric acid compounds, arylalkylsulfonate-boric acid compounds, and arylalkylsulfonate-boric acid ester compounds.

Generally, it is preferred that an organic solvent is fully subjected to a deoxygenation treatment and the reaction proceeds in an inert atmosphere to suppress side reactions, though which depends on compounds and reaction to be used. It is also preferable to subject the solvent used to a dehydration treatment. However, this does not necessarily apply to reactions in a two-phase system: a solvent-water system, such as the Suzuki coupling reaction.

Examples of solvents may include: saturated hydrocarbons such as pentane, hexane, heptane, octane, and cyclohexane; unsaturated hydrocarbons such as benzene, toluene, ethylbenzene, and xylene; saturated halogenated hydrocarbons such as carbon tetrachloride, chloroform, dichloromethane, chlorobutane, bromobutane, chloropentane, bromopentane, chlorohexane, bromohexane, chlorocyclohexane, and bromocyclohexane; unsaturated halogenated hydrocarbons such as chlorobenzene, dichlorobenzene, and trichlorobenzene; alcohols such as methanol, ethanol, propanol, isopropanol, butanol, and t-butylalcohol; carboxylic acids such as formic acid, acetic acid, and propionic acid; ethers such as dimethyl ether, diethyl ether, methyl-t-butylether, tetrahydrofuran, tetrahydropyran, and dioxane; amines such as trimethylamine, triethylamine, N,N,N',N'-tetramethylethylenediamine, and pyridine; and amides such as N,N-dimethylformamide, N,N-dimethylacetoamide, N,N-diethylacetoamide, and N-methylmorpholine oxide. Any single solvent or mixed solvent of two or more selected from these solvents can be used. Among the solvents, ethers are preferable, and tetrahydrofuran and diethyl ether are more preferable.

To allow the polymerization reaction to progress, an alkali or an appropriate catalyst may also be added. Such an alkali or catalyst can be selected depending on the type of the reaction. It is preferred that the alkali or catalyst is preferably fully dissolved in a solvent to be used in the reaction. Examples of methods for mixing an alkali or a catalyst with a reaction solution may include: a method in which a solution of the alkali or catalyst is slowly added to the reaction solution with stirring in an inert atmosphere such as argon or nitrogen, and, conversely, a method in which the reaction solution is slowly added to the solution of the alkali or catalyst.

When a polymer compound according to the present invention is used for a polymer LED, or the like, it is preferable to purify monomers to be used by methods such as distillation, sublimation, or recrystallization prior to polymerization, because the purity of the polymer affects device properties such as light emitting properties. After polymerization, the polymer is preferably subjected to a purifying treatment such as purification by reprecipitation and separation by chromatography.

Compounds represented by the formulae (16-1) to (16-3), (17-1) to (17-3), and (18-1) to (18-4), which are useful as materials for polymer compounds according to the present invention, can be obtained by brominating compounds with structures where Y₁ to Y₆ in the formulae are replaced with hydrogen atoms.

Compounds with structures represented by the formula (18-1) can also be obtained by hydrogenating compounds with structures represented by the formulae (18-2) to (18-4) with a catalyst where a noble metal such as palladium, platinum, rhodium, ruthenium, or mixture thereof is held on activated carbon.

Conversely, compounds with structures represented by the formulae (18-2) to (18-4) can also be obtained by oxidizing compounds with structures represented by the formula (18-1) with 2,3-dichloro-5,6-dicyano-1,4-benzoquinone (DDQ), or with tetrabutylammonium bromide under a basic condition.

A polymer according to the present invention may be a random, block or graft copolymer. Alternatively, the polymer may be a polymer having a mixed structure of random, block and graft copolymers such as a random copolymer with characteristics of a block copolymer. From the viewpoint of obtaining a polymer light emitting body that exhibits fluorescence or phosphorescence in high quantum yields, preferred are a random copolymer with characteristics of a block copolymer, and a block or graft copolymer compared to a perfect random copolymer. A polymer according to the present invention may include: polymers having a branched backbone chain/chains and 3 or more terminals; and dendrimers.

The end groups of the polymer (A) of the present invention may be protected with a stable group because remaining of polymerization active groups can result in degradation of light emitting properties and decrease of life in a device produced with the polymer. The protective groups preferably have a conjugated bond continuous with the conjugated structure of the backbone chain of the polymer, for example, structures combining the protective groups with an aryl or heterocyclic group via a carbon-carbon bond. Specific examples of such groups include substituents described in Formula 10 in JP-A-09-45478.

In the polymer according to the present invention, at least one of molecular chain ends thereof is preferably an aromatic end group selected from monovalent heterocyclic groups, monovalent aromatic amine groups, monovalent groups derived from heterocyclic group coordinated metal complexes, and aryl groups having a formula weight of 90 or more. The aromatic end group may be a single type or two or more types. The content of the end groups other than the aromatic end group is preferably 30% or less, more preferably 20% or less, still preferably 10% or less, and most preferably substantially non-existent, based on all end groups in view of fluorescence properties and device properties. Herein, the molecular chain end means: an aromatic end group present at the end of a polymer by the production method of the present invention; a leaving group of a monomer used for polymerization which group remains without leaving at the end of a polymer during polymerization; and a proton which is bonded with a monomer present at the end of a polymer instead of an aromatic end group where a leaving group of the monomer left. When a monomer having a leaving group such as a halogen atom is used as a material for producing a polymer according to the present invention which group remains without leaving at the end of the polymer during polymerization, the leaving group of the monomer preferably does not substantially remain at the end of the polymer because remaining of halogen at polymer end tends to result in degradation of fluorescence properties and the like.

By sealing at least one of the molecular chain ends of a polymer with an aromatic end group selected from monovalent heterocyclic groups, monovalent aromatic amine groups, monovalent groups derived from heterocyclic group coordinated metal complexes, and aryl groups having a formula weight of 90 or more, the polymer is expected to gain various properties. Examples of the properties may include: an effect of increasing time required for the luminance decrease of a device; an effect of enhancing charge injection properties, charge transport properties, light emitting efficiency, and the like; an effect of enhancing the compatibility and interaction between copolymers; and an anchor-like effect.

Examples of the monovalent aromatic amine groups may include a structure where one of the two valence bonds of the structure represented by the formula (15) is sealed with R.

Examples of the monovalent groups derived from heterocyclic group coordinated metal complexes may include a structure where one of the two valence bonds of the divalent metal complex structures is sealed with R.

Among the aromatic end groups of a polymer according to the present invention, the aryl group having a formula weight of 90 or more typically have about 6 to 60 carbon atoms. The formula weight of the aryl group means the sum of the products of multiplying the atomic weight by the number of atoms as for each of the atoms in the chemical formula of the aryl group.

Examples of the aryl group may include: a phenyl group, a naphthyl group, an anthracenyl group, groups having a fluorene structure, and condensed ring compound groups.

Examples of the phenyl group for sealing the end of the polymer may include:

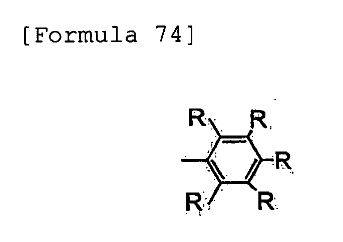

Examples of the naphthyl group for sealing the end of the polymer may include:

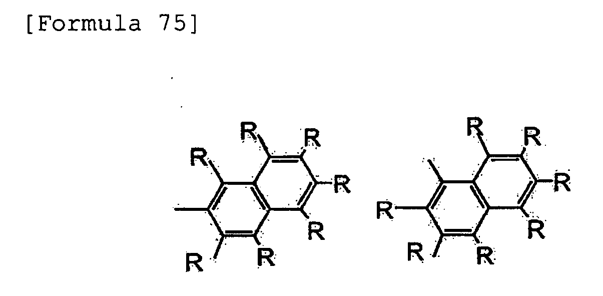

Examples of the anthracenyl group may include:

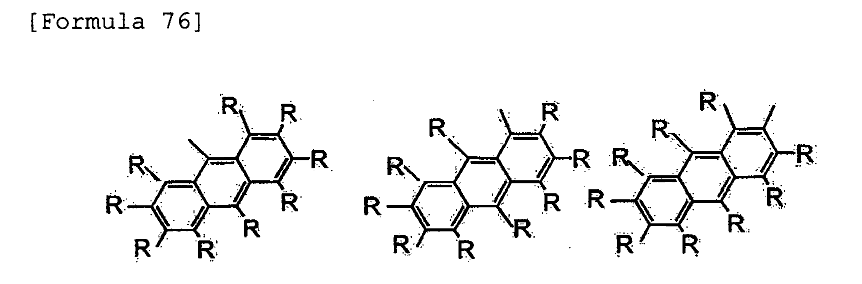

Examples of the groups having a fluorene structure may include:

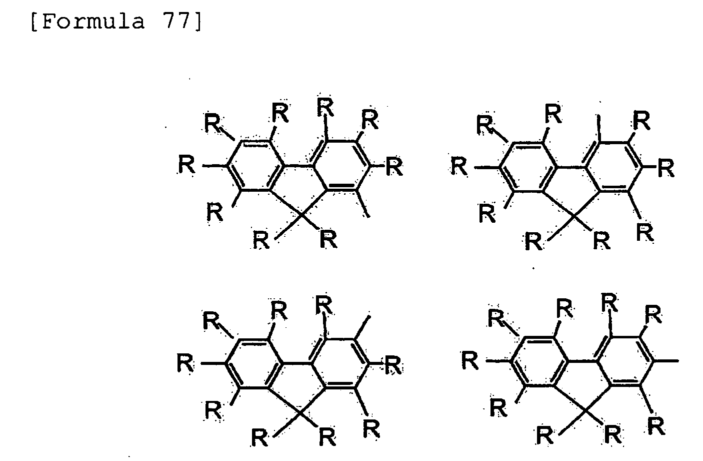

Examples of the condensed ring compound groups may include:

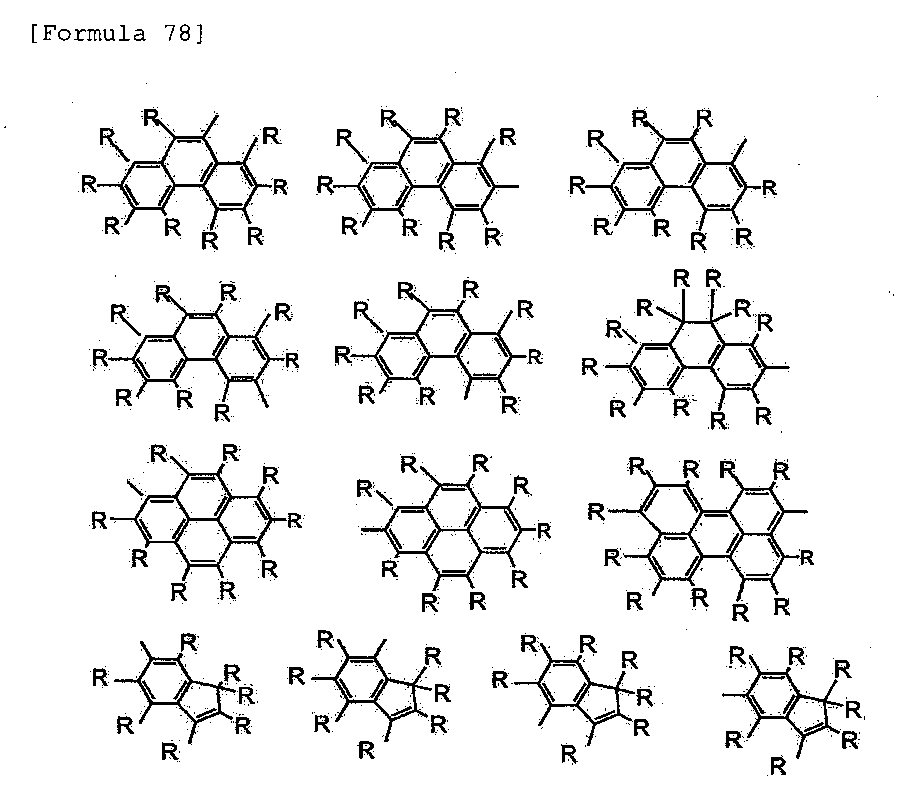

End groups that enhance charge injection properties and charge transport properties are preferably monovalent heterocyclic groups, monovalent aromatic amine groups, and condensed ring compound groups, and more preferably monovalent heterocyclic groups, and condensed ring compound groups.

End groups that enhance light emitting properties are preferably a naphthyl group, an anthracenyl group, condensed ring compound groups, and monovalent groups derived from heterocyclic group coordinated metal complexes.

End groups that increase time required for the luminance decrease of a device are preferably aryl groups having a substituent/substituents such as phenyl groups having 1 to 3 alkyl groups.

End groups that enhance the compatibility and interaction between polymer compounds are preferably aryl groups having a substituent/substituents. By using a phenyl group substituted with an alkyl group having 6 or more carbon atoms, an anchor-like effect can be provided. The anchor effect means an effect with which an end group plays an anchor-like role on an aggregate of a polymer to enhance interaction.

Preferred examples of a group that enhances device properties include the following structures. 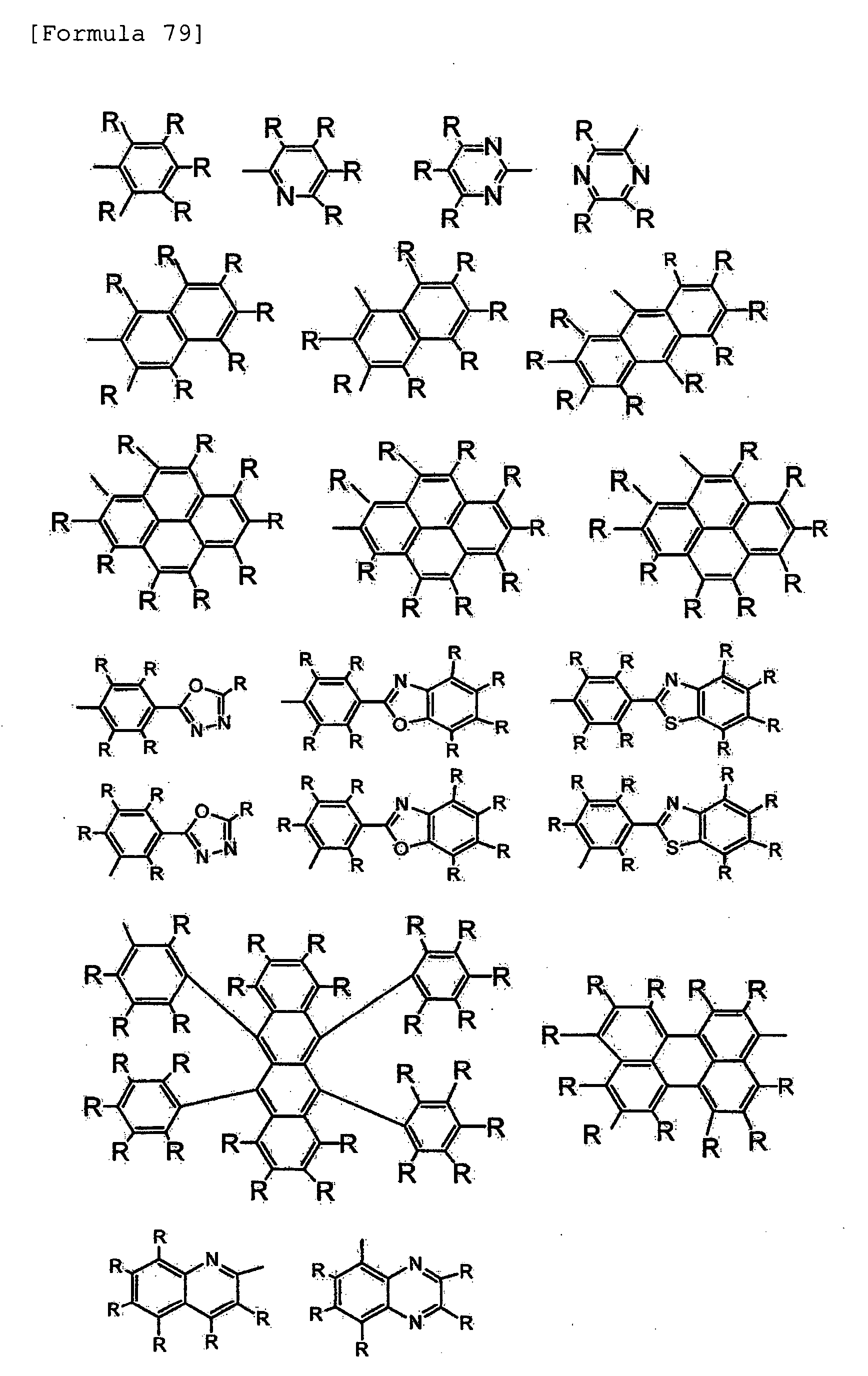 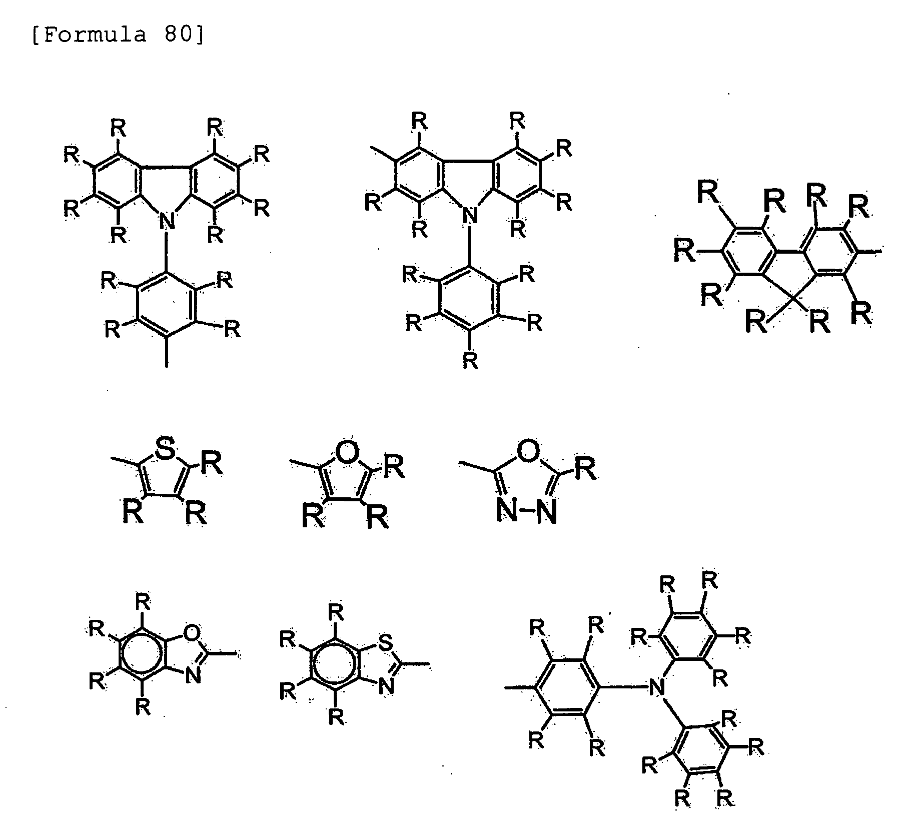 In the formulae, examples of R include R mentioned above.

The number average molecular weight, in terms of polystyrene, of a polymer compound according to the present invention is typically about 10³ to 10⁸, and preferably 10⁴ to 10⁶. The weight average molecular weight, in terms of polystyrene, of the polymer is about 10³ to 10⁸, and preferably 10⁴ to 5x10⁶.

Hereinafter, there is described a molecule (B) exhibiting fluorescence or phosphorescence in the visible range and a structure of the (B) in a polymer material according to the present invention.
Examples of the molecule exhibiting fluorescence in the visible range includes low-molecular-weight fluorescent materials such as naphthalene derivatives; anthracene and derivatives thereof; perylene and derivatives thereof; dyes such as polymethine dyes, xanthene dyes, coumarin dyes and cyanine dyes; metal complexes of 8-hydroxyquinoline and derivatives thereof; aromatic amines; tetraphenylcyclopentadiene and derivatives thereof; and tetraphenylbutadiene and derivatives thereof.
Specific examples of the materials may include well-known materials such as those described in JP-A-57-51781 and JP-A-59-194393.
Examples of the molecule showing phosphorescence in the visible range include metal complexes whose central metals are transition metals or lanthanoids. The molecule (B) or the structure (B) is preferably a metal complex where the metal complex has a central metal which is any one of W, Re, Os, Ir, Pt, Au, Ru, Rh, Pd, Ag, Ni, Cu, and Zn; at least one atom coordinated with the metal is a carbon atom; and all ligands are aromatic rings including substituents.
The molecule (B) or the structure (B) is preferably a metal complex including at least one ligand with any one of the following moieties. 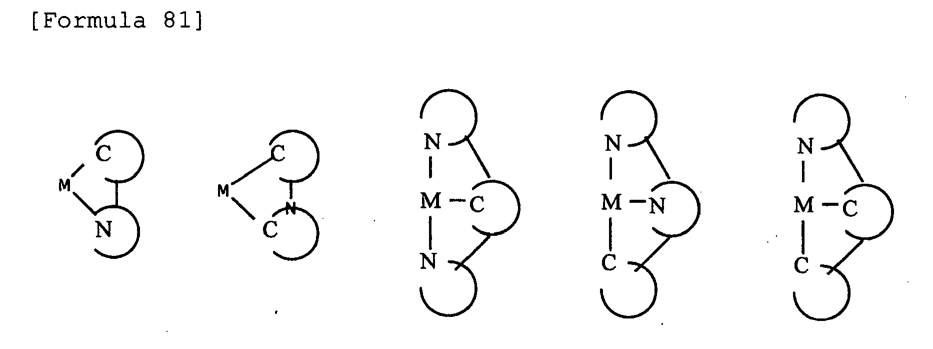 In the formulae, M represents a central metal; and each of the rings represents a 5-membered or 6-membered ring that may optionally have a substituent, or a condensed ring including the 5-membered or 6-membered ring. Hereinafter, there are described molecules showing phosphorescence.

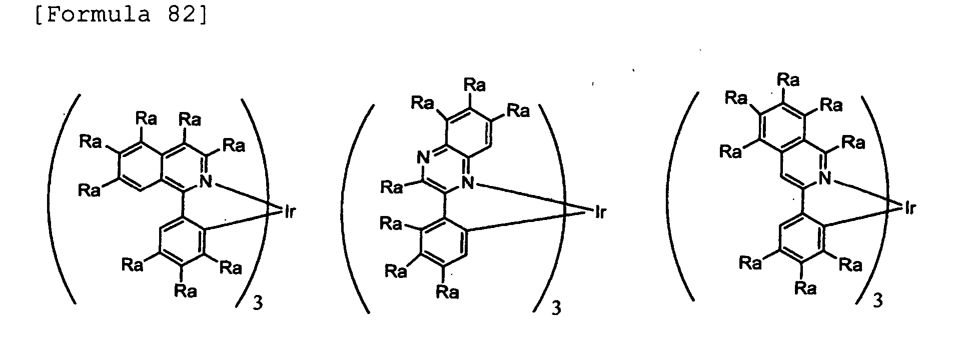

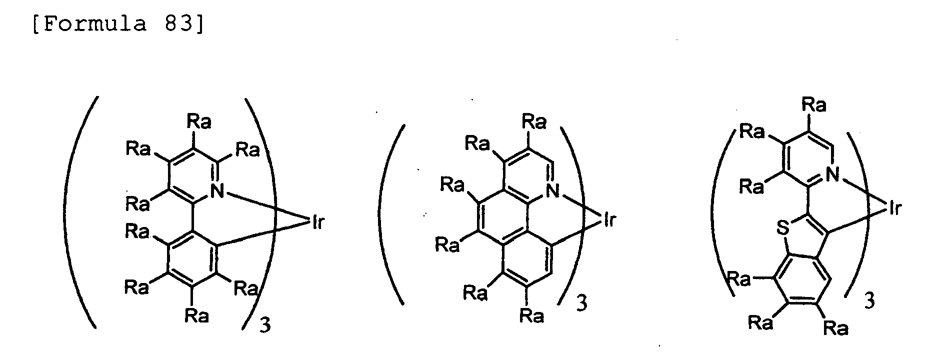

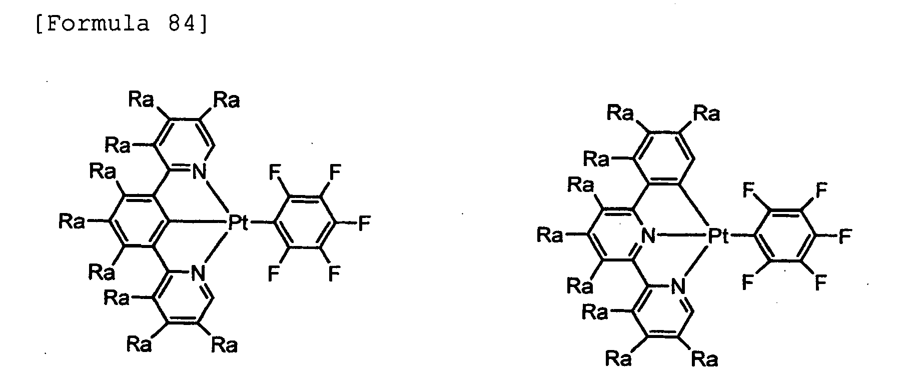

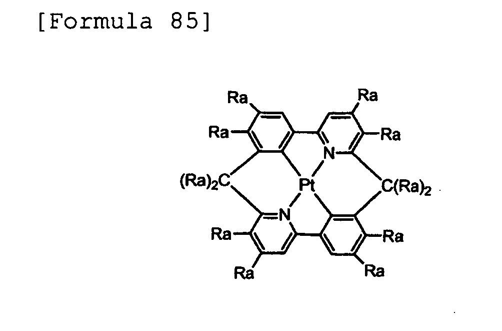

In the above compounds, Ra represents an alkyl group which may be partly substituted with a fluorine atom/atoms; an arylene group which may have a substituent/substituents; or a halogen group. A plurality of Ra in a single compound may be the same or different.
Besides those mentioned above, examples of the molecules may include known molecules described in Nature (1998), 395, 151; Appl. Phys. Lett. (1999), 75(1), 4; Proc. SPIE-Int. Soc. Opt. Eng. (2001), 4105 (Organic Light-Emitting Materials and Devices IV), 119; J. Am. Chem. Soc., (2001), 123, 4304; Appl. Phys. Lett., (1997), 71(18), 2596; Syn. Met., (1998), 94(1), 103; Syn. Met., (1999), 99(2), 1361; Adv. Mater., (1999), 11(10), 852; Jpn. J. Appl. Phys., 34, 1883 (1995); WO 0141512; WO 03033617; 04-2 Organic EL Workshop (Yuuki EL Kenkyukai) Proceedings (2004); WO 2005/103195A1; Documents of the First Workshop, p. 64 (on June 16th, 2004), of Section C of the 142nd Committee on Organic Material for Information Science; and Documents of Joint Workshop, p. 17 to 26, of EL Subcommittee (30th) of the 125th Committee on Optoelectronic and Section C (Organic Optoelectronics) (10th) of the 142nd Committee on Organic Material for Information Science.
The structure of the molecule (B) exhibiting fluorescence or phosphorescence in the visible range means the chemical structure of a molecule exhibiting fluorescence or phosphorescence in the visible range.
The structure of the molecule (B) exhibiting fluorescence or phosphorescence in the visible range may be included in the molecular structure of the polymer (A) of the present invention, or the molecule (B) as well as the polymer (A) may be included in a composition as components. Embodiments of a polymer material according to the present invention may include:
(1) a polymer material, which is a composition comprising the polymer (A) and the molecule (B) exhibiting fluorescence or phosphorescence in the visible range; and
(2) a polymer material including a polymer including the structure of the polymer (A) and the structure of the molecule (B) exhibiting fluorescence or phosphorescence in the visible range intramolecularly.
   Examples of (2) may include: a polymer material containing a polymer where a backbone chain of the polymer (A) includes the structure of the molecule (B) exhibiting fluorescence or phosphorescence in the visible range; a polymer material containing a polymer where the polymer (A) includes the structure of the molecule (B) at an end of the polymer (A) which molecule (B) exhibits fluorescence or phosphorescence in the visible range; and a polymer material containing a polymer where a side chain of the polymer (A) includes the structure of the molecule (B) exhibiting fluorescence or phosphorescence in the visible range.
   The amounts of the polymer (A) and the molecule (B) exhibiting fluorescence or phosphorescence in the visible range in (1), and the amounts of the structure of the polymer (A) and the structure of the molecule (B) exhibiting fluorescence or phosphorescence in the visible range are not particularly restricted because the amounts vary depending on the types of the polymer (A) used in combination and properties intended to adjust optimally. But, when the amount of the polymer (A) or the structure of the (A) is 100 parts by weight, the amount of the molecule (B) exhibiting fluorescence or phosphorescence in the visible range or the structure of the (B) is typically 0.01 to 80 parts by weight, preferably 0.1 to 60 parts by weight.

Examples of the polymer in the embodiment (2) may include a polymer that includes a moiety represented by the general formula (1); has a number average molecular weight, in terms of polystyrene, of 10³ to 10⁸ ; and has a phosphorescent light emitting material at a side chain, a backbone chain, and/or an end of the polymer.

A polymer structure where a side chain of the polymer (A) includes the structure of the molecule (B) exhibiting fluorescence or phosphorescence in the visible range is represented, for example, by the following formula. 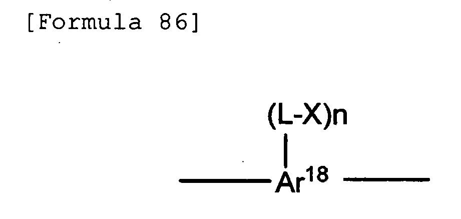 In the formula, Ar¹⁸ represents a divalent aromatic group, or a divalent heterocyclic group having one or more atoms selected from the group consisting of an oxygen atom, a silicon atom, a germanium atom, a tin atom, a phosphorus atom, a boron atom, a sulfur atom, a selenium atom, and a tellurium atom; the Ar¹⁸ has one or more and four or less groups represented by -L-X; X represents a monovalent group that emits light in the condition of triple excitation; L represents a single bond, -O-, -S-, -CO-, -CO₂-, -SO-, -SO₂-, -SiR⁶⁸R⁶⁹-, NR⁷⁰-, -BR⁷¹-, -PR⁷²-, -P(=O)(R⁷³)-, an alkylene group that may optionally be substituted, an alkenylene group that may optionally be substituted, an alkynylene group that may optionally be substituted, an arylene group that may optionally be substituted, or an divalent heterocyclic group that may optionally be substituted, where in the case of a -CH₂- group/groups being included in the alkylene group, the alkenylene group, or the alkynylene group, one or more of the -CH₂- groups included in the alkylene group, one or more of the -CH₂-groups included in the alkenylene group, or one or more of the -CH₂- groups included in the alkynylene group may be substituted with a group selected from the group consisting of -O-, -S-, -CO-, -CO₂- -SO-, -SO₂-, - SiR⁷⁴R⁷⁵-, NR⁷⁶-, -BR⁷⁷-, -PR⁷⁸-, and -P(=O) (R⁷⁹)-; each of R⁶⁸, R⁶⁹, R⁷⁰, R⁷¹, R⁷², R⁷³, R⁷⁴, R⁷⁵, R⁷⁶, R⁷⁷, R⁷⁸, and R⁷⁹ independently represents a group selected from the group consisting of a hydrogen atom, an alkyl group, an aryl group, a monovalent heterocyclic group, and a cyano group; Ar¹⁸ may include, other than the group represented by -L-X, a substituent selected from the group consisting of an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, substituted an amino group, a silyl group, substituted a silyl group, a halogen atom, an acyl group, an acyloxy group, an imine residue, an amide group, an acid imide group, a monovalent heterocyclic group, a carboxyl group, substituted a carboxyl group, and a cyano group; n represents an integer of 1 to 4; when there is a plurality of Ar¹⁸, Ar¹⁸ may be the same or different.
Examples of the divalent aromatic group may include: phenylene, pyridinylene, pyrimidylene, naphthylene, and rings represented by the general formula (1).

A polymer structure where the backbone chain of the polymer (A) includes the structure of the molecule (B) exhibiting fluorescence or phosphorescence in the visible range is represented, for example, by the following formula. 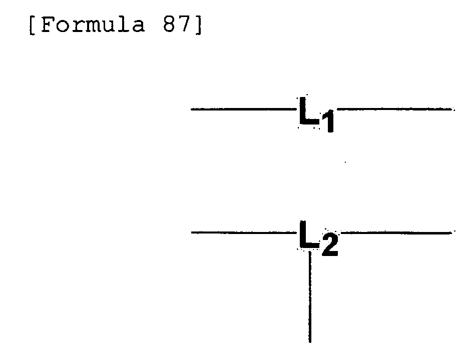 In the formulae, L₁ and L₂ represent structures of phosphorescent light emitting molecules. Divalent or trivalent bonding groups in the formulae are bonded to repeating units where the structure of the phosphorescent light emitting molecules forms a backbone chain of the polymer.

A polymer structure where the polymer (A) includes the structure of the molecule (B) at an end of the polymer (A) which molecule (B) exhibits fluorescence or phosphorescence in the visible range is represented, for example, by the following formula.

[Formula 88] -X-L₃

In the formula, L₃ represents a monovalent group including the structure of the phosphorescent compound (B); the phosphorescent compound (B) material has a monovalent bonding group, which is bonded to X; X represents a single bond, an alkenylene group that may optionally be substituted, an alkynylene group that may optionally be substituted, an arylene group that may optionally be substituted, or an divalent heterocyclic group that may optionally be substituted.

The polymer including the structure of the molecule (B) exhibiting fluorescence or phosphorescence in the visible range in a side chain, a backbone chain, or an end of the polymer can be produced, for example, by using a monomer having the structure of the (B) as one of the materials according to the methods mentioned above.

The polymer material according to the present invention may further comprise at least one material selected from hole transport materials and electron transport materials.
Examples of the hole transport materials may include: aromatic amines, carbazole derivatives, and poly(para-phenylene) derivatives, which have been used as hole transport materials for organic EL devices. Examples of the electron transport materials may include, likewise, materials that have been used as electron transport materials such as oxadiazole derivatives; anthraquinodimethane and derivatives thereof; benzoquinone and derivatives thereof; naphthoquinone and derivatives thereof; anthraquinone and derivatives thereof; tetracyanoanthraquinodimethane and derivatives thereof; fluorenone derivatives; diphenyldicyanoethylene and derivatives thereof; diphenoquinone derivatives; and metal complexes of 8-hydroxyquinoline and derivatives thereof.
When mixing the polymer material of the present invention and a hole transport material, the hole transport material mixed constitutes 1% by weight to 80% by weight and preferably 5% by weight to 60% by weight of the entire mixture. When mixing the polymer material of the present invention and an electron transport material, the electron transport material mixed constitutes 1% by weight to 80% by weight and preferably 5% by weight to 60% by weight of the entire mixture. When mixing the polymer material of the present invention, a hole transport material and/or an electron transport material, the polymer material of the present invention mixed constitutes 1% by weight to 50% by weight and preferably 5% by weight to 40% by weight of the entire mixture, the sum of the hole transport material and the electron transport material mixed constitutes 1% by weight to 50% by weight and preferably 5% by weight to 40% by weight of the entire mixture, and the content of the polymer material of the present invention is 99% by weight to 20% by weight.
As for the hole transport material and the electron transport material to be mixed, well-known low-molecular-weight compounds or polymer compounds, which are shown above, can be used, and the polymers are preferably used. Examples of the polymeric hole transport materials, electron transport materials, and light emitting materials include: polyfluorene and derivatives and copolymers thereof; polyarylene and derivatives and copolymers thereof; polyarylenevinylene and derivatives and copolymers thereof; and (co)polymers of aromatic amines and their derivatives, which are disclosed in, for example, WO 99/13692, WO 99/48160, GB2340304A, WO 00/53656, WO 01/19834, WO 00/55927, GB2348316, WO 00/46321, WO 00/06665, WO 99/54943, WO 99/54385, U.S. Patent No. 5,777,070, WO 98/06773, WO 97/05184, WO 00/35987, WO 00/53655, WO 01/34722, WO 99/24526, WO 00/22027, WO 00/22026, WO 98/27136, U.S. Patent No. 5,736,36, WO 98/21262, U.S. Patent No. 5,741,921, WO 97/09394, WO 96/29356, WO 96/10617, EP0707020, WO 95/07955, JP-A-2001-181618, JP-A-2001-123156, JP-A-2001-3045, JP-A-2000-351967, JP-A-2000-303066, JP-A-2000-299189, JP-A-2000-252065, JP-A-2000-136379, JP-A-2000-104057, JP-A-2000-80167, JP-A-10-324870, JP-A-10-114891, JP-A-09-111233, and JP-A-09-45478.

Hereinafter, there is described a liquid composition according to the present invention.
A polymer material according to the present invention, particularly as a liquid composition, is useful for producing light emitting devices such as polymer light emitting devices. The liquid composition is a polymer material (a composition and a polymer) according to the present invention that includes a solvent as necessary. In the present specification, the term "liquid composition" means a composition in the liquid state when a device is produced, typically, a composition in the liquid state at normal pressure (that is, 1 atmospheric pressure) and at 25°C. The liquid composition is generally referred to as ink, an ink composition, a solution, or the like.

The liquid composition is advantageous in producing a polymer light emitting device because a film can be formed by applying the liquid composition (for example, the composition in a solution state) and subsequently drying the applied composition to remove the solvent. Also, similar procedures can be used in the case of mixing charge transport materials or light emitting materials with the liquid composition. The drying may be conducted by heating the applied composition to about 50°C to 150°C or by reducing pressure to about 10⁻³ Pa.

Examples of a method of forming films using the liquid composition may include: coating methods such as a spin coating method, casting method, micro gravure coating method, gravure coating method, bar coating method, roll coating method, wire bar coating method, dip coating method, spray coating method, screen printing method, flexo printing method, offset printing method, and inkjet printing method.

The ratio of a solvent in the liquid composition is typically 1% by weight to 99.9% by weight, preferably 60% by weight to 99.9% by weight, and more preferably 90% by weight to 99.8% by weight, based on the total weight of the liquid composition. The viscosity of the liquid composition varies depending on a printing method to be used, but preferably in the range of 0.5 to 500 mPa·s at 25°C. When a printing method such as inkjet printing method where the liquid composition passes through a discharging apparatus is used, the liquid composition preferably has a viscosity in the range of 0.5 to 20 mPa·s at 25°C to prevent clogging or bend flying on discharge. The sum of the weight of a polymer including a repeating unit represented by the formula (1-1) or (1-2) and the weight of a compound that emits phosphorescence, or the weight of the polymer compound is typically 20% by weight to 100% by weight, preferably 40% by weight to 100% by weight, based on the total weight of the whole components in the liquid composition except for the solvent.

A solvent contained in the liquid composition preferably dissolve or disperse components of the liquid composition other than the solvent. Examples of the solvent may include: chlorine solvents such as chloroform, methylene chloride, 1,2-dichloroethane, 1,1,2-trichloroethane, chlorobenzene, and o-dichlorobenzene; ether solvents such as tetrahydrofuran, and dioxane; aromatic hydrocarbon solvents such as toluene, xylene, trimethylbenzene, and mesitylene; aliphatic hydrocarbon solvents such as cyclohexane, methylcyclohexane, n-pentane, n-hexane, n-heptane, n-octane, n-nonane, and n-decane; ketone solvents such as acetone, methyl ethyl ketone, and cyclohexanone; ester solvents such as ethyl acetate, butyl acetate, methyl benzoate, and ethyl cellosolve acetate; polyhydric alcohol and derivatives thereof such as ethylene glycol, ethylene glycol monobutyl ether, ethylene glycol monoethyl ether, ethylene glycol monomethyl ether, dimethoxy-ethane, propylene glycol, diethoxy-methane, triethylene glycol monoethyl ether, glycerin, and 1,2-hexanediol; alcohol solvents such as methanol, ethanol, propanol, isopropanol, and cyclohexanol; sulfoxide solvents such as dimethyl sulfoxide; and amide solvents such as N-methyl-2-pyrrolidone, and N,N-dimethylformamide. These solvents may be used alone or plurality of these solvents may be in combination. Among the solvents, one or more organic solvents are preferably included in the liquid composition which solvents have a structure with one or more benzene rings and have a melting point of 0°C or below, and a boiling point of 100°C or above in view of viscosity, film forming properties, and the like.

The types of the solvent are preferably aromatic hydrocarbon solvents, aliphatic hydrocarbon solvents, ester solvents, and ketone solvents in view of solubility, in an organic solvent, of components in the liquid composition other than the solvent, uniformity in forming films, viscosity properties, and the like. Preferred solvents are toluene, xylene, ethylbenzene, diethylbenzene, trimethylbenzene, mesitylene, n-propyl benzene, i-propyl benzene, n-butylbenzene, i-butylbenzene, s-butylbenzene, anisole, ethoxybenzene, 1-methylnaphthalene, cyclohexane, cyclohexanone, cyclohexylbenzene, bicyclohexyl, cyclohexenylcyclohexanone, n-heptylcyclohexanone, n-hexylcyclohexanone, methyl benzoate, 2-propylcyclohexanone, 2-heptanone, 3-heptanone, 4-heptanone, 2-octanone, 2-nonanone, 2-decanone, and dicyclohexylketone. More preferably, the solvent includes at least one among xylene, anisole, mesitylene, cyclohexylbenzene, and bicyclohexyl methyl benzoate.

The solvent contained in the liquid composition are preferably two or more types, more preferably two or three types, and still more preferably two types in view of film forming properties, device properties, and the like.

When the liquid composition contains two types of solvents, one of the two solvents may be in the solid state at 25°C. In view of film forming properties, it is preferred that one solvent has a boiling point of 180°C or above and the other solvent has a boiling point of 180°C or below. More preferably, one solvent has a boiling point of 200°C or above and the other solvent has a boiling point of 180°C or below. In view of viscosity, 0.2% or more by weight of components of the liquid composition except for the solvents preferably dissolve in the solvents at 60°C. It is preferred that 0.2% or more by weight of components of the liquid composition except for the solvents dissolve in one solvent among the two solvents at 25°C.

When the liquid composition contains three types of solvents, one or two solvents among the three solvents may be in the solid state at 25°C. In view of film forming properties, it is preferred that at least one solvent among the three solvents has a boiling point of 180°C or above and at least one solvent has a boiling point of 180°C or below. More preferably, at least one solvent among the three solvents has a boiling point of 200°C or above and 300°C or below, and at least one solvent has a boiling point of 180°C or below. In view of viscosity, 0.2% or more by weight of components of the liquid composition except for the solvents preferably dissolve in two solvents among the three solvents at 60°C. It is preferred that 0.2% or more by weight of components of the liquid composition except for the solvents dissolve in one solvent among the three solvents at 25°C.

When the liquid composition contains two or more types of solvents, in view of viscosity and film forming properties, the liquid composition preferably contains a solvent with the highest boiling point in an amount of 40% to 90% by weight, more preferably 50% to 90% by weight, and still more preferably 65% to 85% by weight, based on the weight of the whole solvents contained in the liquid composition.

Preferred examples of solvents contained in the liquid composition may include, in view of viscosity and film forming properties, combination of anisole and bicyclohexyl; combination of anisole and cyclohexylbenzene; combination of xylene and bicyclohexyl; combination of xylene and cyclohexylbenzene; and combination of mesitylene and methyl benzoate.

The difference between the solubility parameter of a solvent and the solubility parameter of a polymer compound contained in a composition according to the present invention or a polymer according to the present invention is preferably 10 or less in view of solubility, in the solvent, of the components contained in the liquid composition except for the solvent. The solubility parameters can be determined by a method described in "Solvents Handbook (Youzai Handbook, published by Kodansha Ltd., 1976)".

Hereinafter, there is described use of a polymer material according to the present invention.
A polymer material according to the present invention typically exhibits fluorescence or phosphorescence in the solid state, and can be used as a polymeric luminous body (a high-molecular-weight light-emitting material).
The polymer material has an excellent charge transporting capability, and can be suitably used as a material for a polymer light emitting device or a charge transporting material. A polymer light emitting device using the polymer material is a high-performance polymer light emitting device that is operable through the application of low voltage and at high efficiency. Accordingly, such a polymer light emitting device can be suitably used for the backlight of liquid crystal displays, curved-planar or flat planar light sources for lighting, segment-type display devices, or apparatuses such as dot matrix flat panel displays.
A polymer material according to the present invention can also be used as a laser dye, a material for organic solar cells, an organic semiconductor for an organic transistor, a material for a conductive thin film such as a conductive thin film and an organic semiconductor thin film.
A polymer material according to the present invention can also be used as a material for light-emitting thin films that emit fluorescence or phosphorescence.

Hereinafter, a light emitting device according to the present invention will be described.
A light emitting device according to the present invention is characterized by having an organic layer between electrodes of an anode and a cathode which organic layer comprises a polymer material according to the present invention.
The organic layer may be a light emitting layer, a hole transport layer, an electron transport layer, or the like. But, the organic layer is preferably a light emitting layer.

The term "a light emitting layer" means a layer having the function of emitting light, the term "a hole transport layer" means a layer having the function of transporting holes, and the term "an electron transport layer" means a layer having the function of transporting electrons. The electron transport layer and the hole transport layer are collectively called a charge transport layer. The light emitting device may include independently two or more light emitting layers, two or more hole transport layers, and two or more electron transport layers.

When the organic layer is a light emitting layer, the light emitting layer as an organic layer may further include a hole transport material, and an electron transport material.

As for the film thickness of the light emitting layer in a polymer light emitting device according to the present invention, its optimum value varies depending on the material used, and therefore the thickness can be selected so that the values of the operational voltage and light emitting efficiency of the light emitting device become proper. For example, the thickness is 1 nm to 1 µm, preferably 2 nm to 500 nm, and more preferably 5 nm to 200 nm.

Use of a polymer material according to the present invention is advantageous in producing a polymer LED because a film can be formed only by applying a solution and subsequently drying the applied solution to remove the solvent. Also, similar procedures can be used in the case of mixing charge transport materials or light emitting materials with the solution. Examples of a method of forming films using a solution may include: coating methods such as a spin coating method, casting method, micro gravure coating method, gravure coating method, bar coating method, roll coating method, wire bar coating method, dip coating method, spray coating method, screen printing method, flexo printing method, offset printing method, and inkjet printing method.

Examples of a light emitting device according to the present invention may include: a light emitting device having an electron transport layer between a cathode and a light emitting layer; a light emitting device having a hole transport layer between an anode and a light emitting layer; and a light emitting device having an electron transport layer between a cathode and a light emitting layer, and having a hole transport layer between an anode and a light emitting layer.
The light emitting device may further have a charge transport layer and/or a charge block layer between the electrodes of an anode and a cathode.
Examples of the light emitting device may include: a polymer LED having an electron transport layer between a cathode and a light emitting layer; a polymer LED having a hole transport layer between an anode and a light emitting layer; a polymer LED having an electron transport layer between a cathode and a light emitting layer, and having a hole transport layer between an anode and a light emitting layer; and a polymer LED having a hole block layer between a light emitting layer and a cathode. The term "a light emitting layer" means a layer having the function of emitting light, the term "a hole transport layer" means a layer having the function of transporting holes, and the term "an electron transport layer" means a layer having the function of transporting electrons. The electron transport layer and the hole transport layer are collectively called a charge transport layer. The term "a charge block layer" means a layer having the function of trapping holes or electrons in a light emitting layer. A layer that transports electrons and traps holes is referred to as a hole block layer. A layer that transports holes and traps electrons is referred to as an electron block layer.
Examples of a light emitting device according to the present invention may also include: a polymer LED having a layer containing a conductive polymer adjacent to an electrode at least between one of the electrodes and a light emitting layer; and a polymer LED having a buffer layer with an average thickness of 2 nm or less adjacent to an electrode at least between one of the electrodes and a light emitting layer.

Specifically, examples of the polymer LED may include the following a) to e) structures.
a) anode/light emitting layer/cathode
b) anode/hole transport layer/light emitting layer/cathode
c) anode/light emitting layer/electron transport layer/cathode
d) anode/light emitting layer/hole block layer/cathode
e) anode/hole transport layer/light emitting layer/electron transport layer/cathode (The slash "/" indicates the layers are laminated adjacent to each other. This applies to "/" below.)

The light emitting device may include independently two or more light emitting layers, two or more hole transport layers, and two or more electron transport layers.

Examples of a light emitting device according to the present invention may also include a light emitting device where a hole transport layer and/or an electron transport layer contain a polymer material according to the present invention.
When a polymer material according to the present invention is used for a hole transport layer, the polymer material is preferably a polymer including a hole transport group. Examples of the polymer compound may include: a copolymer with an aromatic amine, and a copolymer with stilbene.
When a polymer material according to the present invention is used for an electron transport layer, the polymer material is preferably a polymer compound including an electron transport group. Examples of the polymer compound may include: a copolymer with oxadiazole, a copolymer with triazole, a copolymer with quinoline, a copolymer with quinoxaline, and a copolymer with benzothiadiazole.

When a light emitting device according to the present invention has a hole transport layer, examples of a hole transport material to be used may include: polyvinylcarbazole and derivatives thereof; polysilane and derivatives thereof; polysiloxane derivatives having aromatic amine on its side chain or backbone chain; pyrazoline derivatives; arylamine derivatives; stilbene derivatives; triphenyldiamine derivatives; polyaniline and derivatives thereof; polythiophene and derivatives thereof; polypyrrole and derivatives thereof; poly(p-phenylenevinylene) and derivatives thereof; and poly(2,5-thienylenevinylene) and derivatives thereof.

Specific examples of the hole transport materials include those described in JP-A-63-70257, JP-A-63-175860, JP-A-02-135359, JP-A-02-135361, JP-A-02-209988, JP-A-03-37992, and JP-A-03-152184.

Among the hole transport materials, preferred examples of a hole transport material to be used for hole transport layers may include polymer hole transport materials such as polyvinylcarbazole and derivatives thereof; polysilane and derivatives thereof; polysiloxane derivatives having an aromatic amine compound group on its side chain or backbone chain; polyaniline and derivatives thereof; polythiophene and derivatives thereof; poly(p-phenylenevinylene) and derivatives thereof; and poly(2,5-thienylenevinylene) and derivatives thereof. More preferred examples of a hole transport material may include: polyvinylcarbazole and derivatives thereof; polysilane and derivatives thereof; and polysiloxane derivatives having aromatic amine on its side chain or backbone chain.

Specific examples of hole transport materials with low molecular weight include pyrazoline derivatives, arylamine derivatives, stilbene derivatives, and triphenyldiamine derivatives. When a low-molecular-weight hole transport material is used, the material is preferably used in the state of being dispersed in a polymeric binder.

The polymeric binder to be mixed preferably does not extremely inhibit electron transport and binders suitably used do not have strong absorption of visible light. Examples of the polymeric binder may include: poly(N-vinylcarbazole); polyaniline and derivatives thereof; polythiophene and derivatives thereof; poly(p-phenylenevinylene) and derivatives thereof; poly(2,5-thienylenevinylene) and derivatives thereof; polycarbonate, polyacrylate, polymethylacrylate, polymethylmethacrylate, polystyrene, polyvinyl chloride, and polysiloxane.

Polyvinylcarbazole and derivatives thereof can be obtained, for example, from a vinyl monomer by cationic polymerization or radical polymerization.

Examples of polysilane and derivatives thereof may include compounds described in Chemical Review (Chem. Rev.) Vol. 89, page 1359 (1989) or GB Patent No. 2300196. As for methods for synthesizing such compounds, those described in the above documents can be used. In particular, Kipping method is preferably used.

As for polysiloxane and derivatives thereof, because a siloxane skeleton structure hardly transport holes, those having a structure of the above described low-molecular-weight hole transport material on their side chains or backbone chains are suitably used. In particular, examples of such polysiloxane and derivatives thereof include those having aromatic amine, which transport holes, on their side chains or backbone chains.

Film forming methods for the hole transport layer are not limited. When a low-molecular-weight hole transport material is used, for example, methods are used in which the film is formed by using a mixed solution of the material and a polymeric binder. When a polymer hole transport material is used, for example, methods are used in which the film is formed by using a solution of the material.

Solvents used in the methods for forming the film by using a solution may be any solvents as long as hole transport materials can be dissolved therein. Examples of such solvents may include chlorine solvents such as chloroform, methylene chloride and dichloroethane; ether solvents such as tetrahydrofuran; aromatic hydrocarbon solvents such as toluene and xylene; ketone solvents such as acetone and methyl ethyl ketone; and ester solvents such as ethyl acetate, butyl acetate and ethyl cellosolve acetate.

Examples of a method of forming films using a solution may include: coating methods such as a spin coating method, casting method, micro gravure coating method, gravure coating method, bar coating method, roll coating method, wire bar coating method, dip coating method, spray coating method, screen printing method, flexo printing method, offset printing method, and inkjet printing method.

The optimum value of the thickness of the hole transport layer varies depending on the material used, and therefore the thickness can be selected so that the values of the operational voltage and light emitting efficiency of the light emitting device become proper. The layer needs to have some thickness so that at least pinholes are not formed therein, but on the other hand, too thick layer is not preferable because the operational voltage of the device increases. Accordingly, the thickness of the hole transport layer is, for example, 1 nm to 1 µm, preferably 2 nm to 500 nm, and more preferably 5 nm to 200 nm.

When a polymer device according to the present invention has an electron transport layer, known compounds can be used as the electron transport materials. Examples of such compounds may include: oxadiazole derivatives; anthraquinodimethane and derivatives thereof; benzoquinone and derivatives thereof; naphthoquinone and derivatives thereof; anthraquinone and derivatives thereof; tetracyanoanthraquinodimethane and derivatives thereof; fluorenone derivatives; diphenyldicyanoethylene and derivatives thereof; diphenoquinone derivatives; metal complexes of 8-hydroxyquinoline and derivatives thereof; polyquinoline and derivatives thereof; polyquinoxaline and derivatives thereof; and polyfluorene and derivatives thereof.

Specific examples of the electron transport materials include those described in JP-A-63-70257, JP-A-63-175860, JP-A-02-135359, JP-A-02-135361, JP-A-02-209988, JP-A-03-37992 and JP-A-03-152184.

Among the electron transport materials, preferred are oxadiazole derivatives; benzoquinone and derivatives thereof; anthraquinone and derivatives thereof; metal complexes of 8-hydroxyquinoline and derivative thereof; polyquinoline and derivatives thereof; polyquinoxaline and derivatives thereof; and polyfluorene and derivatives thereof. More preferred are 2-(4-biphenylyl)-5-(4-t-butylphenyl)-1,3,4-oxadiazole, benzoquinone, anthraquinone, tris(8-quinolinol)aluminum, and polyquinoline.

Film forming methods for the electron transport layer are not particularly limited. When a low-molecular-weight electron transport material is used, for example, methods are used in which the film is formed by using a powder of the material by vacuum deposition or by using a solution of the material or the material in the molten state. When a polymer electron transport material is used, for example, methods are used in which the film is formed by using a solution of the material or the material in the molten state. When the film is formed by using a solution of a material or a material in the molten state, any one of the above described polymeric binders may be used together.

Solvents used in forming the film by using a solution may be any solvents as long as they can dissolve electron transport materials and/or polymeric binders. Examples of such solvents include chlorine solvents such as chloroform, methylene chloride and dichloroethane; ether solvents such as tetrahydrofuran; aromatic hydrocarbon solvents such as toluene and xylene; ketone solvents such as acetone and methyl ethyl ketone; and ester solvents such as ethyl acetate, butyl acetate and ethyl cellosolve acetate.

Examples of methods for forming the film by using a solution of the material or the material in the molten state may include: coating methods such as a spin coating method, casting method, micro gravure coating method, gravure coating method, bar coating method, roll coating method, wire bar coating method, dip coating method, spray coating method, screen printing method, flexo printing method, offset printing method, and inkjet printing method.

The optimum value of the thickness of the electron transport layer varies depending on the material used, and therefore it can be selected so that the values of the operational voltage and light emitting efficiency of the light emitting device become proper. However, the layer needs to have some thickness so that at least pinholes are not formed therein, but on the other hand, too thick layer is not preferable because the operational voltage of the device increases. Accordingly, the thickness of the electron transport layer is, for example, 1 nm to 1 µm, preferably 2 nm to 500 nm, and more preferably 5 nm to 200 nm.

Among the charge transport layers provided adjacent to electrodes, those having the function of improving the efficiency of charge injection from the electrodes and of reducing the operational voltage of the device are sometimes particularly referred to as a charge injection layers (hole injection layer, electron injection layer) in general.

To improve the adhesion to electrodes or to improve the charge injection from the electrodes, the above described charge injection layer or an insulating layer with a thickness of 2 nm or less may be provided adjacent to the electrode. To improve the adhesion between interfaces or to prevent intermixing between the interfaces, a thin buffer layer may be inserted in each interface of the electron transport layer and the light emitting layer.
The order, number and thickness of the layers laminated may be selected properly taking into consideration of the light emitting efficiency or life time of the device.

Examples of a light emitting device provided with a charge injection layer/layers (an electron injection layer/layers, a hole injection layer/layers) according to the present invention may include: a polymer LED provided with a charge injection layer adjacent to the cathode; and a polymer LED provided with a charge injection layer adjacent to the anode.
Specifically, examples of the polymer LED may include the following e) to p) structures.
e) anode/charge injection layer/light emitting layer/cathode
f) anode/light emitting layer/charge injection layer/cathode
g) anode/charge injection layer/light emitting layer/charge injection layer/cathode
h) anode/charge injection layer/hole transport layer/light emitting layer/cathode
i) anode/hole transport layer/light emitting layer/charge injection layer/cathode
j) anode/charge injection layer/hole transport layer/light emitting layer/charge injection layer/cathode
k) anode/charge injection layer/light emitting layer/electron transport layer/cathode
l) anode/light emitting layer/electron transport layer/charge injection layer/cathode
m) anode/charge injection layer/light emitting layer/electron transport layer/charge injection layer/cathode
n) anode/charge injection layer/hole transport layer/light emitting layer/electron transport layer/cathode
o) anode/hole transport layer/light emitting layer/electron transport layer/charge injection layer/cathode
p) anode/charge injection layer/hole transport layer/light emitting layer/electron transport layer/charge injection layer/cathode

Specific examples of the charge injection layers include: a layer that contains a conductive polymer; a layer that is provided between an anode and a hole transport layer and contains a material having an ionization potential between that of the anode material and that of the hole transport material contained in the hole transport layer; and a layer that is provided between a cathode and an electron transport layer and contains a material having an electron affinity between that of the cathode material and that of the electron transport material contained in the electron transport layer.

When the above described charge injection layer is a layer that contains a conductive polymer, the electric conductivity of the conductive polymer is preferably 10⁻⁵ S/cm or more and 10³ or less. To decrease the leak current among light emitting pixels, the electric conductivity is preferably 10⁻⁵ S/cm or more and 10² or less and more preferably 10⁻⁵ S/cm or more and 10¹ or less.

When the above described charge injection layer is a layer that contains a conductive polymer, the electric conductivity of the conductive polymer is preferably 10⁻⁵ S/cm or more and 10³ S/cm or less. To decrease the leak current among light emitting pixels, the electric conductivity is preferably 10⁻⁵ S/cm or more and 10² S/cm or less and more preferably 10⁻⁵ S/cm or more and 10¹ S/cm or less.
Typically, an appropriate amount of ion is doped into the conductive polymer to make the electric conductivity of the conductive polymer in 10⁻⁵ S/cm or more and 10³ or less.

The type of the ion doped is anion when the charge injection layer is a hole injection layer, while the type is cation when the charge injection layer is an electron injection layer. Examples of the anions include polystyrenesulfonic acid ion, alkylbenzenesulfonic acid ion and camphorsulfonic acid ion. Examples of the cations include lithium ion, sodium ion, potassium ion and tetrabutylammonium ion.
The thickness of the charge injection layer is, for example, 1 nm to 100 nm and preferably 2 nm to 50 nm.

The materials used for the charge injection layers can be properly selected taking into consideration of the materials of the electrodes and their adjacent layers. Examples of the materials for the charge injection layers include: conductive polymers such as polyaniline and derivatives thereof; polythiophene and derivatives thereof; polypyrrole and derivatives thereof; polyphenylenevinylene and derivatives thereof; polythienylenevinylene and derivatives thereof; polyquinoline and derivatives thereof; polyquinoxaline and derivatives thereof; and polymers having an aromatic amine structure on their backbone chains or side chains; metal phthalocyanine (copper phthalocyanine), and carbon.

The insulating layer with a thickness of 2 nm or less has the function of making charge injection easy. Examples of the materials for the insulating layer include metal fluorides, metal oxides and organic insulating materials. Examples of a polymer LED provided with an insulating layer with a thickness of 2 nm or less include: a polymer LED provided with an insulating layer with a thickness of 2 nm or less adjacent to the cathode; and a polymer LED provided with an insulating layer with a thickness of 2 nm or less adjacent to the anode.

Specifically, examples of the polymer LEDs may include the following q) to ab) structures.
q) anode/insulating layer with a thickness of 2 nm or less/light emitting layer/cathode
r) anode/light emitting layer/insulating layer with a thickness of 2 nm or less/cathode
s) anode/insulating layer with a thickness of 2 nm or less/light emitting layer/insulating layer with a thickness 2 nm or less/cathode
t) anode/insulating layer with a thickness of 2 nm or less/hole transport layer/light emitting layer/cathode u) anode/hole transport layer/light emitting layer/insulating layer with a thickness of 2 nm or less/cathode
v) anode/insulating layer with a thickness of 2 nm or less/hole transport layer/light emitting layer/insulating layer with a thickness of 2 nm or less/cathode
w) anode/insulating layer with a thickness of 2 nm or less/light emitting layer/electron transport layer/cathode
x) anode/light emitting layer/electron transport layer/insulating layer with a thickness of 2 nm or less/cathode
y) anode/insulating layer with a thickness of 2 nm or less/light emitting layer/electron transport layer/insulating layer with a thickness of 2 nm or less/cathode
z) anode/insulating layer with a thickness of 2 nm or less/hole transport layer/light emitting layer/electron transport layer/cathode
aa) anode/hole transport layer/light emitting layer/electron transport layer/insulating layer with a thickness of 2 nm or less/cathode
ab) anode/insulating layer with a thickness of 2 nm or less/hole transport layer/light emitting layer/electron transport layer/insulating layer with a thickness of 2 nm or less/cathode

A substrate that constitutes the polymer LED according to the present invention may be any substrate as long as the substrate does not alter when electrodes and organic layers are formed on it. Examples of such substrates include glass, plastic, polymeric film and silicon substrates. When the substrate is not transparent, the electrode opposite to the substrate is preferably transparent or semitransparent.

Typically, at least one of the anode and cathode of a polymer LED according to the present invention is transparent or semitransparent. The anode is preferably transparent or semitransparent.
As a material for the anode, a conductive metal oxide film, a semitransparent metal thin film or the like is used. Specifically, examples of the material may include: a film (NESA, or the like) formed by using a conductive glass comprising indium oxide, zinc oxide, tin oxide, and complexes thereof such as indium tin oxide (ITO) and indium zinc oxide; and gold, platinum, silver, and copper. Preferred materials are ITO, indium zinc oxide and tin oxide. Examples of methods for forming the anode include vacuum deposition, sputtering, ion plating, and plating. An organic transparent conductive film such as polyaniline or a derivative thereof, polythiophene or a derivative thereof may also be used as the anode.
The film thickness of the anode can be properly selected taking into consideration of the light transmittivity and the electrical conductivity. The film thickness is, for example, 10 nm to 10 µm, preferably 20 nm to 1 µm, and more preferably 50 nm to 500 nm.
To make charge injection easy, on the anode, there may be provided a layer formed with a phthalocyanine derivative, a conductive polymer, carbon, or the like; or a layer that has an average thickness of 2 nm or less and that is formed with a metal oxide, a metal fluoride, an organic insulating material, or the like.

A material for the cathode of a polymer LED according to the present invention preferably has low work function. Examples of such materials include: metals such as lithium, sodium, potassium, rubidium, cesium, beryllium, magnesium, calcium, strontium, barium, aluminum, scandium, vanadium, zinc, yttrium, indium, cerium, samarium, europium, terbium, or ytterbium; alloys of two or more among the metals or alloys of one or more of the metals with one or more selected from gold, silver, platinum, copper, manganese, titanium, cobalt, nickel, tungsten and tin; graphite, and graphite intercalation compounds. Examples of the alloys may include: magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys. The cathode may have a laminated structure of two or more layers.
The film thickness of the cathode can be properly selected taking into consideration of the electrical conductivity and the durability. The film thickness is, for example, 10 nm to 10 µm, preferably 20 nm to 1 µm, and more preferably 50 nm to 500 nm.

Examples of methods for forming the cathode include vacuum deposition, sputtering, and laminating in which a metal thin film is subjected to thermocompression bonding. Between the cathode and the organic layer, there may be provided a layer formed with a conductive polymer or a layer with an average thickness of 2 nm or less formed with a metal oxide, a metal fluoride, an organic insulating material, or the like. After the formation of the cathode, a protective layer for protecting the polymer LED may also be mounted on the cathode. To use the polymer LED stably for a long time, a protective layer and/or a protective cover is preferably mounted on the device to protect the device from the outside.

The protective layer may be formed with a polymer compound, metal oxide, metal fluoride, metal boride, or the like. The protective cover may be a glass plate, a plastic plate the surface of which is subjected to low water-permeability treatment, or the like. A method is preferably used in which the above described protective cover and the device substrate are bonded and sealed with a thermo-setting resin or photosetting resin. If a space is kept using a spacer, it is easy to prevent the device from being damaged. If an inert gas such as nitrogen or argon is included in the space, it is possible to prevent the cathode from being oxidized. If a drying agent such as barium oxide is placed in the space, it is easy to suppress the device from being damaged by water adsorbed on it during the production process. Preferably, any one or more of these methods are employed.

A polymer LED according to the present invention can be used as a flat light source, segment display apparatus, dot matrix display apparatus, or the backlight of a liquid crystal display apparatus.
To obtain flat light emission using a polymer LED according to the present invention, a flat anode and a flat cathode should be arranged so that they are superposed. To obtain patterned light emission, there are methods in which a mask with a patterned window is provided on the surface of the flat light emitting device, in which the organic layer of the non-light-emitting portion is formed to be extremely thick so that the portion does not substantially emit light, or in which either anode or cathode or both of them are formed to have a patterned shape. If one of the above methods is employed to form a pattern and some electrodes are arranged so that they can be each independently set at ON/OFF, a segment display device that can display numerals, letters, simple signs, and the like can be obtained. To produce a dot matrix device, both anodes and cathodes are formed in stripes and arranged so that they lie at right angles to each other. By employing a method in which a plurality of polymeric luminous bodies that emit different colors is color-coded or a method in which a color filter or fluorescence conversion filter is used, partial color display or multicolor display is achieved. Dot matrix devices can be passively-driven ones, or actively-driven devices by combining dot matrix devices with TFT. These display devices can be used as display apparatuses of computers, televisions, portable computers, mobile phones, car navigation systems, or view finders of video cameras.

The above described flat light emitting devices are selfluminous and thin, and the devices can be suitably used as flat light sources for the backlights of liquid crystal display apparatuses or the light source for flat lighting. By using a flexible substrate, the devices can be used as curved light sources or curved display apparatuses.

A polymer material according to the present invention can also be used to form an organic semiconductor thin film which can be used as a polymer field effect transistor. Typically, a polymer field effect transistor has a structure where a source electrode and a drain electrode are provided adjacent to an active layer formed with a polymer, and a gate electrode is provided over the active layer via an insulation layer, which is adjacent to the active layer.

The polymer field effect transistor is formed typically on a support substrate. The material of the support substrate is not particularly restricted as long as the material does not disturb the properties of the field effect transistor. Examples of the substrate may include a glass substrate, flexible film substrate and plastic substrate.

The field effect transistor can be produced by known methods, for example, a method described in JP-A-05-110069.

In forming an active layer, use of a polymer soluble in an organic solvent is very advantageous and preferable from the standpoint of production. Examples of methods for forming the film by using a solution where a polymer is dissolved in an organic solvent may include: coating methods such as a spin coating method, casting method, micro gravure coating method, gravure coating method, bar coating method, roll coating method, wire bar coating method, dip coating method, spray coating method, screen printing method, flexo printing method, offset printing method, and inkjet printing method.

Preferred is a sealed polymer field effect transistor obtained by manufacturing a polymer field effect transistor and subsequently sealing the transistor. As a result, the polymer field effect transistor is blocked from atmospheric air, thereby suppressing degradation of the properties of the polymer field effect transistor.
Examples of the sealing method may include: a method of covering the transistor with a UV hardening resin, a thermosetting resin, an inorganic SiONₓ film, or the like; and a method of pasting glass substrates or films with a UV hardening resin, a thermosetting resin, or the like. For effectively blocking the polymer field effect transistor from atmospheric air, the process from manufacturing to sealing of the transistor is preferably carried out without exposing the transistor to atmospheric air (for example, carried out in dried nitrogen atmosphere, in vacuo, or the like).

### Examples

Hereinafter, the present invention is described further in detail with referring to examples. However, the present invention is not restricted thereto.

### (number average molecular weight and weight average molecular weight)

Number average molecular weight and weight average molecular weight were determined based on polystyrene standards by a GPC (LC-10Avp (trade name) manufactured by SHIMADZU CORPORATION). A polymer to be determined was dissolved in tetrahydrofuran to be a concentration of about 0.5 wt%, and 50 µL of thus obtained solution was injected in the GPC. The mobile phase of the GPC was tetrahydrofuran and flowed at a rate of 0.6 mL/min. A column used was prepared by combining serially two TSK gel SuperHM-H (trade name, manufactured by Tosoh Corporation) and one TSKgel SuperH2000 (trade name, manufactured by Tosoh Corporation). A detector used was a differential refractometer (RID-10A (trade name) manufactured by SHIMADZU CORPORATION).

### Example 1

To the following Polymer 1, 2 wt% of the following iridium complex A was added. Thus obtained mixture was used to prepare a 1.8 wt% toluene solution. Polymer 1

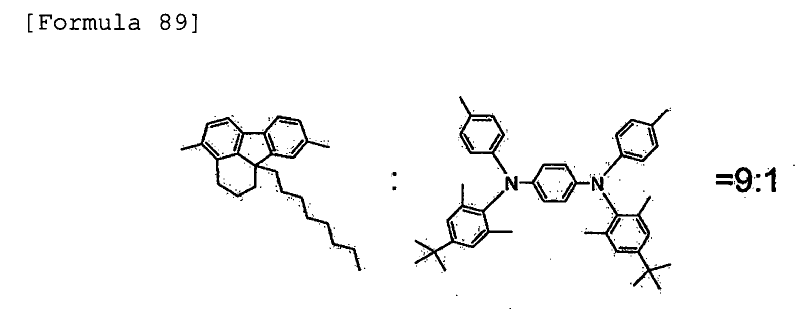

### Iridium Complex A

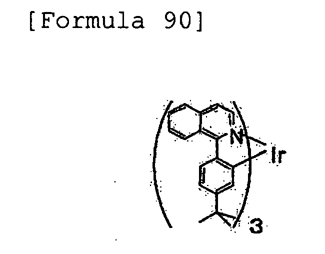

On a glass substrate on which an ITO film was formed in a thickness of 150 nm by sputtering method, a film was formed with a thickness of 50 nm by spin coating using a solution (Baytron P (trade name) manufactured by Bayer AG) of poly(ethylenedioxythiophene)/polystyrene sulfonic acid, and subsequently dried at 200°C for 10 minutes on a hot plate. Next, by using the prepared toluene solution, a film was formed by spin coating at a rotational rate of 2500 rpm. The film had a thickness of about 80 nm. Thus obtained substrate was dried at 80°C under reduced pressure for 1 hour. Then by depositing about 4 nm of LiF as the cathode buffer layer, about 5 nm of calcium as the cathode, and subsequently, about 80 nm of aluminum, thereby fabricating an EL device. In the deposition, metal vapor deposition was started after the vacuum degree reached to 1×10⁻⁴ Pa or less.
By applying a voltage to thus obtained device, EL light-emission having a peak at 620 nm was observed. The EL light-emission was x=0.62 and y=0.30 in C.I.E. color coordinate value, and was extremely good red. The device started light-emission at 4.1 V. The maximum light emitting efficiency was high of 2.9 cd/A.

The Polymer 1 was synthesized as mentioned below.
Compound A (0.557 g), N,N'-bis(4-bromophenyl)-N,N'-bis(4-t-butyl-2,6-dimethylphenyl)-1,4-phenylenediamine(0.096 g), and 2,2'-bipyridyl (0.548 g) were dissolved in 140 ml of dehydrated tetrahydrofuran. After that, the system was subjected to bubbling with argon to replace the system with nitrogen. The system was heated to 60°C. To this solution, bis(1,5-cyclooctadiene) nickel (0) {Ni(COD)₂} (0.965 g) was added in a nitrogen atmosphere, and stirred to effect reaction for 3 hours. This reaction solution was cooled to room temperature, added dropwise to a mixed solution of 25% aqueous ammonia 5 ml/methanol 140 ml/ion-exchanged water 140 ml, and stirred for an hour. Then resulting precipitate was collected by filtration. The precipitate was dried under reduced pressure, and dissolved in 40 ml of toluene. After dissolving, 1.6 g of Radiolite was added to the solution, stirred for 30 minutes, and filtrated to remove insoluble material. Thus obtained filtrate was purified by passing through an alumina column. Next, to the purified solution, 80 mL of 5.2% aqueous hydrochloric acid was added and stirred for 3 hours, and the water layer was removed. Then 80 mL of 4% aqueous ammonia was added thereto, and stirred for 2 hours, and the water layer was removed. To the organic layer, about 80 mL of ion-exchanged water was added and stirred for an hour, and the water layer was removed. After that, the organic layer was added to 160 mL of methanol and stirred for an hour. Then resulting precipitate was collected by filtration. The precipitate was dried under reduced pressure. The yield of thus obtained polymer (hereinafter, referred to as Polymer compound 1) was 0.33 g. The number average molecular weight of the polymer, in terms of polystyrene, was Mn=1.6x10⁴. The weight average molecular weight of the polymer, in terms of polystyrene, was Mw=8.7×10⁴.

### <Synthesis of Compound A>

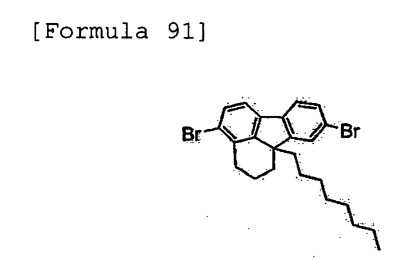

### (Compound A)

5.8 g (18 mmol) of Compound A and 115 ml of a mixed solvent of acetic acid:dichloromethane=1:1 were charged in a reaction vessel replaced with argon, and stirred and dissolved at room temperature. Then 14 g (36 mmol) of benzyltrimethylammonium tribromide was added thereto and zinc chloride was added with stirring until benzyltrimethylammonium tribromide dissolved completely. The reaction was monitored by HPLC, and benzyltrimethylammonium tribromide and zinc chloride were properly added. After the reaction was complete, the reaction solution was separated with chloroform and water. The organic layer was extracted, washed with water twice, and neutralized with an aqueous solution of potassium carbonate. Thus obtained solution was dried with sodium sulfate, and the solvent was evaporated. This solution was purified with a silica gel column using hexane as a developing solvent. After that, recrystallization was conducted with a mixed solvent of ethanol:hexane=10:1 to obtain 5.08 g of Compound B as a white powder.
MS(APPI(+))476(M⁺)
¹H-NMR (300 MHz/CDC1₃) δ7.53-7.43 (4H, m), 7.33 (1H, d), 2.90-2.84 (2H, m), 2.33-2.22 (2H, m), 2.05-1.96 (1H, m), 1.83-1.64 (2H, m), 1.32-1.05 (13H, m), 0.85-0.81 (3H, m)

### <Synthesis of N,N'-bis(4-bromophenyl)-N,N'-bis(4-t-butyl-2,6-dimethylphenyl)-1,4-phenylenediamine>

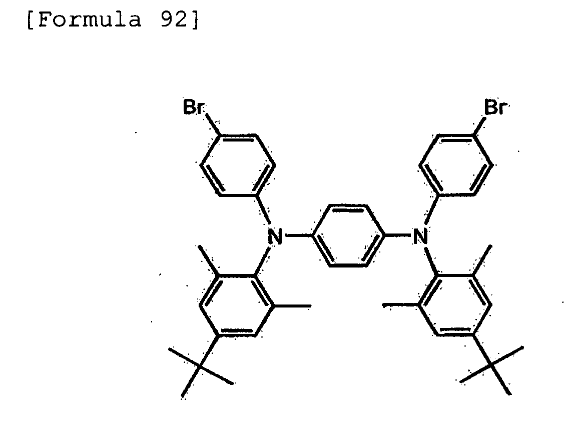

In an inert atmosphere, to a 1000 ml 3-neck flask, 350 ml of dehydrated N,N-dimethylformamide was added, and 5.2 g of N'-diphenyl-N,N'-bis(4-t-butyl-2,6-dimethylphenyl)-1,4-phenylenediamine was dissolved therein. After that, under ice bath, N-bromosuccinimide 3.5 g/N,N-dimethylformamide solution was added dropwise thereto to effect reaction during a day and a night.
To the reaction solution, 150 ml of water was added. Then resulting precipitate was collected by filtration. The precipitate was washed twice with 50 ml of methanol to obtain 4.4 g of a white solid.
¹H-NMR (300 MHz/THF-d8):
δ(ppm) = 1.3 [s, 18H], 2.0 [s, 12H], 6.6-6.7 [d, 4H], 6.8-6.9 [br, 4H], 7.1 [s, 4H], 7.2-7.3 [d, 4H]
MS (FD⁺) M⁺738
The iridium complex A was synthesized according to a method described in WO 03.040256A2.

### INDUSTRIAL APPLICABILITY

The present invention provides a polymer material comprising a compound exhibiting fluorescence or phosphorescence with which material light emitting devices with high practicality can be provided such as operability through the application of low voltage, high light emitting efficiency, and sufficient colors of emitted light.

## Claims

1. A polymer material comprising a polymer (A) including a moiety of a compound represented by the following formula (1) or a structure of the (A), and a molecule (B) exhibiting fluorescence or phosphorescence in a visible range or a structure of the (B), 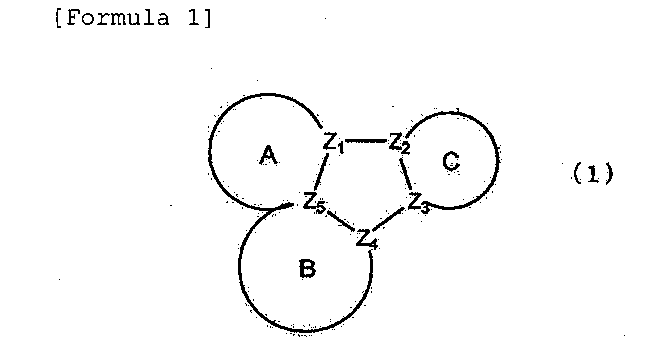 wherein each of rings A, B, and C independently represents an aromatic ring or a non-aromatic ring which rings may optionally have a substituent; each of Z₁, Z₂, Z₃, Z₄, and Z₅ independently represents C-(Q)z or a nitrogen atom; Q represents a substituent or a hydrogen atom; z represents 0 or 1; the rings A and B may share an atom of the rings other than Z₅; and one or two rings among the rings A, B, and C are non-aromatic rings.

2. The polymer material according to claim 1, wherein the material is a composition comprising the polymer (A) and the molecule (B).

3. The polymer material according to claim 1 or 2, wherein the polymer (A) comprises a repeating unit represented by any one of the following formulae (1-1) to (1-3), 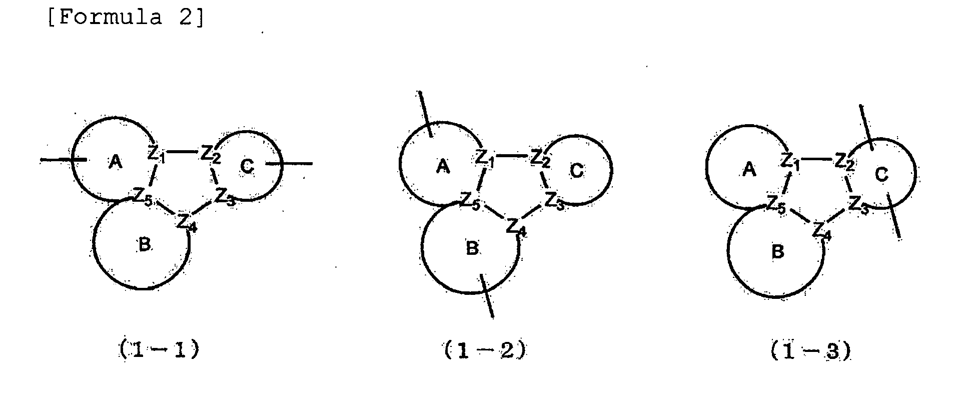 wherein each of the rings A, B, and C independently represents an aromatic ring or a non-aromatic ring which may optionally have a substituent; each of Z₁, Z₂, Z₃, Z₄, and Z₅ independently represents C-(Q)z or a nitrogen atom; Q represents a substituent or a hydrogen atom; z represents 0 or 1; the rings A and B may share an atom of the rings other than Z₅; substituents of the rings may be linked to form another ring; and one or more rings with no valence bond among the rings A, B, and C are non-aromatic rings.

4. The polymer material according to claim 3, wherein all atoms forming skeletons of the rings A, B, and C in the formulae (1-1), (1-2), and (1-3) are carbon atoms.

5. The polymer material according to claim 3 or 4, wherein the repeating unit represented by the formula (1-1) is a repeating unit represented by the following formula (2-1), 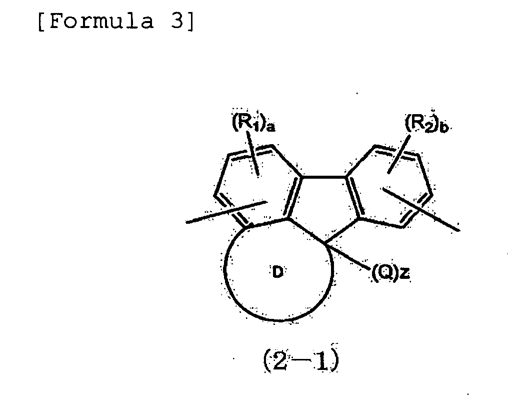 wherein each of R₁ and R₂ independently represents a substituent; the ring D represents a non-aromatic ring which may optionally have a substituent; a represents an integer of 0 to 2; b represents an integer of 0 to 3; when there are a plurality of R₁'s and R₂'s, respectively, R₁'s and R₂'s may be the same or different, respectively; R₁ and R₂ may be linked to each other and to form a ring; R₁ and/or R₂ and the ring D may be linked to form a ring; Q and z represent the same as above.

6. The polymer material according to claim 3 or 4, wherein the repeating unit represented by the formula (2-1) is a repeating unit represented by the following formula (3-1), 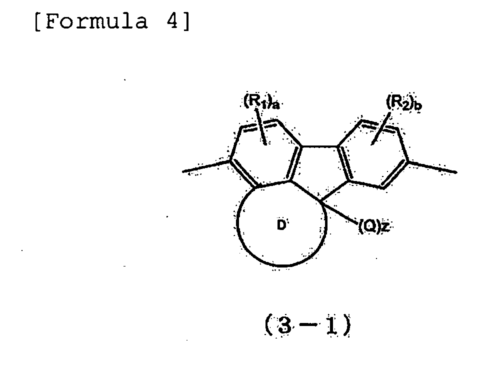 wherein R₁, R₂, the ring D, Q, z, a, and b represent the same as above.

7. The polymer material according to claim 6, wherein the repeating unit represented by the formula (3-1) is selected from structures represented by the following formulae (4-1), (4-2), (4-3), and (4-4), 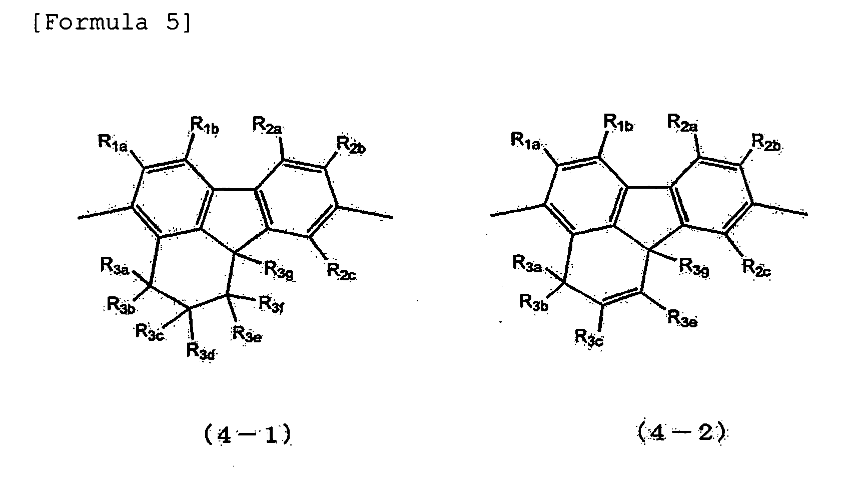 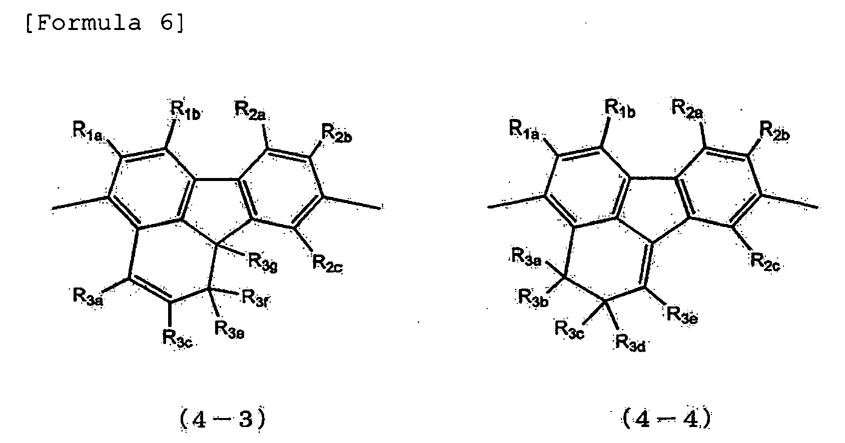 wherein each of R₁ₐ, R_{1b}, R₂ₐ to R_{2c}, and R₃ₐ to R_{3g} independently represents a hydrogen atom or a substituent; R_{2c} and R_{3g} in the formulae (4-1) to (4-3) may be linked to each other to form a ring; and R_{2c} and R₃ₑ in the formula (4-4) may be linked to form a ring.

8. The polymer material according to any one of claims 1 to 7, further comprising a repeating unit represented by the following formulae (5), (6), (7), or (8), 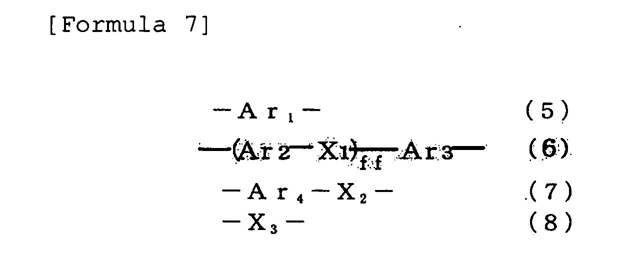 wherein each of Ar₁, Ar₂, Ar₃, and Ar₄ independently represents an arylene group, a divalent heterocyclic group, or a divalent group including a metal complex structure; each of X₁, X₂, and X₃ independently represents -CR₉=CR₁₀-, -C≡C-, -N(R₁₁)-, or -(SiR₁₂R₁₃)ₘ-; each of R₉ and R₁₀ independently represents a hydrogen atom, an alkyl group, an aryl group, a monovalent heterocyclic group, a carboxyl group, a substituted carboxyl group, or a cyano group; each of R₁₁, R₁₂, and R₁₃ independently represents a hydrogen atom, an alkyl group, an aryl group, a monovalent heterocyclic group, an arylalkyl group, or a substituted amino group; ff represents 1 or 2; m represents an integer of 1 to 12; when there are a plurality of R₉, R₁₀, R₁₁, R₁₂ and R₁₃, R₉ to R₁₃ may be the same or different.

9. The polymer material according to any one of claims 1 and 3 to 8, wherein the polymer includes the structure (A) and the structure (B) intramolecularly.

10. The polymer material according to claim 9, wherein a backbone chain of the polymer with the structure (A) includes the structure (B).

11. The polymer material according to claim 9, wherein a side chain of the polymer with the structure (A) includes the structure (B).

12. The polymer material according to claim 9, wherein the polymer (A) includes the molecule (B) at an end of the polymer (A) which the molecule (B) exhibits fluorescence or phosphorescence in a visible range.

13. The polymer material according to any one of claims 9 to 12, wherein the molecule with the structure (B) is a metal complex.

14. The polymer material according to any one of claims 1 to 13, further comprising at least one material selected from hole transport materials and electron transport materials.

15. The polymer material according to any one of claims 1 to 14, wherein the molecule (B) or the structure (B) is selected from naphthalene derivatives, anthracene or derivatives thereof, perylene or derivatives thereof, dyes such as polymethine dyes, xanthene dyes, coumarin dyes, cyanine dyes, metal complexes of 8-hydroxyquinoline or derivatives thereof, organic metal complexes of aromatic amines, tetraphenylcyclopentadiene or derivatives thereof, tetraphenylbutadiene or derivatives thereof.

16. The polymer material according to any one of claims 1 to 14, wherein the molecule (B) or the structure (B) is a metal complex; the metal complex has a central metal which is any one of W, Re, Os, Ir, Pt, Au, Ru, Rh, Pd, Ag, Ni, Cu, and Zn; at least one atom coordinated with the metal is a carbon atom; and all ligands are aromatic rings including substituents.

17. The polymer material according to claim 16, wherein the molecule (B) or the structure (B) is a metal complex including at least one ligand with any one of the following moieties, 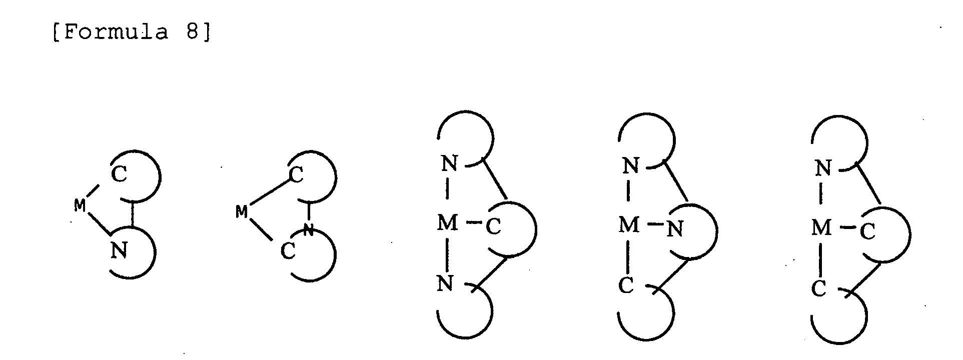 wherein M represents a central metal; and each of the rings represents a 5-membered or 6-membered ring that may optionally have a substituent/substituents, or a condensed ring including the 5-membered or 6-membered ring.

18. A liquid composition comprising the polymer material according to any one of claims 1 to 17.

19. The liquid composition according to claim 18, having a viscosity of 1 to 20 mPa·s at 25°C.

20. A light emitting thin film comprising the polymer material according to any one of claims 1 to 17.

21. A conductive thin film comprising the polymer material according to any one of claims 1 to 17.

22. An organic semiconductor thin film comprising the polymer material according to any one of claims 1 to 17.

23. A light emitting device comprising a layer comprising the polymer material according to any one of claims 1 to 17 between electrodes of an anode and a cathode.

24. The light emitting device according to claim 22, further comprising a charge transport layer and a charge block layer between the electrodes of an anode and a cathode.

25. A planar flat light source using the light emitting device according to claim 23 or 24.

26. A segment display apparatus using the light emitting device according to claim 23 or 24.

27. A dot matrix display apparatus using the light emitting device according to claim 23 or 24.

28. A liquid crystal display apparatus using the light emitting device according to claim 23 or 24 as a back light.

29. A lighting using the light emitting device according to claim 23 or 24.
